# EUROPEAN PATENT APPLICATION

(11) **EP 4 535 975 A2**
(43) Date of publication of application: **09.04.2025**
(21) Application number: 24202974.2
(22) Date of filing: 26.09.2024
(51) Int. Cl.: H10N 30/50, H10N 30/87, H10N 30/88, B06B 1/06, H04R 17/00

(54) **MULTILAYERED PIEZOELECTRIC VIBRATION DEVICE AND ELECTRONIC APPARATUS INCLUDING THE SAME**

(30) Priority: 06.10.2023 KR 20230133197
(71) Applicant: LG Display Co., Ltd., Seoul 07336 (KR)
(72) Inventor: PARK, SeungRyull, 10845 Paju-si, Gyeonggi-do (KR); KIM, Chiwan, 10845 Paju-si, Gyeonggi-do (KR); HA, YoungWook, 10845 Paju-si, Gyeonggi-do (KR)
(74) Representative: Bryn-Jacobsen, Caelia

(57) **Abstract**

Provided is a vibration device which includes a stack-type vibration generating part (110). The vibration generating part comprises a plurality of vibration layers (111) of piezoelectric material arranged between a plurality of electrode layers (113), a first connection member (118A) electrically connected to a first group of the electrode layers, and a second connection member (118B) electrically connected to a second group of the electrode layers. Each electrode layer has a shape which differs from a shape the vibration layers, and a size which is smaller than a size of the vibration layers, particularly having a main electrode part (113a) and several protruding sub-electrodes (113b). The vibration device may be incorporated in an electronic apparatus having a passive vibration member such as a display panel to generate a sound, for example.

## Description

### CROSS-REFERENCE TO RELATED APPLICATIONS

This application claims the benefit of and priority to Korean Patent Application No. 10-2023-0133197 filed on October 06, 2023.

### BACKGROUND

### Technical Field

The present disclosure relates to a vibration apparatus and an electronic apparatus including the same.

### Description of the Related Art

An electronic apparatus includes a separate speaker or a sound apparatus providing a sound. When a speaker is disposed in an electronic apparatus, the speaker occupies a space, due to this, the design and spatial disposition of the electronic apparatus are limited. A speaker applied to the electronic apparatus may be, for example, an actuator including a magnet and a coil. When an actuator is applied to the electronic apparatus, there is a disadvantage in that a thickness of the electronic apparatus is thickened. Therefore, piezoelectric devices for realizing a thin thickness of the electronic apparatus are attracting much attention.

Because piezoelectric constants of piezoelectric devices are proportional to a dielectric constant of a piezoelectric material, as for piezoelectric materials having a relatively strong driving force (or displacement force), dielectric constant increases together with a piezoelectric constant, and due to this, a capacitance increases also. In this case, as a capacitance is greater than an allowable capacitance of a driving circuit for driving a piezoelectric device, it is impossible to configure the driving circuit, or an expensive circuit part should be used. For example, in vehicular piezoelectric devices where a temperature range of driving reliability is higher than general electronic devices, a capacitance increases together with a dielectric constant as a temperature increases, and due to this, there is a limitation in using a piezoelectric device as a temperature for guaranteeing reliability increases. For example, in piezoelectric devices, because an impedance decreases progressively as a frequency increases up to a high frequency, a current increases, and due to this, a current increases in a high frequency, causing a problem where piezoelectric devices are vulnerable to the occurrence of heat in a driving circuit (or the occurrence of heat in a circuit).

### SUMMARY

The inventors of the present disclosure have performed various research and experiments for implementing a vibration apparatus which may have a strong driving force or a large displacement force and may have a relatively low capacitance. Based on the various research and experiments, the inventors have invented a vibration apparatus having a new structure and an electronic apparatus including the vibration apparatus, which may have a strong driving force or a large displacement force and may have a relatively low capacitance.

An aspect of the present disclosure is directed to providing a vibration apparatus and an electronic apparatus including the same, which may have a strong driving force or a large displacement force and may have a relatively low capacitance.

Another aspect of the present disclosure is directed to providing a vibration apparatus and an electronic apparatus including the same, which may be low in occurrence of heat and may be driven by a low-cost driving circuit.

Another aspect of the present disclosure is directed to providing a vibration apparatus and an electronic apparatus including the same, in which a manufacturing process and a structure may be simplified.

Another aspect of the present disclosure is directed to providing a vibration apparatus and an electronic apparatus including the same, which may be connected to a signal supply member without a soldering process.

Another aspect of the present disclosure is directed to providing a vibration apparatus with a signal supply member integrated therein and an electronic apparatus including the vibration apparatus.

Additional features, advantages, and aspects will be set forth in the description that follows, and in part will be apparent from the description, or may be learned by practice of the inventive concepts provided herein. Other features, advantages, and aspects of the present disclosure may be realized and attained by the structure particularly pointed out in the written description, or derivable therefrom, and the claims hereof as well as the appended drawings.

To achieve these and other advantages and aspects of the present disclosure, as embodied and broadly described herein, in one or more aspects, a vibration apparatus comprises a vibration generating part, the vibration generating part comprises a plurality of electrode layers; a plurality of vibration layers between the plurality of electrode layers, the plurality of vibration layers including a piezoelectric material; a first connection member configured to be electrically connected to an electrode layer in a first group among the plurality of electrode layers; and a second connection member configured to be electrically connected to an electrode layer in a second group among the plurality of electrode layers. Each of the plurality of electrode layers is configured to have a shape, which differs from a shape of each of the plurality of vibration layers, and a size which is smaller than a size of each of the plurality of vibration layers.

In one or more aspects, an electronic apparatus comprises a passive vibration member, and one or more vibration generating devices configured to vibrate the passive vibration member, the one or more vibration generating devices comprise a vibration apparatus including a vibration generating part, the vibration generating part comprises a plurality of electrode layers; a plurality of vibration layers between the plurality of electrode layers, the plurality of vibration layers including a piezoelectric material; a first connection member configured to be electrically connected to an electrode layer in a first group among the plurality of electrode layers; and a second connection member configured to be electrically connected to an electrode layer in a second group among the plurality of electrode layers. Each of the plurality of electrode layers is configured to have a shape, which differs from a shape of each of the plurality of vibration layers, and a size which is smaller than a size of each of the plurality of vibration layers.

Details of other exemplary examples will be included in the detailed description of the disclosure and the accompanying drawings.

According to one or more examples of the present disclosure, a vibration apparatus and an electronic apparatus including the same, which may have a strong driving force or a large displacement force and may have a relatively low capacitance, may be provided.

According to one or more examples of the present disclosure, a vibration apparatus and an electronic apparatus including the same, which may be low in occurrence of heat and may be driven by a low-cost driving circuit, may be provided.

According to one or more examples of the present disclosure, a structure and a manufacturing process of a vibration apparatus may be simplified.

According to one or more examples of the present disclosure, a signal supply member and a vibration apparatus may be electrically connected to each other without a soldering process.

According to one or more examples of the present disclosure, as a signal supply member and a vibration apparatus are provided as one body, the signal supply member and the vibration apparatus may be configured as one part (or one element or one component).

It is to be understood that both the foregoing description and the following description of the present disclosure are exemplary and explanatory and are intended to provide further explanation of the disclosure as claimed.

### BRIEF DESCRIPTION OF THE DRAWINGS

The accompanying drawings, which are included to provide a further understanding of the disclosure, are incorporated in and constitute a part of this disclosure, illustrate aspects and examples of the disclosure and together with the description serve to explain principles of the disclosure.
FIG. 1 illustrates a vibration apparatus according to an example of the present disclosure.
FIG. 2 illustrates a vibration generating part illustrated in FIG. 1 according to an example of the present disclosure.
FIG. 3 is an exploded perspective view of a vibration part and an electrode part illustrated in FIG. 2 according to an example of the present disclosure.
FIG. 4 is a cross-sectional view taken along line A-A' illustrated in FIG. 2 according to an example of the present disclosure.
FIG. 5 is a cross-sectional view taken along line B-B' illustrated in FIG. 2 according to an example of the present disclosure.
FIG. 6 is a cross-sectional view taken along line C-C' illustrated in FIG. 1 according to an example of the present disclosure.
FIG. 7 is a cross-sectional view taken along line D-D' illustrated in FIG. 1 according to an example of the present disclosure.
FIG. 8 illustrates a vibration apparatus according to another example of the present disclosure.
FIG. 9 illustrates a vibration generating part illustrated in FIG. 8 according to an example of the present disclosure.
FIG. 10 illustrates a vibration apparatus according to another example of the present disclosure.
FIG. 11 illustrates a vibration generating part illustrated in FIG. 10 according to an example of the present disclosure.
FIG. 12 illustrates an electrode part illustrated in FIGs. 10 and 11 according to an example of the present disclosure.
FIG. 13 illustrates a vibration apparatus according to another example of the present disclosure.
FIG. 14 illustrates a vibration generating part illustrated in FIG. 13 according to an example of the present disclosure.
FIG. 15 illustrates an electrode part illustrated in FIGs. 13 and 14 according to an example of the present disclosure.
FIG. 16 illustrates a vibration apparatus according to another example of the present disclosure.
FIG. 17 illustrates a vibration generating part illustrated in FIG. 16 according to an example of the present disclosure.
FIG. 18 illustrates a vibration apparatus according to another example of the present disclosure.
FIG. 19 illustrates a vibration generating part illustrated in FIG. 18 according to an example of the present disclosure.
FIG. 20 illustrates a vibration apparatus according to another example of the present disclosure.
FIG. 21 illustrates a vibration generating part illustrated in FIG. 20 according to an example of the present disclosure.
FIG. 22 illustrates an electrode part illustrated in FIGs. 20 and 21 according to an example of the present disclosure.
FIG. 23 illustrates a vibration apparatus according to another example of the present disclosure.
FIG. 24 illustrates a vibration generating part illustrated in FIG. 23 according to an example of the present disclosure.
FIG. 25 illustrates an electrode part illustrated in FIGs. 23 and 24 according to an example of the present disclosure.
FIG. 26 illustrates a vibration apparatus according to another example of the present disclosure.
FIG. 27 illustrates a vibration generating part illustrated in FIG. 26 according to an example of the present disclosure.
FIG. 28 illustrates an electrode part illustrated in FIGs. 26 and 27 according to an example of the present disclosure.
FIG. 29 illustrates a vibration apparatus according to another example of the present disclosure.
FIG. 30 illustrates a vibration generating part illustrated in FIG. 29 according to an example of the present disclosure.
FIG. 31 illustrates an electrode part illustrated in FIGs. 29 and 30 according to an example of the present disclosure.
FIG. 32 illustrates a vibration apparatus according to another example of the present disclosure.
FIG. 33 illustrates a vibration generating part illustrated in FIG. 32 according to an example of the present disclosure.
FIG. 34 illustrates an electrode part illustrated in FIGs. 32 and 33 according to an example of the present disclosure.
FIG. 35 illustrates a vibration apparatus according to another example of the present disclosure.
FIG. 36 illustrates a vibration generating part illustrated in FIG. 35 according to an example of the present disclosure.
FIG. 37 illustrates an electrode part illustrated in FIGs. 35 and 36 according to an example of the present disclosure.
FIG. 38 illustrates a vibration generating part of a vibration apparatus according to another example of the present disclosure.
FIG. 39 illustrates an electrode part and a bonding member illustrated in FIG. 38 according to an example of the present disclosure.
FIG. 40 is a cross-sectional view taken along line E-E' illustrated in FIG. 38 according to an example of the present disclosure.
FIG. 41 is a cross-sectional view taken along line F-F' illustrated in FIG. 38 according to an example of the present disclosure.
FIG. 42 illustrates a vibration generating part of a vibration apparatus according to another example of the present disclosure.
FIG. 43 illustrates an electrode part and a bonding member illustrated in FIG. 42 according to an example of the present disclosure.
FIG. 44 is a cross-sectional view taken along line G-G' illustrated in FIG. 44 according to an example of the present disclosure.
FIG. 45 is a cross-sectional view taken along line H-H' illustrated in FIG. 44 according to an example of the present disclosure.
FIG. 46 illustrates a vibration apparatus according to an example of the present disclosure.
FIG. 47 illustrates a vibration generating part illustrated in FIG. 46 according to an example of the present disclosure.
FIG. 48 is an exploded perspective view of a vibration part and an electrode part illustrated in FIG. 47 according to an example of the present disclosure.
FIG. 49 is a cross-sectional view taken along line I-I' illustrated in FIG. 47 according to an example of the present disclosure.
FIG. 50 is a cross-sectional view taken along line J-J' illustrated in FIG. 47 according to an example of the present disclosure.
FIGs. 51A to 51I illustrate a main vibration region having a vibration mode shape based on a frequency-based driving signal, in a vibration apparatus according to an experiment example.
FIG. 52 illustrates an electronic apparatus according to an example of the present disclosure.
FIG. 53 is a cross-sectional view taken along line K-K' illustrated in FIG. 52 according to an example of the present disclosure.

Throughout the drawings and the detailed description, unless otherwise described, the same drawing reference numerals should be understood to refer to the same elements, features, and structures. The sizes, lengths, and thicknesses of layers, regions and elements, and depiction of thereof may be exaggerated for clarity, illustration, and convenience.

### DETAILED DESCRIPTION OF THE DISCLOSURE

A shape, a size, a ratio, an angle, and a number disclosed in the drawings for describing examples of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted.

In a situation where "comprise," "have," and "include" described in the present specification are used, another part can be added unless "only" is used. The terms of a singular form can include plural forms unless referred to the contrary.

In construing an element, the element is construed as including an error range although there is no explicit description.

In describing a position relationship, for example, when a position relation between two parts is described as "on," "over," "under," and "next," one or more other parts can be disposed between the two parts unless 'just' or 'direct' is used.

In describing a temporal relationship, for example, when the temporal order is described as "after," "subsequent," "next," and "before," a situation which is not continuous can be included, unless "just" or "direct" is used.

It will be understood that, although the terms "first," "second," etc. can be used herein to describe various elements, these elements should not be limited by these terms. These terms are only used to distinguish one element from another. For example, a first element could be termed a second element, and, similarly, a second element could be termed a first element, without departing from the scope of the present disclosure.

In describing elements of the present disclosure, the terms "first," "second," "A," "B," "(a)," "(b)," or the like can be used. These terms are intended to identify the corresponding element(s) from the other element(s), and these are not used to define the essence, basis, order, or number of the elements. For the expression that an element is "connected," "coupled," or "contact," to another element, the element may not only be directly connected, coupled, or contacted to another element, but also be indirectly connected, coupled, or contacted to another element with one or more intervening elements interposed between the elements, unless otherwise specified.

The term "at least one" should be understood as including any and all combinations of one or more of the associated listed items. For example, the meaning of "at least one of a first item, a second item and a third item" denotes the combination of all items proposed from two or more of the first item, the second item and the third item as well as the first item, the second item or the third item.

Features of various examples of the present disclosure can be partially or overall coupled to or combined with each other and can be variously inter-operated with each other and driven technically as those skilled in the art can sufficiently understand. The examples of the present disclosure can be carried out independently from each other or can be carried out together in co-dependent relationship.

Hereinafter, examples of a vibration apparatus and an electronic apparatus according to the present disclosure will be described in detail with reference to the accompanying drawings. For convenience of description, a scale of each of elements illustrated in the accompanying drawings differs from a real scale, and thus, is not limited to a scale illustrated in the drawings.

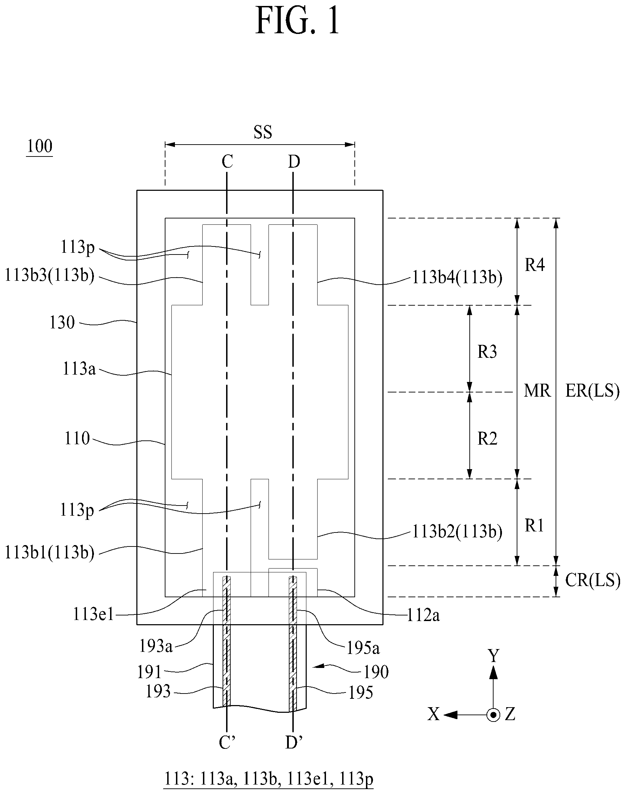

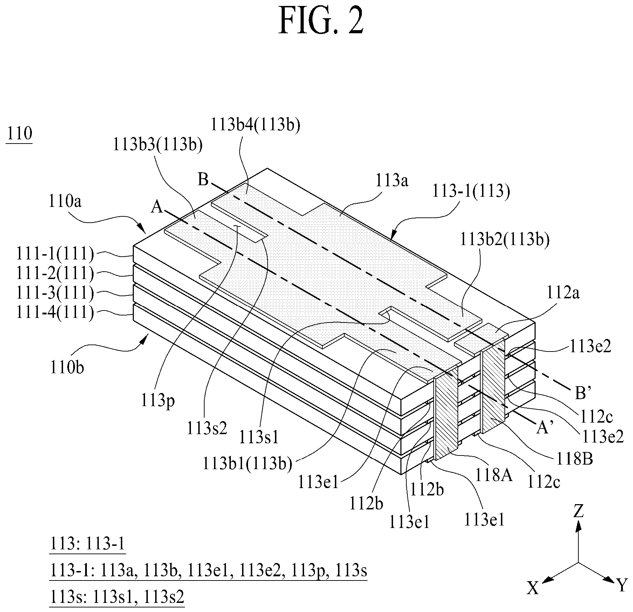

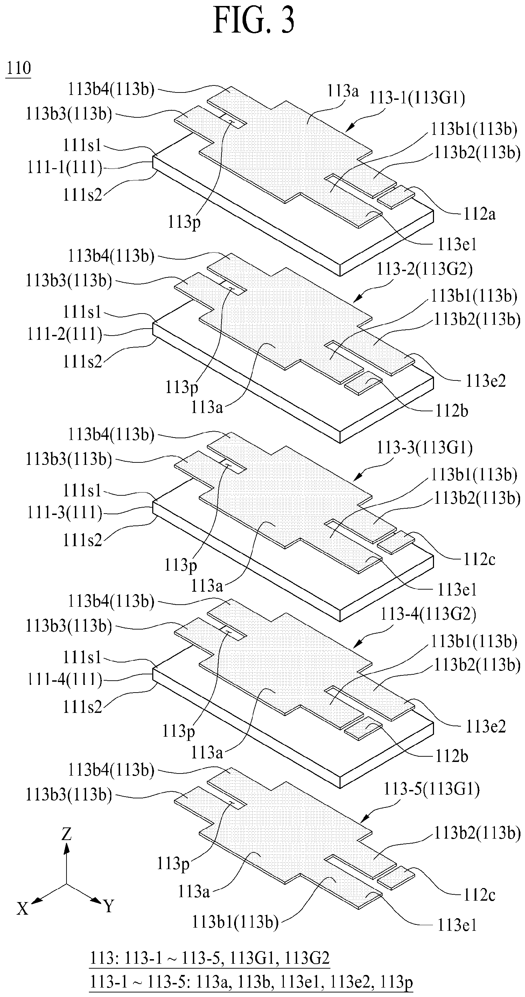

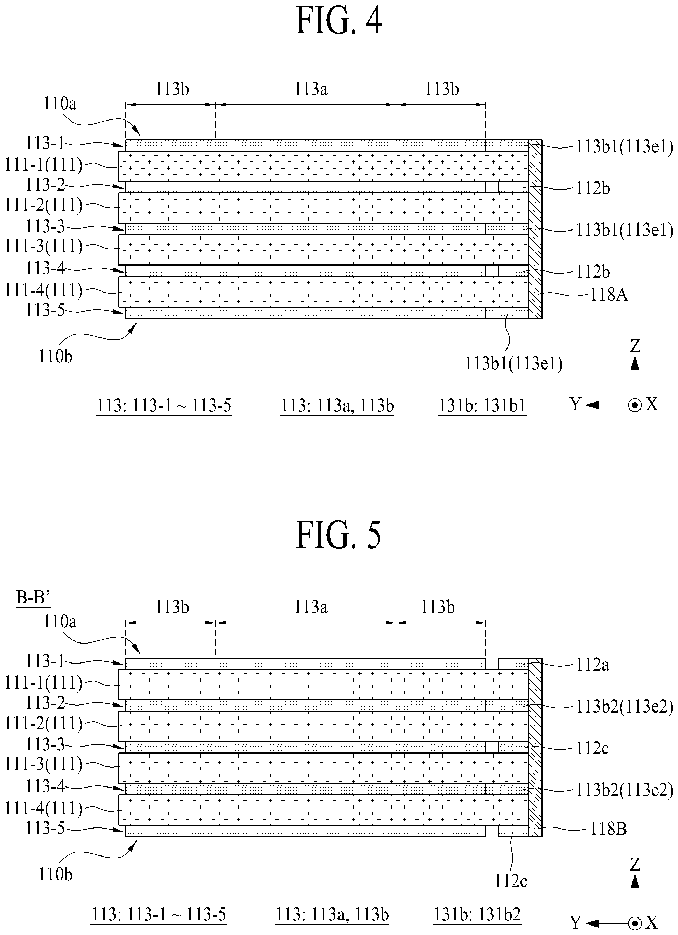

FIG. 1 illustrates a vibration apparatus according to an example of the present disclosure. FIG. 2 illustrates a vibration generating part illustrated in FIG. 1 according to an example of the present disclosure. FIG. 3 is an exploded perspective view of a vibration part and an electrode part illustrated in FIG. 2 according to an example of the present disclosure. FIG. 4 is a cross-sectional view taken along line A-A' illustrated in FIG. 2 according to an example of the present disclosure. FIG. 5 is a cross-sectional view taken along line B-B' illustrated in FIG. 2 according to an example of the present disclosure.

With reference to FIGs. 1 to 3, the vibration apparatus 100 according to an example (or a first example) of the present disclosure may include a vibration generating part 110.

The vibration generating part 110 may be configured to vibrate based on a driving signal (or a sound signal or a voice sound signal). For example, the vibration generating part 110 may include a first surface 110a and a second surface 110b opposite to the first surface 110a. In the vibration generating part 110, the first surface 101a may be an upper surface, a front surface, an uppermost electrode layer, an uppermost electrode part, or an uppermost electrode surface, but examples of the present disclosure are not limited thereto. The second surface 10b may be a lower surface, a back surface, a rear surface, a lowermost electrode layer, a lowermost electrode part, or a lowermost electrode surface, but examples of the present disclosure are not limited thereto.

The vibration generating part 110 may include a vibration part 111, an electrode part 113, a first connection member 118A, and a second connection member 118B.

The vibration part 111 may be configured to vibrate based on the driving signal (or sound signal or voice sound signal). The vibration part 111 may include a plurality of vibration layers 111-1 to 111-4. For example, the vibration part 111 may include a plurality of vibration layers 111-1 to 111-4 which are overlapped or stacked to each other. For example, the vibration part 111 may include a plurality of (or two or more) vibration layers 111-1 to 111-4 which are overlapped or stacked to be displaced in a same direction. For example, the vibration part 111 may be a piezoelectric type vibration part, a displacement part, a stack-type vibration part, a stack-type piezoelectric part, a stack-type vibration device, or a stack-type ceramic part, but examples of the present disclosure are not limited thereto.

The vibration part 111 according to an example of the present disclosure may include first to N^{th} (where N may be a natural number of 2 or more) vibration layers 111-1 to 111-4. Hereinafter, in describing examples of the present disclosure, for convenience of description, an example where a vibration part includes first to fourth vibration layers 111-1 to 111-4 will be described, but examples of the present disclosure are not limited thereto.

The first to fourth vibration layers 111-1 to 111-4 may be overlapped or stacked to be displaced (or driven or vibrated) in a same direction along a third direction Z or a thickness direction of the vibration generating part 110. For example, each of the first to fourth vibration layers 111-1 to 111-4 may contract or expand in a same driving direction (or a displacement direction or a vibration direction) based on a driving signal in a state where the first to fourth vibration layers 111-1 to 111-4 are stacked or overlapped with each other, and thus, a displacement amount (or a bending force) or an amplitude displacement of the vibration generating part 110 or the vibration apparatus 100 may increase or may be maximized. Therefore, the first to fourth vibration layers 111-1 to 111-4 may increase (or maximize) a displacement amount (or a bending force) or an amplitude displacement of the vibration generating part 110 or the vibration apparatus 100, thereby enhancing a sound pressure level characteristic of a sound and a sound characteristic of a middle-low-pitched sound band generated based on a vibration of the vibration generating part 110 or the vibration apparatus 100. For example, the middle-low-pitched sound band may be 200Hz to 1kHz, but examples of the present disclosure are not limited thereto. For example, a high-pitched sound band may be 1kHz or more or 3kHz or more, but examples of the present disclosure are not limited thereto.

Each of the first to fourth vibration layers 111-1 to 111-4 may include a piezoelectric material (or an electroactive material) which includes a piezoelectric effect. For example, the piezoelectric material may have a characteristic in which, when pressure or twisting (or bending) is applied to a crystalline structure by an external force, a potential difference occurs due to dielectric polarization caused by a relative position change of a positive (+) ion and a negative (-) ion, and a vibration is generated by an electric field based on a reverse voltage applied thereto. For example, each of the first to fourth vibration layers 111-1 to 111-4 may be referred to as a piezoelectric layer, a piezoelectric material layer, a piezoelectric inorganic layer, a displacement layer, a piezoelectric vibration layer, a piezoelectric green sheet, a piezoelectric ceramic layer, an electroactive layer, or a piezoelectric structure layer, or the like, but examples of the present disclosure are not limited thereto.

Each of the first to fourth vibration layers 111-1 to 111-4 may be configured as a ceramic-based material capable of implementing a relatively strong vibration, or may be configured as a piezoelectric ceramic having a perovskite-based crystalline structure.

The piezoelectric ceramic may be configured as a single crystalline ceramic having a crystalline structure, or may be configured as a ceramic material having a polycrystalline structure or polycrystalline ceramic. A piezoelectric material including the single crystalline ceramic may include α-AlPO₄, α-SiO₂, LiNbO₃, Tb₂(MoO₄)₃, Li₂B₄O₇, or ZnO, but examples of the present disclosure are not limited thereto. A piezoelectric material including the polycrystalline ceramic may include a lead zirconate titanate (PZT)-based material, including lead (Pb), zirconium (Zr), and titanium (Ti), or may include a lead zirconate nickel niobate (PZNN)-based material, including lead (Pb), zirconium (Zr), nickel (Ni), and niobium (Nb), but examples of the present disclosure are not limited thereto. For example, the vibration layer 111 may include at least one or more of calcium titanate (CaTiO₃), barium titanate (BaTiO₃), and strontium titanate (SrTiO₃), without lead (Pb), but examples of the present disclosure are not limited thereto.

The vibration layer 111 according to an example of the present disclosure may include a piezoelectric sintered material (or a piezoelectric ceramic or a piezoelectric green sheet) which is manufactured by sintering (or firing) a piezoelectric powder (or a ceramic powder) at a high sintering (or firing) temperature of 1,200 °C or more, but examples of the present disclosure are not limited thereto. For example, the piezoelectric sintered material may be manufactured by a high temperature sintering process performed on a piezoelectric powder.

The plurality of or first to fourth vibration layers 111-1 to 111-4 may have a thickness of 70 *µ*m to 180 *µ*m so as to slim the vibration apparatus 100 or the vibration generating part 110, but examples of the present disclosure are not limited thereto. For example, the plurality of or first to fourth vibration layers 111-1 to 111-4 may have a thickness of 80 *µ*m to 165 *µ*m, and thus, the vibration apparatus 100 or the vibration generating part 110 may have a relatively thin thickness.

Each of the first to fourth vibration layers 111-1 to 111-4 according to an example of the present disclosure may have a tetragonal shape, and for example, may two-dimensionally have a rectangular shape. For example, each of the first to fourth vibration layers 111-1 to 111-4 may have a rectangular shape in plan. For example, each of the first to fourth vibration layers 111-1 to 111-4 may include a first surface 111s1 and a second surface 111s2 opposite to the first surface 111s1. For example, in each of the first to fourth vibration layers 111-1 to 111-4, the first surface 111s1 may be an upper surface or a front surface, and the second surface 111s2 may be a lower surface, a back surface, or a rear surface.

Each of the first surface 111s1 and the second surface 11 1s2 of each of the first to fourth vibration layers 111-1 to 111-4 may include a rectangular shape having a short side SS and a long side LS. For example, the short side SS of each of the first surface 111s1 and the second surface 111s2 may be parallel to a first direction X, the long side of each of the first surface 111s1 and the second surface 111s2 may be parallel to a second direction Y intersecting with the first direction X, but examples of the present disclosure are not limited thereto. For example, the first direction X may be a short-side lengthwise direction, a widthwise direction, or a horizontal direction of the vibration apparatus 100 or the vibration generating part 110, and the second direction Y may be a long-side lengthwise direction, a lengthwise direction, or a vertical direction of the vibration apparatus 100 or the vibration generating part 110, but examples of the present disclosure are not limited thereto. For example, the second direction Y may be a short-side lengthwise direction, a widthwise direction, or a vertical direction of the vibration apparatus 100 or the vibration generating part 110, and the first direction X may be a long-side lengthwise direction, a lengthwise direction, or a horizontal direction of the vibration apparatus 100 or the vibration generating part 110, but examples of the present disclosure are not limited thereto.

The vibration generating part 110 and the vibration part 111 according to an example of the present disclosure may include an electrode region ER and a connection region CR. For example, each of the first surface 111s1 and the second surface 11 1s2 of each of the first to fourth vibration layers 111-1 to 111-4 according to an example of the present disclosure may include an electrode region ER and a connection region CR.

The electrode region ER may have a relatively larger size than the connection region CR. The electrode region ER may include a center portion of each of the first surface 111s1 and the second surface 11 1s2 of each of the first to fourth vibration layers 111-1 to 111-4. The connection region CR may include one edge portion (or one periphery portion) of each of the first surface 111s1 and the second surface 111s2 of each of the first to fourth vibration layers 111-1 to 111-4. For example, the connection region CR may be an edge portion (or a periphery portion) adjacent to one short side (or first short side) of the vibration generating part 110. For example, the electrode region ER may be a main vibration region of the vibration generating part 110 or the vibration part 111. For example, the connection region CR may be a signal reception region from a driving circuit, or may be a circuit connection region between the vibration generating part 110 and the driving circuit.

Each of the first surface 111s1 and the second surface 111s2 of each of the first to fourth vibration layers 111-1 to 111-4 may include first to fourth region R1, R2, R3, and R4. For example, the electrode region ER of each of the first to fourth vibration layers 111-1 to 111-4 may include first to fourth regions R1, R2, R3, and R4, but examples of the present disclosure are not limited thereto.

The first to fourth region R1, R2, R3, and R4 may be parallel to the first direction X. Each of the first to fourth regions R1, R2, R3, and R4 may be a horizontal region, a division region or a horizontal division region. The first region R1 may be disposed adjacent to the connection region CR. For example, the first region R1 may be a first edge portion (or a first periphery portion) adjacent to one short side (or a first short side) of the vibration generating part 110.

The second region R2 and the third region R3 may be a middle region MR. The second region R2 may be a first middle region. The third region R3 may be a second middle region. The first region R1 may be one region of the middle region MR or a first edge region (or a first periphery region) or a lower region of the middle region MR.

The fourth region R4 may be disposed adjacent to the other side of the middle region MR. For example, the fourth region R4 may be a second edge portion (or a second periphery portion) adjacent to the other short side (or a second short side) of the vibration generating part 110. The fourth region R4 may be the other region of the middle region MR or a second edge region (or a second periphery region) or an upper region of the middle region MR.

Each of the first to fourth regions R1, R2, R3, and R4 may have two-dimensionally the same size. For example, the electrode region ER may be divided into the first to fourth regions R1, R2, R3, and R4 having the same size. For example, the connection region CR may be a region between one short side (or the first short side) of the vibration generating part 110 and the first region R1.

The electrode part 113 may be configured to be electrically connected to each of the first surface 111s1 and the second surface 11 1s2 of each of the first to fourth vibration layers 111-1 to 111-4. The electrode part 113 may include a plurality of electrode layers 113-1 to 113-5. For example, the vibration apparatus 100 according to an example of the present disclosure may include a plurality of electrode layers 113-1 to 113-5 and a plurality of vibration layers 111-1 to 111-4 which are between the plurality of electrode layers 113-1 to 113-5 and each include a piezoelectric material.

The plurality of electrode layers 113-1 to 113-5 may include first to M* (where M may be N+1) electrode layers 113-1 to 113-5. In the following description, an example where the first to M* electrode layers are first to fifth electrode layers 113-1 to 113-5 will be described, but examples of the present disclosure are not limited thereto.

Each of the first to fifth electrode layers 113-1 to 113-5 may have a shape which differs from that of each of the first to fourth vibration layers 111-1 to 111-4 and may have a size which is smaller than that of each of the first to fourth vibration layers 111-1 to 111-4. For example, each of the first to fifth electrode layers 113-1 to 113-5 may have a shape which differs from that of each of the first to fourth vibration layers 111-1 to 111-4 and may have a size which is smaller than that of each of the first to fourth vibration layers 111-1 to 111-4, based on electrode patterning (or an electrode pattern structure) for decreasing a capacitance of the vibration apparatus 100 or the vibration generating part 110. For example, each of the first to fifth electrode layers 113-1 to 113-5 may correspond to a main vibration region based on a frequency-based vibration characteristic (or a vibration mode shape) of the vibration apparatus 100 or the vibration generating part 110, or may have a shape and/or a size corresponding to the main vibration region and an effective vibration region.

According to an example of the present disclosure, each of the first to fourth vibration layers 111-1 to 111-4 may have a tetragonal shape, and for example, may two-dimensionally have a rectangular shape. For example, each of the first to fourth vibration layers 111-1 to 111-4 may have a rectangular shape in plan. Each of the first to fifth electrode layers 113-1 to 113-5 may two-dimensionally have a non-tetragonal shape. For example, each of the first to fifth electrode layers 113-1 to 113-5 may have a non-tetragonal shape in plan. For example, each of the first to fifth electrode layers 113-1 to 113-5 may two-dimensionally have a non-tetragonal shape, based on the electrode patterning.

According to an example of the present disclosure, each of the first to fifth electrode layers 113-1 to 113-5 may have a size of 40% to 90% of a size of each of the first to fourth vibration layers 111-1 to 111-4. Therefore, a size of each of the first to fifth electrode layers 113-1 to 113-5 may be smaller than that of the first to fourth vibration layers 111-1 to 111-4, and thus, a capacitance of the vibration apparatus 100 or the vibration generating part 110 may decrease compared to a structure where an electrode layer and a vibration layer have the same size and shape.

Comparing with a vibration generating part according to an experiment example including a vibration layer having a reference thickness and a reference size and upper and lower electrode layers having the same size as the vibration layer, when a thickness of the vibration layer decreases, a capacitance may increase, and when a size (or area) of the electrode layer decreases, a capacitance may decrease. Accordingly, comparing with the vibration generating part according to the experiment example, a thickness of each of the first to fourth vibration layers 111-1 to 111-4 may decrease, and a size of each of the first to fifth electrode layers 113-1 to 113-5 may decrease, and thus, the vibration apparatus 100 or the vibration generating part 110 according to an example of the present disclosure may have a capacitance which is lower than or similar to that of the experiment example.

According to one example of the present disclosure, each of the first to fifth electrode layers 113-1 to 113-5 may include a plurality of sides 113s. In each of the first to fifth electrode layers 113-1 to 113-5, one or more sides 113s1 and 113s2 of the plurality of sides 113s may include one or more protrusions or one or more concave portions, and thus, each of the first to fifth electrode layers 113-1 to 113-5 may have a non-tetragonal shape in plan.

According to one example of the present disclosure, each of the first to fifth electrode layers 113-1 to 113-5 may include a main electrode 113a and one or more sub-electrodes 113b protruding from the main electrode 113a. For example, a ratio of a size of the main electrode 113a to a size of the one or more sub-electrodes 113b may be 10:8 to 10:2, and thus, a capacitance of the vibration apparatus 100 or the vibration generating part 110 may decrease compared to a structure where an electrode layer and a vibration layer have the same size and shape.

The first electrode layer 113-1 may be disposed (or configured) at the first surface 110a of the vibration generating part 110. The first electrode layer 113-1 may be disposed (or configured) at the first surface 111s1 of the first vibration layer 111-1. The first electrode layer 113-1 may be electrically connected to the first surface 111s1 of the first vibration layer 111-1. For example, the first electrode layer 113-1 may be a highest electrode layer or an uppermost electrode layer, but examples of the present disclosure are not limited thereto.

The second electrode layer 113-2 may be disposed or interposed between the first vibration layer 111-1 and the second vibration layer 111-2. The second electrode layer 113-2 may be electrically connected to each of the second surface 111s2 of the first vibration layer 111-1 and the first surface 111s1 of the second vibration layer 111-2. For example, the second electrode layer 113-2 may be a first intermediate electrode layer, a first inner electrode layer, or a first common electrode layer, but examples of the present disclosure are not limited thereto.

The third electrode layer 113-3 may be disposed or interposed between the second vibration layer 111-2 and the third vibration layer 111-3. The third electrode layer 113-3 may be electrically connected to each of the second surface 111s2 of the second vibration layer 111-2 and the first surface 111s1 of the third vibration layer 111-3. For example, the third electrode layer 113-3 may be a second intermediate electrode layer, a second inner electrode layer, or a second common electrode layer, but examples of the present disclosure are not limited thereto.

The fourth electrode layer 113-4 may be disposed or interposed between the third vibration layer 111-3 and the fourth vibration layer 111-4. The fourth electrode layer 113-4 may be electrically connected to each of the second surface 111s2 of the third vibration layer 111-3 and the first surface 111s1 of the fourth vibration layer 111-4. For example, the fourth electrode layer 113-4 may be a third intermediate electrode layer, a third inner electrode layer, or a third common electrode layer, but examples of the present disclosure are not limited thereto.

The fifth electrode layer 113-5 may be disposed at the second surface 110b of the vibration generating part 110. The fifth electrode layer 113-5 may be disposed at the second surface 111s2 of the fourth vibration layer 111-4. For example, the fifth electrode layer 113-5 may be a lowest electrode layer or a bottommost electrode layer, but examples of the present disclosure are not limited thereto.

The first to fifth electrode layers 113-1 to 113-5 may overlap or overlay each other along a third direction Z or a thickness direction of the vibration generating part 110.

According to one example of the present disclosure, a plurality of or first to fifth electrode layers 113-1 to 113-5 may include or be grouped into a first group (or an electrode group) 113G1 and a second group (or an electrode group) 113G2. The electrode layers 113-2 and 113-4 in the second group 113G2 may be disposed (or interposed) between the electrode layers 113-1, 113-3, and 113-5 in the first group 113G1. For example, the first group 113G1 may include odd-numbered electrode layers 113-1, 113-3, and 113-5 of the first to fifth electrode layers 113-1 to 113-5. The second group 113G2 may include even-numbered electrode layers 113-2 and 113-4 of the first to fifth electrode layers 113-1 to 113-5. For example, the first group 113G1 may include a first electrode layer 113-1, a third electrode layer 113-3, and a fifth electrode layer 113-5, and the second group 113G2 may include a second electrode layer 113-2 and a fourth electrode layer 113-4, but examples of the present disclosure are not limited thereto. For example, the first group 113G1 may include even-numbered electrode layers 113-2 and 113-4, and the second group 113G2 may include odd-numbered electrode layers 113-1, 113-3, and 113-5.

According to an example of the present disclosure, to prevent electrical short circuit between the first to fifth electrode layers 113-1 to 113-5, each of the first to fifth electrode layers 113-1 to 113-5 may be formed at the other portion, except an edge portion (or a periphery portion), of corresponding vibration layers 111-1 to 111-4. For example, lateral surfaces (or outer sidewalls) of the first to fifth electrode layers 113-1 to 113-5 may be spaced apart from lateral surfaces (or outer sidewalls) of the vibration layer 111-1 to 111-4 to have a predetermined distance (or a predetermined interval).

According to an example of the present disclosure, a distance (or a shortest distance) between the lateral surface (or outer sidewall) of the electrode layers 113-1 to 113-5 and the lateral surface (or outer sidewall) of the vibration layer 111-1 to 111-4 may be set (or adjusted) based on a thickness of the vibration layer 111, or may be set (or adjusted) based on a thickness of the vibration layer 111-1 to 111-4 and a process error when forming the electrode layers 113-1 to 113-5. For example, the distance (or shortest distance) between the lateral surface (or outer sidewall) of the electrode layers 113-1 to 113-5 and the lateral surface (or outer sidewall) of the vibration layer 111-1 to 111-4 may be greater than the thickness of the vibration layer 111-1 to 111-4, or it may be two or more times the thickness of the vibration layer 111-1 to 111-4. For example, the distance (or shortest distance) between the lateral surface (or outer sidewall) of the electrode layers 113-1 to 113-5 and the lateral surface (or outer sidewall) of the vibration layer 111-1 to 111-4 may be at least 0.4 mm or more, or at least 1 mm or more, but examples of the present disclosure are not limited thereto.

The electrode part 113 according to an example of the present disclosure may include a main electrode 113a and a sub-electrode 113b connected to the main electrode 113a. For example, each of the first to fifth electrode layers 113-1 to 113-5 according to an example of the present disclosure may include a main electrode 113a and a sub-electrode 113b protruding (or extending) from the main electrode 113a. For example, the main electrode 113a may be a main pattern electrode, a main electrode pattern, a pattern main electrode, or a first pattern electrode, but examples of the present disclosure are not limited thereto. For example, the sub-electrode 113b may be an auxiliary electrode, a pattern protrusion electrode, a protrusion pattern electrode, a protrusion electrode, an extension electrode, a protrusion portion, an extension portion, a pattern sub-electrode, or a second pattern electrode, but examples of the present disclosure are not limited thereto.

The main electrode 113a may be disposed in the middle region MR or a portion of the electrode region ER of corresponding vibration layers 111-1 to 111-4. For example, the main electrode 113a may be disposed at the second region R2 and the third region R3 of the electrode region ER of corresponding vibration layers 111-1 to 111-4. For example, the main electrode 113a may have a size corresponding to the second region R2 and the third region R3 of the electrode region ER of corresponding vibration layers 111-1 to 111-4. For example, a portion which is disposed (configured) at the second region R2 and the third region R3 of the electrode region ER of the electrode layers 113-1 to 113-5 may be the main electrode 113a.

The sub-electrode 113b may be disposed (or configured) at the same plane as the main electrode 113a. For example, the sub-electrode 113b may be electrically connected to the main electrode 113a and may be disposed (or configured) to have one or more of a shape and a size which differ from those of the main electrode 113a, in the same plane as the corresponding vibration layers 111-1 to 111-4. For example, the sub-electrode 113b may protrude (or extend) from the main electrode 113a to have one or more of a shape and a size which differ from those of the main electrode 113a, in the same plane as the corresponding vibration layers 111-1 to 111-4.

The sub-electrode 113b may be disposed at each of the first region R1 and the fourth region R4 of the electrode region ER of the corresponding vibration layers 111-1 to 111-4. The sub-electrode 113b may protrude (or extend) toward the first region R1 and the fourth region R4 respectively from a first side (or a first short side) 113s1 and a second side (or a second short side) 113s2, which is opposite to the first side 113s1, of the main electrode 113a. For example, the sub-electrode 113b may protrude (or extend) toward a lateral surface (or a short side) of the corresponding vibration layers 111-1 to 111-4 from each of the first side 113s1 and the second side 113s2 of the main electrode 113a. For example, a portion which is disposed (configured) at the first region R1 and the fourth region R4 of the electrode region ER of the electrode layers 113-1 to 113-5 may be the sub-electrode 113b.

According to an example of the present disclosure, two-dimensionally (or in plan), a total size of the main electrode 113a may be greater than a total size of the sub-electrode 113b. For example, two-dimensionally (or in plan), a ratio of a size of the main electrode 113a to a size of the sub-electrode 113b may be 10:8 to 10:2. Accordingly, the amount of displacement (or bending force or amplitude) of a vibration of the middle region MR referred to as a main vibration region may be maximized in each of the first to fourth vibration layers 111-1 to 111-4, and comparing with the vibration generating part according to the experiment example described above, a capacitance of the vibration apparatus 100 or the vibration generating part 110 may be reduced.

Each of the first to fifth electrode layers 113-1 to 113-5 or the sub-electrode 113b according to an example of the present disclosure may include a plurality of sub-electrodes 113b1, 113b2, 113b3, and 113b4. The plurality of sub-electrodes 113b1, 113b2, 113b3, and 113b4 may be disposed at each of the first region R1 and the fourth region R4 of the electrode region ER of the corresponding vibration layers 111-1 to 111-4. The plurality of sub-electrodes 113b1, 113b2, 113b3, and 113b4 may protrude (or extend) from the first side 113s1 and the second side 113s2 of the main electrode 113a to each of the first region R1 and the fourth region R4. For example, the sub-electrodes 113b1, 113b2, 113b3, and 113b4 may be a sub-line electrode, a protrusion pattern, a sub-line pattern, a sub-electrode pattern, or an extension pattern, but examples of the present disclosure are not limited thereto.

Each of the first to fifth electrode layers 113-1 to 113-5 or the sub-electrode 113b according to an example of the present disclosure may include first to fourth sub-electrodes 113b1, 113b2, 113b3, and 113b4.

The first and second sub-electrodes 113b1 and 113b2 may be disposed at the electrode region ER, which is adjacent to the connection region CR, of the vibration generating part 110 or the vibration part 111 in the corresponding vibration layers 111-1 to 111-4. The first and second sub-electrodes 113b1 and 113b2 may be disposed at the first region R1 of the electrode region ER adjacent to the connection region CR in the corresponding vibration layers 111-1 to 111-4. Each of the first and second sub-electrodes 113b1 and 113b2 may protrude (or extend) in parallel toward the first region R1 of the electrode region ER from the first side 113s1 of the main electrode 113a.

The third and fourth sub-electrodes 113b3 and 113b4 may be disposed at the fourth region R4 of the electrode region ER of the corresponding vibration layers 111-1 to 111-4. The third and fourth sub-electrodes 113b3 and 113b4 may protrude (or extend) in a direction opposite to the first and second sub-electrodes 113b1 and 113b2 from the main electrode 113a in the corresponding vibration layers 111-1 to 111-4. Each of the third and fourth sub-electrodes 113b3 and 113b4 may protrude (or extend) in parallel toward the first region R1 of the electrode region ER from the second side 113s2 of the main electrode 113a.

The main electrode 113a may have a symmetrical structure with respect to one or more of the first direction X and the second direction Y passing through a center portion of the corresponding vibration layers 111-1 to 111-4. The first to fourth sub-electrodes 113b1 to 113b4 may have a symmetrical structure with respect to the main electrode 113a. The first to fourth sub-electrodes 113b1 to 113b4 may have a symmetrical structure with respect to one or more of the first direction X and the second direction Y passing through a center portion of the corresponding vibration layers 111-1 to 111-4. A driving signal applied to the electrode layers 113-1 to 113-5 may be uniformly applied to the corresponding vibration layers 111-1 to 111-4, based on the symmetricity of the main electrode 113a and the first to fourth sub-electrodes 113b1 to 113b4.

According to an example of the present disclosure, in each of the first to fifth electrode layers 113-1 to 113-5, some of the plurality of sub-electrodes 113b1 to 113b4 disposed adjacent to the connection region CR of the plurality of sub-electrodes 113b1 to 113b4 may further extend (or protrude) to the connection region CR. For example, in each of the first to fifth electrode layers 113-1 to 113-5, the sub-electrodes 113b1 and 113b2 disposed at the first region R1 adjacent to the connection region CR of the plurality of sub-electrodes 113b1 and 113b2 may further extend (or protrude) to the connection region CR. An end (or an end surface) of each of the sub-electrodes 113b1 and 113b2 disposed at the connection region CR may be exposed at one lateral surface (or one short side) of the vibration generating part 110 or the electrode part 113. For example, one lateral surface (or one sidewall) of each of the sub-electrodes 113b1 and 113b2 disposed at the connection region CR may be exposed at the one lateral surface (or one short side) of the vibration generating part 110 or the electrode part 113.

According to an example of the present disclosure, in each of the first to fifth electrode layers 113-1 to 113-5, any one of the first and second sub-electrodes 113b1 and 113b2 may further extend (or protrude) to the connection region CR. An end (or an end surface) of any one of the first and second sub-electrodes 113b1 and 113b2 disposed at the connection region CR may be exposed at the one lateral surface (or one short side) of the vibration generating part 110 or the electrode part 113. For example, one lateral surface (or one sidewall) of any one of the first and second sub-electrodes 113b1 and 113b2 disposed at the connection region CR may be exposed at the one lateral surface (or one short side) of the vibration generating part 110 or the electrode part 113.

According to an example of the present disclosure, in the first and second sub-electrodes 113b1 and 113b2 of the electrode layers 113-1, 113-3, and 113-5 included in the first group 113G1 of the first to fifth electrode layers 113-1 to 113-5, the first sub-electrode 113b1 may further extend (or protrude) to the connection region CR, and the second sub-electrode 113b2 may not extend (or protrude) to the connection region CR. For example, an end (or an end surface) of the first sub-electrode 113b1 may be exposed at the one lateral surface (or one short side) of the vibration generating part 110 or the electrode part 113. For example, the end (or end surface) of the first sub-electrode 113b1 disposed at the connection region CR may be exposed at the one lateral surface (or one short side) of the vibration generating part 110 or the electrode part 113.

According to an example of the present disclosure, in the first and second sub-electrodes 113b1 and 113b2 of the electrode layers 113-2 and 113-4 included in the second group 113G2 of the first to fifth electrode layers 113-1 to 113-5, the second sub-electrode 113b2 may further extend (or protrude) to the connection region CR, and the first sub-electrode 113b1 may not extend (or protrude) to the connection region CR. For example, an end (or an end surface) of the second sub-electrode 113b2 may be exposed at the one lateral surface (or one short side) of the vibration generating part 110 or the electrode part 113. For example, the end (or end surface) of the second sub-electrode 113b2 disposed at the connection region CR may be exposed at the one lateral surface (or one short side) of the vibration generating part 110 or the electrode part 113. Accordingly, in the first to fifth electrode layers 113-1 to 113-5, the first and second sub-electrodes 113b1 and 113b2 may include different lengths or different sizes.

In each of the first and second sub-electrodes 113b1 and 113b2 of the first to fifth electrode layers 113-1 to 113-5, a portion disposed at the connection region CR may be an extension pattern 113e1 and 113e2. For example, the extension patterns 113e1 and 113e2 may be an enlargement pattern or an internal contact pattern, but examples of the present disclosure are not limited thereto. For example, a portion which further protrudes (or extends) from the first sub-electrode 113b1 of the electrode layers 113-1, 113-3, and 113-5 included in the first group 113G1 of the first to fifth electrode layers 113-1 to 113-5 and is disposed at the connection region CR may be a first extension pattern 113e1. A portion which further protrudes (or extends) from the second sub-electrode 113b2 of the electrode layers 113-2 and 113-4 included in the second group 113G2 of the first to fifth electrode layers 113-1 to 113-5 and is disposed at the connection region CR may be a second extension pattern 113e2.

The vibration generating part 110 or the electrode part 113 may include a patterning region 113p disposed at a peripheral region of each of the main electrode 113a and the sub-electrode 113b of each of the first to fifth electrode layers 113-1 to 113-5. For example, each of the first to fifth electrode layers 113-1 to 113-5 may include the patterning region 113p corresponding to a portion between the plurality of sub-electrodes 113b and a corner portion of each of the vibration layers 111-1 to 111-4.

The patterning region 113p of each of the first to fifth electrode layers 113-1 to 113-5 may be a non-disposition region of each of the electrode layers 113-1 to 113-5 in each of the first surface 111s1 and the second surface 111s2 of each of the corresponding vibration layers 111-1 to 111-4. For example, the patterning region 113p may be an exposure region of a vibration layer, a patterning region of an electrode, an electrode removal region, or an effective vibration region, but examples of the present disclosure are not limited thereto. For example, the patterning region 113p may be disposed (or formed) at a region corresponding to an effective vibration region based on a frequency-based vibration characteristic (or a vibration mode shape) of the vibration apparatus 100 or the vibration generating part 110. In a plane, a total size of the patterning region 113p in each of the first surface 111s1 and the second surface 111s2 of the first to fourth vibration layers 111-1 to 111-4 may be 10% to 60% of a size of each of the corresponding vibration layers 111-1 to 111-4. Accordingly, a capacitance of the vibration apparatus 100 or the vibration generating part 110 may decrease based on a total size of the patterning region 113p.

In each of the first to fifth electrode layers 113-1 to 113-5, the patterning region 113p between a plurality of sub-electrodes 113b may be a concave region, a concave pattern region, or a concave portion, but examples of the present disclosure are not limited thereto. For example, a plurality of sub-electrodes 113b or the first to fourth sub-electrodes 113b1, 113b2, 113b3, and 113b4 may be disposed (or configured) in parallel with the patterning region 113p therebetween. For example, the patterning region 113p in a region between the first sub-electrodes 113b1 and the second sub-electrodes and 113b2 and a region between the third sub-electrode 113b3 and the fourth sub-electrode 113b4 may be a concave region, a concave pattern region, or a concave portion, but examples of the present disclosure are not limited thereto.

According to an example of the present disclosure, two-dimensionally (or in plan), a total size of the main electrode 113a may be greater than a total size of the plurality of sub-electrodes 113b1, 113b2, 113b3, and 113b4. Two-dimensionally (or in plan), a total size of the main electrode 113a may be greater than a total size of the first to fourth sub-electrodes 113b1, 113b2, 113b3, and 113b4. For example, two-dimensionally (or in plan), a ratio of a total size of the main electrode 113a to a total size of the first to fourth sub-electrodes 113b1, 113b2, 113b3, and 113b4 may be 10:8 to 10:2. Accordingly, the amount of displacement (or bending force or amplitude) of a vibration of the middle region MR referred to as a main vibration region may be maximized in each of the first to fourth vibration layers 111-1 to 111-4, and comparing with the vibration generating part according to the experiment example described above, a capacitance of the vibration apparatus 100 or the vibration generating part 110 may be reduced.

According to an example of the present disclosure, each of the first to fifth electrode layers 113-1 to 113-5 may overlap or overlay each other along the third direction Z or the thickness direction of the vibration generating part 110. Two electrodes vertically adjacent to each other of the first to fifth electrode layers 113-1 to 113-5 may vertically overlap or overlay each other with one vibration layer 111-1 to 111-4 therebetween. Each of the first to fourth vibration layers 111-1 to 111-4 may be disposed or interposed between two electrodes vertically adjacent to each other of the first to fifth electrode layers 113-1 to 113-5, which are vertically overlapping or overlaying each other.

According to an example of the present disclosure, the main electrode 113a and the sub-electrode 113b of the each of the first to fifth electrode layers 113-1 to 113-5 may vertically overlap or overlay each other.

The main electrode 113a and the sub-electrode 113b of the first electrode layer 113-1 may be directly formed or configured at the first surface 111s1 of the first vibration layer 111-1.

The main electrode 113a and the sub-electrode 113b of the second electrode layer 113-2 may be directly formed or configured at the first surface 111s1 of the second vibration layer 111-2 and may be electrically and directly connected (or coupled) to the second surface 11 1s2 of the first vibration layer 111-1, but examples of the present disclosure are not limited thereto. For example, the main electrode 113a and the sub-electrode 113b of the second electrode layer 113-2 may be directly formed or configured at the second surface 111s2 of the first vibration layer 111-1 and may be electrically and directly connected (or coupled) to the first surface 111s1 of the second vibration layer 111-2, but examples of the present disclosure are not limited thereto.

The main electrode 113a and the sub-electrode 113b of the third electrode layer 113-3 may be directly formed or configured at the first surface 111s1 of the third vibration layer 111-3 and may be electrically and directly connected (or coupled) to the second surface 111s2 of the second vibration layer 111-2, but examples of the present disclosure are not limited thereto. For example, the main electrode 113a and the sub-electrode 113b of the third electrode layer 113-3 may be directly formed or configured at the second surface 11 1s2 of the second vibration layer 111-2 and may be electrically and directly connected (or coupled) to the first surface 111s1 of the third vibration layer 111-3, but examples of the present disclosure are not limited thereto.

The main electrode 113a and the sub-electrode 113b of the fourth electrode layer 113-4 may be electrically and directly connected (or coupled) to the first surface 111s1 of the fourth vibration layer 111-4 and may be electrically and directly connected (or coupled) to the second surface 111s2 of the third vibration layer 111-3, but examples of the present disclosure are not limited thereto. For example, the main electrode 113a and the sub-electrode 113b of the fourth electrode layer 113-4 may be directly formed or configured at the second surface 111s2 of the third vibration layer 111-3 and may be electrically and directly connected (or coupled) to the first surface 111s1 of the fourth vibration layer 111-4, but examples of the present disclosure are not limited thereto.

The main electrode 113a and the sub-electrode 113b of the fifth electrode layer 113-5 may be directly formed or configured at the second surface 111s2 of the fourth vibration layer 111-4.

The electrode region ER of each of the first to fourth vibration layers 111-1 to 111-4 according to another example of the present disclosure may include first to third regions, but examples of the present disclosure are not limited thereto.

Each of the first to third region may be parallel to the first direction X. Each of the first to third regions may be a horizontal region, a division region or a horizontal division region, but examples of the present disclosure are not limited thereto. The second region may be disposed (or configured) between the first region and the third region. For example, the first to third regions may have a same size (or area) in the electrode region ER. For example, the first to third regions may have a same size (or area) in a same plane of the electrode region ER. The main electrode 113a of each of the first to fourth vibration layers 111-1 to 111-4 may be disposed (or configured) at the second region (or intermediate region) of the electrode region ER. The sub-electrodes 113b of each of the first to fourth vibration layers 111-1 to 111-4 may be disposed (or configured) at each of the first region and the third region of the electrode region ER, respectively. For example, the first and second sub-electrodes 113b1 and 113b2 of each of the first to fourth vibration layers 111-1 to 111-4 may be disposed (or configured) at the third region of the electrode region ER. The third and fourth sub-electrodes 113b3 and 113b4 of each of the first to fourth vibration layers 111-1 to 111-4 may be disposed (or configured) at the first region of the electrode region ER.

One or more of the first to fifth electrode layers 113-1 to 113-5 according to an example of the present disclosure may be formed of a transparent conductive material, a semitransparent conductive material, or an opaque conductive material. For example, the transparent conductive material or the semitransparent conductive material may include indium tin oxide (ITO) or indium zinc oxide (IZO), but examples of the present disclosure are not limited thereto. The opaque conductive material may include gold (Au), silver (Ag), platinum (Pt), palladium (Pd), molybdenum (Mo), magnesium (Mg), carbon, or silver (Ag) including glass frit, or the like, or may be formed of an alloy thereof, but examples of the present disclosure are not limited thereto. For example, the carbon may be carbon black, ketjen black, carbon nanotube, and a carbon material including graphite, but examples of the present disclosure are not limited thereto.

According to an example of the present disclosure, in order to enhance an electrical characteristic and/or a vibration characteristic of the vibration layer 111, each of the first to fifth electrode layers 113-1 to 113-5 may include silver (Ag) having a low resistivity. In each of the first to fifth electrode layers 113-1 to 113-5 including silver (Ag) including glass frit, a content of the glass frit may be 1wt% to 12wt%, but examples of the present disclosure are not limited thereto. The glass frit may include PbO or Bi₂O₃-based material, but examples of the present disclosure are not limited thereto.

With reference to FIGs. 2 to 4, the first connection member 118A may be configured to be electrically connected to the electrode layers 113-1, 113-3, and 113-5 in the first group 113G1 of the first to fifth electrode layers 113-1 to 113-5. The first connection member 118A may be formed (or disposed) at one lateral surface (or one short side) of the vibration generating part 110 or the electrode part 113 and may be electrically connected to (or coupled to or contact) the electrode layers 113-1, 113-3, and 113-5 included in the first group 113G1 of the first to fifth electrode layers 113-1 to 113-5. For example, the first connection member 118A may be electrically connected to (or coupled to or contact) the first sub-electrode 113b1 (or the first extension pattern 113e1) of each of the electrode layers 113-1, 113-3, and 113-5 included in the first group 113G1 of the first to fifth electrode layers 113-1 to 113-5. For example, the first connection member 118A may be a first connection line, a first link line, a first common line, a first external connection line, a first lateral line, a first lateral connection line, a first lateral common line, a first edge contact member, or a first edge contact line, but examples of the present disclosure are not limited thereto.

The first connection member 118A may be electrically (or in common) connected to (or coupled to or contact) odd-numbered electrode layers 113-1, 113-3, and 113-5 or the first electrode layer 113-1, the third electrode layer 113-3, and the fifth electrode layer 113-5 among the first to fifth electrode layers 113-1 to 113-5. Accordingly, the first electrode layer 113-1, the third electrode layer 113-3, and the fifth electrode layer 113-5 may be connected to (or coupled to or contact) the first connection member 118A.

The first connection member 118A may be electrically (or in common) connected to (or coupled to or contact) the first sub-electrode 113b1 (or the first extension pattern 113e1) of each of odd-numbered electrode layers 113-1, 113-3, and 113-5 or the first electrode layer 113-1, the third electrode layer 113-3, and the fifth electrode layer 113-5 among the first to fifth electrode layers 113-1 to 113-5. Accordingly, each of the first electrode layer 113-1, the third electrode layer 113-3, and the fifth electrode layer 113-5 may be electrically (or in common) connected to (or coupled to or contact) the first connection member 118A through the first sub-electrode 113b1 (or the first extension pattern 113e1).

Each of the first electrode layer 113-1, the third electrode layer 113-3, and the fifth electrode layer 113-5 connected to the first connection member 118A may be used as a first electrode of each of the first to fourth vibration layers 111-1 to 111-4. For example, the first electrode layer 113-1 may be used as a first electrode (or an upper electrode) of the first vibration layer 111-1. The third electrode layer 113-3 may be used as a first electrode (or a lower electrode) of the second vibration layer 111-2, and simultaneously as a first electrode (or an upper electrode) of the third vibration layer 111-3. The second vibration layer 111-2 and the third vibration layer 111-3 may share the third electrode layer 113-3. The fifth electrode layer 113-5 may be used as a first electrode (or a lower electrode) of the fourth vibration layer 111-4.

With reference to FIGs. 2, 3, and 5, the second connection member 118B may be configured to be electrically connected to the electrode layers 113-2 and 113-4 in the second group 113G2 of the first to fifth electrode layers 113-1 to 113-5. The second connection member 118B may be formed (or disposed) at one surface (or one short side) of the vibration generating part 110 or the electrode part 113 so as to be electrically disconnected (or insulated) from the first connection member 118A and may be electrically connected to (or coupled to or contact) the electrode layers 113-1, 113-3, and 113-5 included in the second group 113G2 of the first to fifth electrode layers 113-1 to 113-5. For example, the second connection member 118B may be electrically connected to (or coupled to or contact) the second sub-electrode 113b2 (or the second extension pattern 113e2) of each of the electrode layers 113-2 and 113-4 included in the second group 113G2 of the first to fifth electrode layers 113-1 to 113-5. For example, the second connection member 118B may be a second connection line, a second link line, a second common line, a second external connection line, a second lateral line, a second lateral connection line, a second lateral common line, a second edge contact member, or a second edge contact line, but examples of the present disclosure are not limited thereto.

The second connection member 118B may be electrically (or in common) connected to (or coupled to or contact) even-numbered electrode layers 113-2 and 113-4 or the second electrode layer 113-2 and the fourth electrode layer 113-4 among the first to fifth electrode layers 113-1 to 113-5. Accordingly, the second electrode layer 113-2 and the fourth electrode layer 113-4 may be connected to (or coupled to or contact) the second connection member 118B in common.

The second connection member 118B may be electrically (or in common) connected to (or coupled to or contact) the second sub-electrode 113b2 (or the second extension pattern 113e2) of each of even-numbered electrode layers 113-2 and 113-4 or the second electrode layer 113-2 and the fourth electrode layer 113-4 among the first to fifth electrode layers 113-1 to 113-5. Accordingly, each of the second electrode layer 113-3 and the fourth electrode layer 113-4 may be electrically (or in common) connected to (or coupled to or contact) the second connection member 118B through the second sub-electrode 113b2 (or the second extension pattern 113e2).

Each of the second electrode layer 113-2 and the fourth electrode layer 113-4 connected to the second connection member 118B may be used as a second electrode of each of the first to fourth vibration layers 111-1 to 111-4. For example, the second electrode layer 113-2 may be used as a second electrode (or a lower electrode) of the first vibration layer 111-1, and simultaneously as a first electrode (or an upper electrode) of the second vibration layer 111-2. The first vibration layer 111-1 and the second vibration layer 111-2 may share the second electrode layer 113-2. For example, the fourth electrode layer 113-4 may be used as a second electrode (or a lower electrode) of the third vibration layer 111-3, and simultaneously as a first electrode (or an upper electrode) of the fourth vibration layer 111-4. The third vibration layer 111-3 and the fourth vibration layer 111-4 may share the fourth electrode layer 113-4.

Each of the first and second connection member 118A and 118B according to an example of the present disclosure may be configured as a conductive material or a conductive adhesive. For example, the conductive material of each of the first and second connection members 118A and 118B may include a thermos-curable electrode material, a photo-curable (or ultraviolet (UV)-curable) electrode material, or a solution-type electrode material, but examples of the present disclosure are not limited thereto. For example, the electrode material of each of the first and second connection members 118A and 118B may include silver (Ag), nickel (Ni), an Ag alloy, or a Ni alloy, but examples of the present disclosure are not limited thereto. For example, each of the first and second connection members 118A and 118B may be configured in a silver (Ag) paste. For example, the conductive adhesive of each of the first and second connection members 118A and 118B may include a conductive epoxy resin, a conductive acrylic resin, a conductive silicone resin, or a conductive urethane resin, but examples of the present disclosure are not limited thereto.

With reference to FIGs. 1 to 3 and 5, the vibration apparatus 100 or the vibration generating part 110 according to an example of the present disclosure may further include a connection pattern (or a first connection pattern) 112a.

The connection pattern 112a may be configured to transfer a driving signal, applied from the outside, to the second connection member 118B. The connection pattern 112a may be configured at the first surface 110a of the vibration generating part 110. The connection pattern 112a may be configured at the first surface 110a of the vibration generating part 110 to be electrically connected to the second connection member 118B.

The connection pattern 112a may be in the first electrode layer (or an uppermost electrode layer) 113-1 of the vibration generating part 110 and may be configured to be electrically disconnected from the first electrode layer 113-1. The connection pattern 112a may be disposed (or configured) at the first surface 111s1 of the first vibration layer 111-1 corresponding to a region between the second connection member 118B and the first electrode layer 113-1. For example, the connection pattern 112a may be disposed (or configured) in an island shape at the connection region CR of the vibration generating part 110 or the first vibration layer 111-1 so as to be electrically disconnected from the first electrode layer 113-1. The connection pattern 112a may be disposed at the connection region CR of the first vibration layer 111-1 adjacent to the second sub-electrode 113b2 of the first electrode layer 113-1. For example, the connection pattern 112a may be disposed at the connection region CR of the first vibration layer 111-1 so as to be electrically connected to the second connection member 118B and electrically disconnected (or insulated) from the second sub-electrode 113b2 of the first electrode layer 113-1.

The connection pattern 112a may be disposed at a same plane as the first electrode layer 113-1. For example, the connection pattern 112a may be formed (or configured) as an electrode material layer of the first electrode layer 113-1 which intactly remains without being patterned or removed by a patterning process of the first electrode layer 113-1. For example, the connection pattern 112a and the second sub-electrode 113b2 of the first electrode layer 113-1 may be disposed in parallel to each other in the same plane at the connection region CR. For example, the connection pattern 112a may be disposed in parallel with the first extension pattern 113e1 of the first electrode layer 113-1. For example, the connection pattern 112a and the first extension pattern 113e1 of the first electrode layer 113-1 may be disposed in parallel to each other in the same plane at the connection region CR.

The connection pattern 112a may increase (or enlarge) a size of the second connection member 118B disposed at the first surface 110a of the vibration generating part 110 and may thus increase a connection (or coupling or contact) area between the driving circuit and the second connection member 118B. Also, the connection pattern 112a may increase a coupling force between the vibration generating part 110 and the second connection member 118B. Accordingly, the second connection member 118B may be additionally connected (or coupled) to the connection pattern 112a, and thus, stripping of the second connection member 118B connected (or coupled) to the vibration generating part 110 may be prevented.

With reference to FIGs. 2 to 5, the vibration apparatus 100 or the vibration generating part 110 according to an example of the present disclosure may further include a plurality of second connection patterns 112b and a plurality of third connection patterns 112c.

The plurality of second connection patterns 112b may be configured to be electrically disconnected from each of the second electrode layer 113-2 and the fourth electrode layer 113-4. The plurality of second connection patterns 112b may be disposed (or configured) at the first surface 111s1 of each of the second vibration layer 111-2 and the fourth vibration layer 111-4 corresponding to a region between the first connection member 118A and each of the second electrode layer 113-2 and the fourth electrode layer 113-4. The plurality of second connection patterns 112b may be disposed (or configured) in an island shape at the connection region CR of each of the second vibration layer 111-2 and the fourth vibration layer 111-4 so as to be electrically disconnected from each of the second electrode layer 113-2 and the fourth electrode layer 113-4. The plurality of second connection patterns 112b may be disposed at the connection region CR of each of the second vibration layer 111-2 and the fourth vibration layer 111-4 so as to be adjacent to the first sub-electrode 113b1 of each of the second electrode layer 113-2 and the fourth electrode layer 113-4. For example, the plurality of second connection patterns 112b may be disposed at the connection region CR of each of the second vibration layer 111-2 and the fourth vibration layer 111-4 so as to be electrically connected to the first connection member 118A and electrically disconnected (or insulated) from the first sub-electrode 113b1 of each of the second electrode layer 113-2 and the fourth electrode layer 113-4.

The plurality of second connection patterns 112b may be formed (or configured) as an electrode material layer of each of the second electrode layer 113-2 and the fourth electrode layer 113-4 which intactly remains without being patterned or removed by a patterning process of each of the second electrode layer 113-2 and the fourth electrode layer 113-4.

The plurality of second connection patterns 112b may increase a coupling force between the vibration generating part 110 and the first connection member 118A. Accordingly, the first connection member 118A may be additionally connected (or coupled) to the plurality of second connection patterns 112b, and thus, stripping of the first connection member 118A connected (or coupled) to the vibration generating part 110 may be prevented.

The plurality of third connection patterns 112c may be configured to be electrically disconnected from each of the third electrode layer 113-3 and the fifth electrode layer 113-5. The plurality of third connection patterns 112c may be disposed (or configured) at each of the third vibration layer 111-3 and the fourth vibration layer 111-4 corresponding to a region between the second connection member 118B and each of the third electrode layer 113-3 and the fifth electrode layer 113-5. The plurality of third connection patterns 112c may be disposed (or configured) in an island shape at the connection region CR of each of the third vibration layer 111-3 and the fourth vibration layer 111-4 so as to be electrically disconnected from each of the third electrode layer 113-3 and the fifth electrode layer 113-5. The plurality of third connection patterns 112c may be disposed at the connection region CR of each of the third vibration layer 111-3 and the fourth vibration layer 111-4 so as to be adjacent to the second sub-electrode 113b2 of each of the third electrode layer 113-3 and the fifth electrode layer 113-5. For example, the plurality of third connection patterns 112c may be disposed at the connection region CR of each of the third vibration layer 111-3 and the fourth vibration layer 111-4 so as to be electrically connected to the second connection member 118B and electrically disconnected (or insulated) from the second sub-electrode 113b2 of each of the third electrode layer 113-3 and the fifth electrode layer 113-5.

The plurality of third connection patterns 112c may be formed (or configured) as an electrode material layer of each of the third electrode layer 113-3 and the fifth electrode layer 113-5 which intactly remains without being patterned or removed by a patterning process of each of the third electrode layer 113-3 and the fifth electrode layer 113-5.

The plurality of third connection patterns 112c may more increase a coupling force between the vibration generating part 110 and the second connection member 118B. Accordingly, the second connection member 118B may be additionally connected (or coupled) to the plurality of third connection patterns 112c, and thus, stripping of the second connection member 118B connected (or coupled) to the vibration generating part 110 may be more prevented.

Each of the first to fourth vibration layers 111-1 to 111-4 or the vibration part 111 according to an example of the present disclosure may be poled by a certain voltage applied from the outside to a first electrode and a second electrode in a constant temperature atmosphere or a temperature atmosphere which is changed from a high temperature to a room temperature, but examples of the present disclosure are not limited thereto. For example, in a constant temperature atmosphere or a temperature atmosphere which is changed from a high temperature to a room temperature, a first poling voltage may be applied to the first, third, and fifth electrode layers 113-1, 113-3, and 113-5 through the first connection member 118A in common, and a second poling voltage may be applied to the second and fourth electrode layers 113-2 and 113-4 through the connection pattern 112a and the second connection member 118B in common. Accordingly, the first to fourth vibration layers 111-1 to 111-4 may be simultaneously poled by the first poling voltage and the second poling voltage, but examples of the present disclosure are not limited thereto. Each of the first to fifth electrode layers 113-1 to 113-5 may be spaced apart from one surface (or an outer sidewall) of each of corresponding vibration layers 111-1 to 111-4 by a predetermined distance (or interval), and thus, an electrical short circuit between the first to fifth electrode layers 113-1 to 113-5 may be prevented in a poling process.

According to an example of the present disclosure, the plurality of or first to fourth vibration layers 111-1 to 111-4 may be classified or grouped into a first group and a second group.

The vibration layers 111-1 and 111-3 included in the first group may have a same poling direction. The vibration layers 111-2 and 111-4 included in the second group may have a same poling direction. The vibration layers 111-1 and 111-3 included in the first group and the vibration layers 111-2 and 111-4 included in the second group may have different poling directions. For example, the vibration layers 111-1 and 111-3 included in the first group and the vibration layers 111-2 and 111-4 included in the second group may have poling directions opposite to each other.

According to an example of the present disclosure, in the plurality of or first to fourth vibration layers 111-1 to 111-4, the vibration layers 111-1 and 111-3 included in the first group may have a same poling direction, and the vibration layers 111-2 and 111-4 included in the second group may have a same poling direction. The vibration layers 111-1 and 111-3 and the vibration layers 111-2 and 111-4 may have poling directions opposite to each other. For example, each of the vibration layers 111-1 and 111-3 may have a poling direction toward the second surface 111a2 from the first surface 111a1, and each of the vibration layers 111-2 and 111-4 may have a poling direction toward the first surface 111a1 from the second surface 111a2, but examples of the present disclosure are not limited thereto.

According to an example of the present disclosure, the plurality of or first to fourth vibration layers 111-1 to 111-4, which are vertically overlapping or overlaying each other, may be displaced (or vibrated or driven) in the same direction, and thus, the vibration apparatus 100 or the vibration generating part 110 may have a strong driving force or a large displacement force.

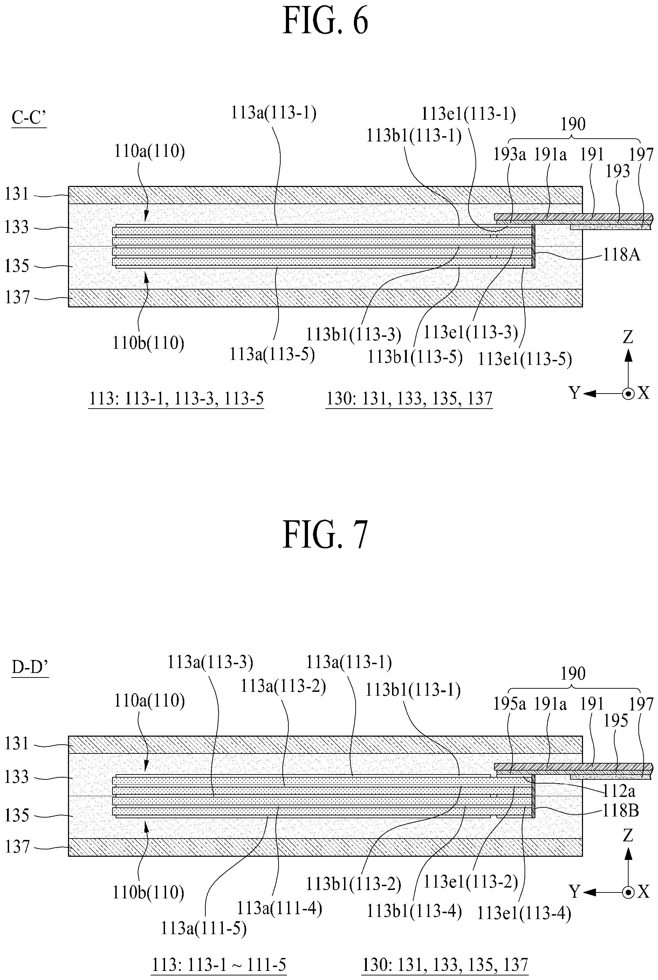

FIG. 6 is a cross-sectional view taken along line C-C' illustrated in FIG. 1 according to an example of the present disclosure. FIG. 7 is a cross-sectional view taken along line D-D' illustrated in FIG. 1 according to an example of the present disclosure.

With reference to FIGs. 1, 6, and 7, the vibration apparatus 100 according to an example of the present disclosure may further include a cover member 130.

The cover member 130 may be configured to cover at least one or more of the first surface 110a and the second surface 110b of the vibration generating part 110. The cover member 130 may be configured to protect at least one or more of the first surface 110a and the second surface 110b of the vibration generating part 110.

The cover member 130 according to an example of the present disclosure may include a first cover member 131.

The first cover member 131 may be disposed at the first surface 110a of the vibration generating part 110. The first cover member 131 may be configured to cover an uppermost electrode layer of the vibration generating part 110. For example, the first cover member 131 may be configured to cover the first electrode layer 113-1 of the vibration generating part 110. For example, the first cover member 131 may be configured to have a size which is greater than the vibration generating part 110. The first cover member 131 may be configured to protect the first surface 110a and the first electrode layer 113-1 of the vibration generating part 110.

The first cover member 131 according to an example of the present disclosure may include an adhesive layer. For example, the first cover member 131 may include a base film, and an adhesive layer disposed on the base film and connected or coupled to the first surface 110a of the vibration generating part 110. For example, the adhesive layer may include an electrically insulating material which has adhesiveness and is capable of compression and decompression.

The first cover member 131 according to another example of the present disclosure may be connected or coupled to the first surface 110a of the vibration generating part 110 by a first adhesive layer 133. For example, the first cover member 131 may be connected or coupled to the first surface 110a of the vibration generating part 110 or the first electrode layer 113-1 by the first adhesive layer 133. For example, the first cover member 131 may be connected or coupled to the first surface 110a of the vibration generating part 110 or the first electrode layer 113-1 by a film laminating process using the first adhesive layer 133. The first adhesive layer 133 may be configured to surround an entire first surface 110a of the vibration generating part 110 and a portion of side surfaces of the vibration generating part 110.

The cover member 130 according to an example of the present disclosure may further include a second adhesive layer 135.

The second adhesive layer 135 may be disposed at the second surface 110b of the vibration generating part 110. The second adhesive layer 135 may be configured to cover a lowermost electrode layer of the vibration generating part 110. For example, the second adhesive layer 135 may be configured to cover the vibration generating part 110. The second adhesive layer 135 may be configured to protect the second surface 110b of the vibration generating part 110 and the fifth electrode layer 113-5. The second adhesive layer 135 may be configured to surround an entire second surface 110b of the vibration generating part 110 and a portion of side surfaces of the vibration generating part 110. For example, the second adhesive layer 135 may be a protection layer or a protection member, but examples of the present disclosure are not limited thereto.

The second adhesive layer 135 may be connected or coupled to the first adhesive layer 133 at a lateral surface of the vibration generating part 110 or a periphery portion of the first cover member 131. Accordingly, the first adhesive layer 133 and the second adhesive layer 135 may be configured to surround or completely surround the vibration generating part 110. The first adhesive layer 133 and the second adhesive layer 135 may be configured to cover or surround all surfaces of the vibration generating part 110. For example, the vibration generating part 110 may be inserted (or accommodated) or embedded (or built-in) inside the adhesive layer including the first adhesive layer 133 and the second adhesive layer 135.

The cover member 130 according to an example of the present disclosure may further include a second cover member 137, but examples of the present disclosure are not limited thereto.

The second cover member 137 may be disposed at the second surface 110b of the vibration generating part 110. The second cover member 137 may be configured to cover a lowermost electrode layer of the vibration generating part 110. For example, the second cover member 137 may be configured to cover the fifth electrode layer 113-5 of the vibration generating part 110. For example, the second cover member 137 may be configured to have a size which is greater than the vibration generating part 110, or may be configured to have a same size as the first cover member 131. The second cover member 137 may be configured to protect the second surface 110b of the vibration generating part 110 and the fifth electrode layer 113-5.

The first cover member 131 and second cover member 137 according to an example of the present disclosure may include a same material or different material. For example, each of the first cover member 131 and second cover member 137 may be a polyimide film, a polyethylene naphthalate, or a polyethylene terephthalate film, but examples of the present disclosure are not limited thereto.

The second cover member 137 may be connected or coupled to the second surface 110b of the vibration generating part 110 or the fifth electrode layer 113-5 by the second adhesive layer 135. For example, the second cover member 137 may be connected or coupled to the second surface 110b of the vibration generating part 110 or the fifth electrode layer 113-5 by a film laminating process using the second adhesive layer 135.

The vibration generating part 110 may be disposed or inserted (or accommodated) between first cover member 131 and the second cover member 137. For example, the vibration generating part 110 may be inserted (or accommodated) or embedded (or built-in) inside the adhesive layer including the first adhesive layer 133 and the second adhesive layer 135.

Each of the first adhesive layer 133 and the second adhesive layer 135 according to another example of the present disclosure may include an electrically insulating material which has adhesiveness and is capable of compression and decompression. For example, each of the first adhesive layer 133 and the second adhesive layer 135 may include an epoxy resin, an acrylic resin, a silicone resin, a urethane resin, a pressure sensitive adhesive (PSA), an optically cleared adhesive (OCA), or an optically cleared resin (OCR), but examples of the present disclosure are not limited thereto.

Each of the first adhesive layer 133 and second adhesive layer 135 according to another example of the present disclosure may include an insulating adhesive material. For example, each of the first adhesive layer 133 and second adhesive layer 135 may include one or more of a thermo-curable adhesive, a photo-curable adhesive, and a thermosetting adhesive (or a thermal bonding adhesive). For example, each of the first adhesive layer 133 and second adhesive layer 135 may include the thermo-curable adhesive or the thermosetting adhesive. The thermosetting adhesive may be a heat-active type or a thermo-curable type, but examples of the present disclosure are not limited thereto.

The first adhesive layer 133 and the second adhesive layer 135 may be configured between first cover member 131 and the second cover member 137 to surround the vibration generating part 110. For example, one or more of the first adhesive layer 133 and the second adhesive layer 135 may be configured to surround the vibration generating part 110.

The vibration apparatus 100 according to an example of the present disclosure may further include a signal supply member 190.

The signal supply member 190 may be configured to be electrically connected to the vibration generating part 110 at one side of the vibration generating part 110. The signal supply member 190 may be configured to be electrically connected to each of the first connection member 118A and the second connection member 118B, at one side of the vibration generating part 110. For example, the signal supply member 190 may be configured to be electrically connected to each of the first electrode layer 113-1 of the vibration generating part 110 and the connection pattern 112a, at one side of the vibration generating part 110. The signal supply member 190 may be configured to be electrically connected to each of the first electrode layer 113-1 of the vibration generating part 110 and the connection pattern 112a, on one side of the vibration generating part 110 and the first surface 110a of the vibration generating part 110.

The signal supply member 190 may be configured to be electrically connected to the first surface 110a of the vibration generating part 110 between the vibration generating part 110 and the cover member 130. The signal supply member 190 may be configured to be electrically connected to each of the first electrode layer 113-1 and the connection pattern 112a in the first surface 110a of the vibration generating part 110 at a region between the vibration generating part 110 and the cover member 130. The signal supply member 190 may be disposed (or configured) between the vibration generating part 110 and the cover member 130 to be electrically connected to each of the first connection member 118A and the second connection member 118B.

A portion of the signal supply member 190 may be accommodated (or inserted) between the vibration generating part 110 and the cover member 130. For example, the portion of the signal supply member 190 may be accommodated (or inserted) between the first surface 110a of the vibration generating part 110 and the first cover member 131. For example, the portion of the signal supply member 190 may be accommodated (or inserted) between the first cover member 131 and the second cover member 137.

According to an example of the present disclosure, an end portion (or a distal end portion or one side) of the signal supply member 190 may be disposed or inserted (or accommodated) between one periphery portion of the vibration generating part 110 and one periphery portion of the cover member 130. For example, the end portion (or the distal end portion or one side) of the signal supply member 190 may be disposed or inserted (or accommodated) between one periphery portion of the first cover member 131 and the first surface 110a of the vibration generating part 110.

According to an example of the present disclosure, the portion of the signal supply member 190 may be disposed or inserted (or accommodated) in a portion between one periphery portion of the first cover member 131 and one periphery portion of the second cover member 137. One periphery portion of the first cover member 131 and one periphery portion of the second cover member 137 may accommodate or vertically cover the portion of the signal supply member 190. Accordingly, the signal supply member 190 may be integrated into (or configured as one body with) the vibration generating part 110 by the first cover member 131 and the second cover member 137. For example, the vibration apparatus 100 according to an example of the present disclosure may be a vibration apparatus in which the signal supply member 190 is integrated. The portion of the signal supply member 190 may be inserted (or accommodated) and fixed between the cover member 130 and the vibration generating part 110, or may be inserted (or accommodated) and fixed between the first cover member 131 and the second cover member 137, and thus, a contact defect between the vibration generating part 110 and the signal supply member 190 caused by the movement or bending of the signal supply member 190 which occurs during the manufacturing process of attaching the signal supply member 190 to the vibration generating part 110 may be prevented.

According to an example of the present disclosure, the signal supply member 190 may be configured as a signal cable, a cable member, a flexible cable, a flexible printed circuit cable, a flexible flat cable, a single-sided flexible printed circuit, a single-sided flexible printed circuit board, a flexible multilayer printed circuit, or a flexible multilayer printed circuit board, but examples of the present disclosure are not limited thereto.

The signal supply member 190 according to an example of the present disclosure may include a base film 191 and a plurality of signal lines 193 and 195. For example, the signal supply member 190 may include a base film 191, a first signal line 193, a second signal line 195, and an insulation film 197.

The base film 191 may include a transparent or opaque plastic material. The base film 191 may be a flexible film, a base insulation film, or a base member, but examples of the present disclosure are not limited thereto. The base film 191 may have a certain width along the first direction X and may be extended long along the second direction Y.

Each of the first and second signal lines (or a plurality of signal lines) 193 and 195 may be disposed at a first surface of the base film 191 to be parallel to the second direction Y, and may be spaced apart from or separated from each other along the first direction X. Each of the first and second signal lines 193 and 195 may be disposed parallel to each other at the first surface of the base film 191. For example, each of the first and second signal lines 193 and 195 may be implemented in a line shape by patterning a metal layer (or a conductive layer) formed or deposited at the first surface of the base film 191. For example, the first surface of the base film 191 may be a rear surface of the base film 191, but examples of the present disclosure are not limited thereto.

The insulation film 197 may be disposed at the first surface of the base film 191 to cover each of the first signal line 193 and the second signal line 195. The first and second signal lines (or the plurality of signal lines) 193 and 195 may be disposed between the base film 191 and the insulation film 197. The insulation film 197 may be a protection film, a coverlay film, a cover film, or a cover insulation film, but examples of the present disclosure are not limited thereto.

The first signal line 193 may be configured to be electrically connected to the first connection member 118A. The first signal line 193 may be disposed between the cover member 130 and the vibration generating part 110, and may be electrically connected to the first electrode layer 113-1 of the vibration generating part 110. The first signal line 193 may be electrically connected to an extension portion of the first extension pattern 113e1 or the first sub-electrode 113b1 of the first electrode layer 113-1 in the vibration generating part 110, between the cover member 130 and the first surface 110a of the vibration generating part 110.

With reference to FIGs. 1 and 6, an end portion (or one side) 193a of the first signal line 193 may be electrically connected to the first electrode layer 113-1 of the vibration generating part 110, between the first surface 110a of the vibration generating part 110 and the first cover member 131. The end portion 193a of the first signal line 193 may be electrically connected to the first extension pattern 113e1 of the first electrode layer 113-1 or the extension portion of the first sub-electrode 113b1. The end portion (or one side) 193a of the first signal line 193 may be electrically connected to (or coupled or in contact with) each of the first extension pattern 113e1 of the first electrode layer 113-1 and an upper surface of the first connection member 118A. Accordingly, a driving signal (or a first driving signal) supplied from an external vibration driving circuit may be supplied to the first electrode layer 113-1 of the vibration generating part 110 through the first signal line 193, and may be commonly supplied to the third electrode layer 113-3 and the fifth electrode layer 113-5 of the vibration generating part 110 through the first connection member 118A. For example, the end portion (or one side) 193a of the first signal line 193 may be a first electrode connection portion or a first electrode contact portion, but examples of the present disclosure are not limited thereto.

The second signal line 195 may be configured to be electrically connected to the second connection member 118B. The second signal line 195 may be disposed between the cover member 130 and the vibration generating part 110, and may be electrically connected to the second connection member 118B. The second signal line 195 may be disposed between the cover member 130 and the vibration generating part 110, and may be electrically connected to each of the connection pattern 112a of the vibration generating part 110 and the second connection member 118B. The second signal line 195 may be electrically connected to each of the connection pattern 112a of the vibration generating part 110 and the second connection member 118B, between the cover member 130 and the first surface 110a of the vibration generating part 110.

With reference to FIGs. 1 and 7, an end portion (or one side) 195a of the second signal line 195 may be electrically connected to (or coupled or in contact with) each of the connection pattern 112a of the vibration generating part 110 and the second connection member 118B, between the first surface 110a of the vibration generating part 110 and the first cover member 131. Accordingly, a driving signal (or a second driving signal) supplied from the external vibration driving circuit may be supplied to the connection pattern 112a of the vibration generating part 110 through the second signal line 195, and may be commonly supplied to the second electrode layer 113-2 and the fourth electrode layer 113-4 of the vibration generating part 110 through the connection pattern 112a. For example, the end portion (or one side) 193a of the second signal line 195 may be a second electrode connection portion or a second electrode contact portion, but examples of the present disclosure are not limited thereto.

According to another example of the present disclosure, each of the end portion (or one side) 193a of the first signal line 193 and the end portion (or one side) 195a of the second signal line 195 may not be covered by the insulation film 197 and may be supported by the extension portion 191a of the base film 191, but examples of the present disclosure are not limited thereto. For example, the extension portion 191a of the base film 191 may be removed. For example, each of the end portion (or one side) 193a of the first signal line 193 and the end portion (or one side) 195a of the second signal line 195 may protrude (or extend) to have a predetermined length from the end portion of the base film 191 without being supported or covered by the base film 191 and the insulation film 197. Accordingly, each of the end portion (or one side) 193a of the first signal line 193 and the end portion (or one side) 195a of the second signal line 195 may be bent or curved. For example, the end portion (or one side) 193a of the first signal line 193 and the end portion (or one side) 195a of the second signal line 195 which are not supported by the base film 191 and the insulation film 197 may be a first protruding line, a first protruding electrode, a first conductive protruding line, a first flexible protruding line, or a first flexible protruding electrode, but examples of the present disclosure are not limited thereto.

The vibration apparatus 100 according to an example of the present disclosure may include the plurality of vibration layers 111-1 to 111-4 which are vertically stacked and are displaced (or vibrated or driven) in the same direction, and thus, may have a strong driving force or a large displacement force, thereby enhancing a sound pressure level characteristic and/or a sound characteristic. For example, a sound pressure level characteristic of a sound and a sound characteristic of a middle-low-pitched sound band may be enhanced.

Comparing with a structure where an electrode layer and a vibration layer have the same size and shape, in the vibration apparatus 100 according to an example of the present disclosure, the electrode layers 113-1 to 113-5 may be configured to have a shape which differs from that of each of the vibration layers 111-1 to 111-4 and a size which is smaller than that of each of the vibration layers 111-1 to 111-4, and thus, the vibration apparatus 100 according to an example of the present disclosure may have a relatively low capacitance, and a thickness of each of the vibration layers 111-1 to 111-4 may be slimmed. The vibration apparatus 100 according to an example of the present disclosure may be low in occurrence of heat and may be driven by a low-cost driving circuit.

According to the vibration apparatus 300 according to an example of the present disclosure, a soldering process for an electrical connection between the vibration generating part 110 and the signal supply member 190 may not be needed, and thus, a manufacturing process and a structure of the vibration apparatus 100 may be simplified. The vibration apparatus 100 with the signal supply member 190 integrated therein may be provided, and thus, the signal supply member 190 and the vibration generating part 110 may be configured as one part, thereby realizing a uni-materialization effect.

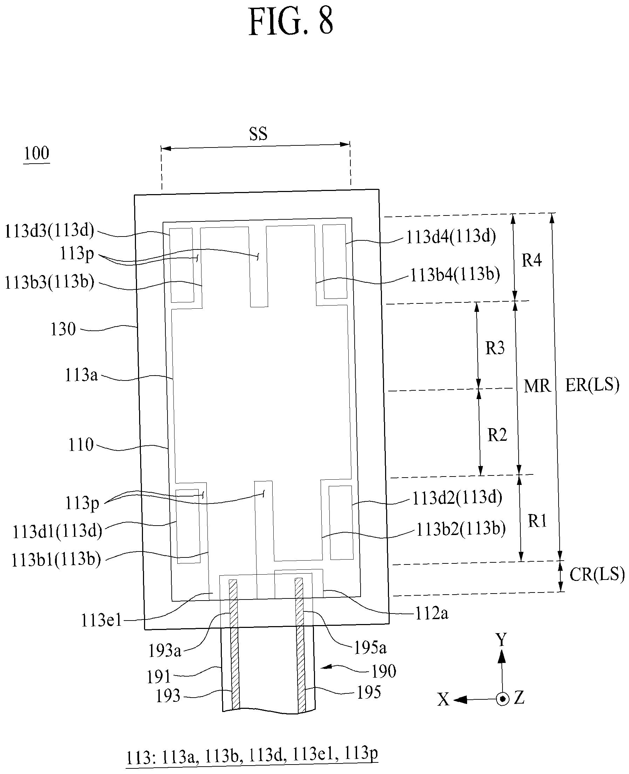

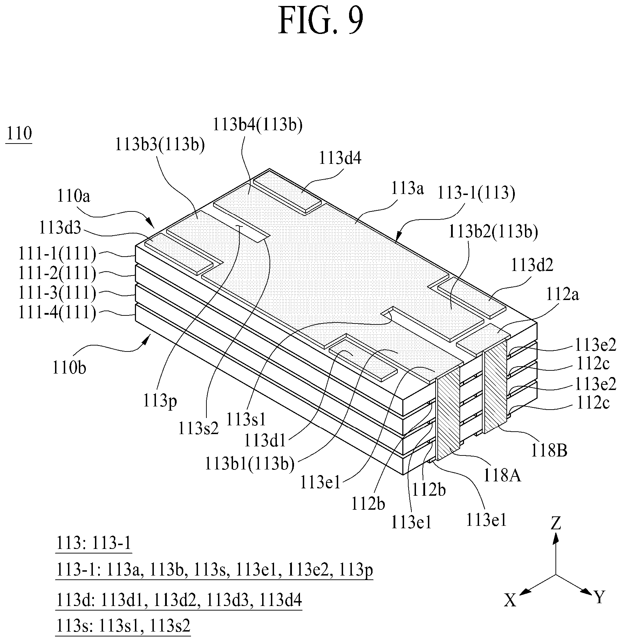

FIG. 8 illustrates a vibration apparatus according to another example (or a second example) of the present disclosure. FIG. 9 illustrates a vibration generating part illustrated in FIG. 8 according to an example of the present disclosure. FIGs. 8 and 9 illustrate an example where a dummy pattern is additionally configured to the vibration apparatus described above with reference to FIGs. 1 to 7. Hereinafter, in describing the vibration apparatus according to the second example of the present disclosure, elements differing from the elements of the vibration apparatus 100 according to the first example of the present disclosure will be mainly described. The descriptions of the vibration apparatus 100 described above with reference to FIGs. 1 to 7 may be included in descriptions of the vibration apparatus 100 illustrated in FIGs. 8 and 9, and thus, like reference numerals refer to like elements and repeated descriptions may be omitted or will be briefly given below.

With reference to FIGs. 8 and 9, in the vibration apparatus 100 according to the second example of the present disclosure, the vibration generating part 110 or the electrode part 113 may further include a dummy pattern part 113d.

The dummy pattern part 113d may be disposed (or configured) at a periphery of each of the first to fifth electrode layers 113-1 to 113-5 so as to be electrically disconnected (or insulated) from each of the first to fifth electrode layers 113-1 to 113-5. The dummy pattern part 113d may be disposed (or configured) to be spaced apart or electrically disconnected (or insulated) from the main electrode 113a and the sub-electrode 113b.

The dummy pattern part 113d may be disposed (or configured) to be spaced apart or electrically disconnected (or insulated) from the main electrode 113a and the sub-electrode 113b. The dummy pattern part 113d may be disposed (or configured) at the patterning region 113p of the electrode part 113. For example, the dummy pattern part 113d may be disposed (or configured) at the patterning region 113p of the electrode part 113 corresponding to a corner portion of each of the first to fourth vibration layers 111-1 to 111-4. The dummy pattern part 113d may be disposed (or configured) at the patterning region 113p of each of the first to fifth electrode layers 113-1 to 113-5. For example, the dummy pattern part 113d may be disposed (or configured) at the patterning region 113p of each of the first to fifth electrode layers 113-1 to 113-5 overlapping the corner portion of each of the first to fourth vibration layers 111-1 to 111-4.

The dummy pattern part 113d may be formed at corresponding vibration layers 111-1 to 111-4 together with each of the first to fifth electrode layers 113-1 to 113-5. For example, the dummy pattern part 113d may be an electrode layer of each of the electrode layers 113-1 to 113-5 which intactly remain without being patterned or removed by a patterning process on each of the first to fifth electrode layers 113-1 to 113-5. For example, each of the first to fifth electrode layers 113-1 to 113-5 may further include a dummy pattern part 113d which is disposed at a periphery of each of the main electrode 113a and the sub-electrode 113b. For example, each of the first to fifth electrode layers 113-1 to 113-5 may further include the dummy pattern part 113d which is disposed at the patterning region 113p of each of the main electrode 113a and the sub-electrode 113b.

The dummy pattern part 113d according to an example of the present disclosure may include first to fourth dummy patterns 113d1, 113d2, 113d3, and 113d4. For example, each of the first to fourth dummy patterns 113d1, 113d2, 113d3, and 113d4 may be an island pattern, a non-driving electrode, or a non-driving main electrode, but examples of the present disclosure are not limited thereto.

The first dummy pattern 113d1 may be disposed at the patterning region (or a first patterning region) 113p of each of the first to fifth electrode layers 113-1 to 113-5 overlapping a first corner portion of each of the first to fourth vibration layers 111-1 to 111-4. For example, the first dummy pattern 113d1 may be disposed at the patterning region (or first patterning region) 113p which overlaps the first corner portion of each of the first to fourth vibration layers 111-1 to 111-4 and is adjacent to the first sub-electrode 113b1 of each of the first to fifth electrode layers 113-1 to 113-5.

The second dummy pattern 113d2 may be disposed at the patterning region (or a second patterning region) 113p of each of the first to fifth electrode layers 113-1 to 113-5 overlapping a second corner portion of each of the first to fourth vibration layers 111-1 to 111-4. For example, the second dummy pattern 113d2 may be disposed at the patterning region (or second patterning region) 113p which overlaps the second corner portion of each of the first to fourth vibration layers 111-1 to 111-4 and is adjacent to the second sub-electrode 113b2 of each of the first to fifth electrode layers 113-1 to 113-5.

The third dummy pattern 113d3 may be disposed at the patterning region (or a third patterning region) 113p of each of the first to fifth electrode layers 113-1 to 113-5 overlapping a third corner portion of each of the first to fourth vibration layers 111-1 to 111-4. For example, the third dummy pattern 113d3 may be disposed at the patterning region (or third patterning region) 113p which overlaps the third corner portion of each of the first to fourth vibration layers 111-1 to 111-4 and is adjacent to the third sub-electrode 113b3 of each of the first to fifth electrode layers 113-1 to 113-5.

The fourth dummy pattern 113d4 may be disposed at the patterning region (or a fourth patterning region) 113p of each of the first to fifth electrode layers 113-1 to 113-5 overlapping a fourth corner portion of each of the first to fourth vibration layers 111-1 to 111-4. For example, the fourth dummy pattern 113d4 may be disposed at the patterning region (or fourth patterning region) 113p which overlaps the fourth corner portion of each of the first to fourth vibration layers 111-1 to 111-4 and is adjacent to the fourth sub-electrode 113b4 of each of the first to fifth electrode layers 113-1 to 113-5.

The dummy pattern part 113d may minimize a space (or a gap space) between the first to fourth vibration layers 111-1 to 111-4 which are vertically stacked, thereby minimizing or preventing the damage of a vibration layer which occurs in a space or a spacer periphery between the first to fourth vibration layers 111-1 to 111-4 due to pressing of the vibration generating part 110. Also, the dummy pattern part 113d may increase a mass of each of corresponding vibration layers 111-1 to 111-4. Accordingly, a natural frequency of each of the first to fourth vibration layers 111-1 to 111-4 may increase due to an increase in mass caused by the dummy pattern part 113d.

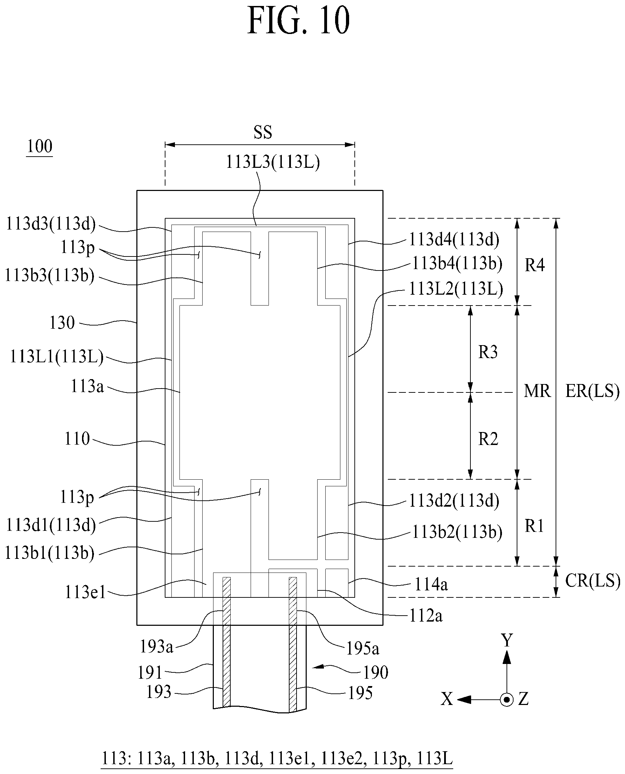

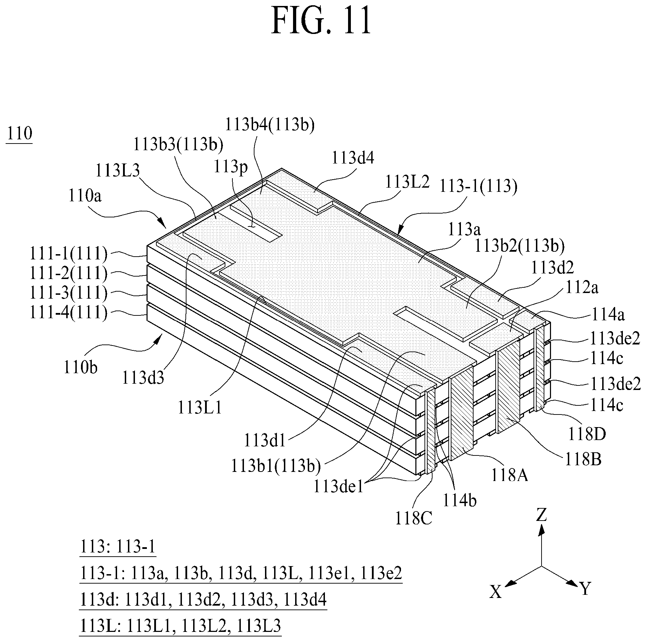

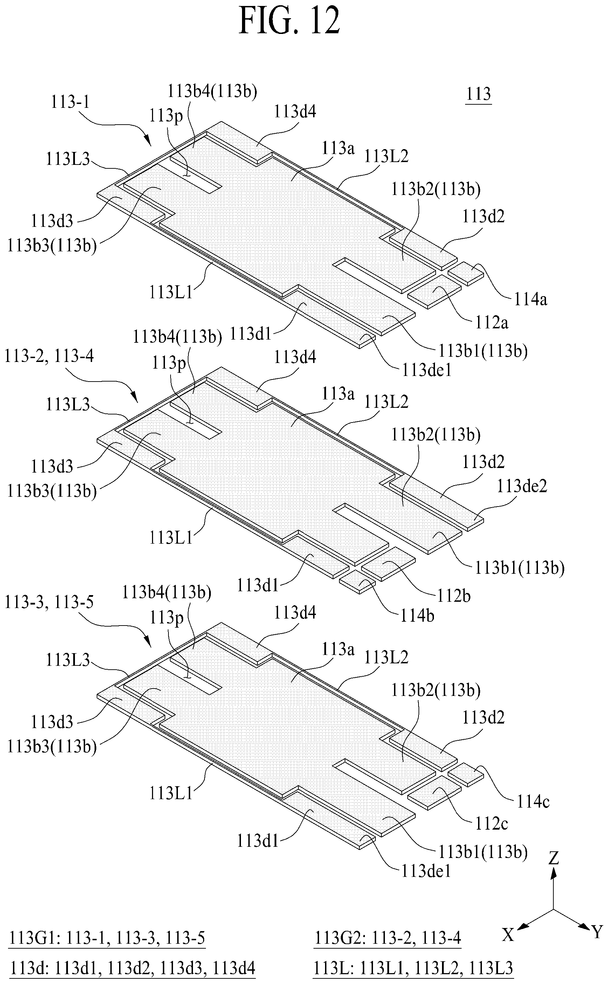

FIG. 10 illustrates a vibration apparatus according to another example (or a third example) of the present disclosure. FIG. 11 illustrates a vibration generating part illustrated in FIG. 10 according to an example of the present disclosure. FIG. 12 illustrates an electrode part illustrated in FIGs. 10 and 11 according to an example of the present disclosure. FIGs. 10 to 12 illustrate an example where an electrode connection line is additionally configured at the dummy pattern part of the vibration apparatus described above with reference to FIGs. 1 to 9. Hereinafter, in describing the vibration apparatus 100 according to the third example of the present disclosure, elements differing from the elements of the vibration apparatus 100 according to the first and second examples of the present disclosure will be mainly described. The descriptions of the vibration apparatus 100 described above with reference to FIGs. 1 to 9 may be included in descriptions of the vibration apparatus 100 illustrated in FIGs. 10 to 12, and thus, like reference numerals refer to like elements and repeated descriptions may be omitted or will be briefly given below.

With reference to FIGs. 10 to 12, in the vibration generating part 110 of the vibration apparatus 100 according to the third example of the present disclosure, the electrode part 113 or the dummy pattern part 113d may further include an electrode connection line 113L which is configured to electrically connect the first to fourth dummy patterns 113d1, 113d2, 113d3, and 113d4 with each other.

The electrode connection line 113L may be configured to be electrically connected between the first to fourth dummy patterns 113d1, 113d2, 113d3, and 113d4. The electrode connection line 113L may be disposed at an edge portion (or a periphery portion) of each of the first to fourth vibration layers 111-1 to 111-4 and may be configured to be electrically connected between the first to fourth dummy patterns 113d1, 113d2, 113d3, and 113d4.

The electrode connection line 113L according to an example of the present disclosure may include first to third electrode connection lines 113L1, 113L2, and 113L3. The first to third electrode connection lines 113L1, 113L2, and 113L3 may be for an electrical connection between the first to fourth dummy patterns 113d1, 113d2, 113d3, and 113d4, and thus, may include a line shape having a relatively thin width.

The first electrode connection line 113L1 may be configured to electrically connect the first dummy pattern 113d1 and the second dummy pattern 113d3. The first electrode connection line 113L1 may be disposed at a portion, which is between the first dummy pattern 113d1 and the second dummy pattern 113d3, of an edge portion (or a periphery portion) adjacent to one long side (or a first long side) of each of the first to fourth vibration layers 111-1 to 111-4. Accordingly, the first dummy pattern 113d1 and the third dummy pattern 113d3 may be electrically connected to each other by the first electrode connection line 113L1.

The second electrode connection line 113L2 may be configured to electrically connect the second dummy pattern 113d2 and the fourth dummy pattern 113d4. The second electrode connection line 113L2 may be disposed at a portion, which is between the second dummy pattern 113d2 and the fourth dummy pattern 113d4, of an edge portion (or a periphery portion) adjacent to the other long side (or a second long side) of each of the first to fourth vibration layers 111-1 to 111-4. Accordingly, the second dummy pattern 113d2 and the fourth dummy pattern 113d4 may be electrically connected to each other by the second electrode connection line 113L2.

The third electrode connection line 113L3 may be configured to electrically connect the third dummy pattern 113d3 and the fourth dummy pattern 113d4. The third electrode connection line 113L3 may be disposed at a portion, which is between the third dummy pattern 113d3 and the fourth dummy pattern 113d4, of an edge portion (or a periphery portion) adjacent to the other short side (or a second short side) of each of the first to fourth vibration layers 111-1 to 111-4. Accordingly, the third dummy pattern 113d3 and the fourth dummy pattern 113d4 may be electrically connected to each other by the third electrode connection line 113L3.

The first to fourth dummy patterns 113dl, 113d2, 113d3, and 113d4 and the first to third electrode connection lines 113L1, 113L2, and 113L3 may be disposed (or configured) at the other edge portion, except one edge portion adjacent to one short side (or a first short side), of an edge portion of each of the first to fourth vibration layers 111-1 to 111-4.

The first dummy pattern 113d1 adjacent to the first sub-electrode 113b1 in the electrode layers 113-1, 113-3, and 113-5 of the first group 113G1 among the first to fifth electrode layers 113-1 to 113-5 may extend to the connection region CR of each of the first to fourth vibration layers 111-1 to 111-4. For example, the first dummy pattern 113d1 adjacent to the first sub-electrode 113b1 in the first, third, and fifth electrode layers 113-1, 113-3, and 113-5 of the first group 113G1 among the first to fifth electrode layers 113-1 to 113-5 may extend to the connection region CR of each of the first to fourth vibration layers 111-1 to 111-4. For example, a portion, extending to the connection region CR, of each of the first to fourth vibration layers 111-1 to 111-4 in the first dummy pattern 113d1 may be a first dummy extension pattern (or a third extension pattern) 113de1.

The first dummy extension pattern 113de1 may be disposed in parallel with the first extension pattern 113e1 of the first sub-electrode 113b1. An end (or an end surface) of the first dummy extension pattern 113de1 may be exposed at one lateral surface (or one short side) of the vibration generating part 110 or the electrode part 113. For example, one lateral surface (or one sidewall) of the first dummy extension pattern 113de1 may be exposed at the one lateral surface (or the one short side) of the vibration generating part 110 or the electrode part 113.

The second dummy pattern 113d2 adjacent to the second sub-electrode 113b2 in the electrode layers 113-2 and 113-4 of the second group 113G2 among the first to fifth electrode layers 113-1 to 113-5 may extend to the connection region CR of each of the first to fourth vibration layers 111-1 to 111-4. For example, the second dummy pattern 113d2 adjacent to the second sub-electrode 113b2 in the second and fourth electrode layers 113-2 and 113-4 of the second group 113G2 among the first to fifth electrode layers 113-1 to 113-5 may extend to the connection region CR of each of the first to fourth vibration layers 111-1 to 111-4. For example, a portion, extending to the connection region CR, of each of the first to fourth vibration layers 111-1 to 111-4 in the second dummy pattern 113d2 may be a second dummy extension pattern (or a fourth extension pattern) 113de2.

The second dummy extension pattern 113de2 may be disposed in parallel with the second extension pattern 113e2 of the second sub-electrode 113b2. An end (or an end surface) of the second dummy extension pattern 113de2 may be exposed at one lateral surface (or one short side) of the vibration generating part 110 or the electrode part 113. For example, one lateral surface (or one sidewall) of the second dummy extension pattern 113de2 may be exposed at the one lateral surface (or the one short side) of the vibration generating part 110 or the electrode part 113.

The vibration apparatus 100 according to a third example of the present disclosure may further include a third connection member 118C and a fourth connection member 118D.

The third connection member 118C may be configured to be electrically connected to the first dummy extension pattern 113de1 disposed at the electrode layers 113-1, 113-3, and 113-5 of the first group 113G1 among the first to fifth electrode layers 113-1 to 113-5. For example, the third connection member 118C may be formed (or disposed) at one surface (or one short side) of the vibration generating part 110 or the electrode part 113 in parallel with the first connection member 118A and may be configured to be electrically (or in common) connected to the first dummy extension pattern 113de1 disposed at each of the first, third, and fifth electrode layers 113-1, 113-3, and 113-5. Except for that the third connection member 118C is connected to in common the first dummy extension pattern 113de1 disposed at each of the first, third, and fifth electrode layers 113-1, 113-3, and 113-5, the third connection member 118C may be the same or substantially a same as the first connection member 118A, and thus, its description is omitted.

The fourth connection member 118D may be configured to be electrically connected to the second dummy extension pattern 113de2 disposed at the electrode layers 113-2 and 113-4 of the second group 113G2 among the first to fifth electrode layers 113-1 to 113-5. For example, the fourth connection member 118D may be formed (or disposed) at one surface (or one short side) of the vibration generating part 110 or the electrode part 113 in parallel with the second connection member 118B and may be configured to be electrically (or in common) connected to the second dummy extension pattern 113de2 disposed at each of the second and fourth electrode layers 113-2 and 113-4. Except for that the fourth connection member 118D is connected to in common the second dummy extension pattern 113de2 disposed at each of the second and fourth electrode layers 113-2 and 113-4, the fourth connection member 118D may be the same or substantially a same as the second connection member 118B, and thus, its description is omitted.

Each of the third and fourth connection members 118C and 118D according to an example of the present disclosure may include a conductive material or a conductive adhesive. For example, the third and fourth connection members 118C and 118D may be formed (or configured) together with the first and second connection members 118A and 118B, and thus, their descriptions are omitted.

The vibration apparatus 100 or the vibration generating part 110 according to the third example of the present disclosure may further include an auxiliary connection pattern 114a. For example, the auxiliary connection pattern 114a may be an additional connection pattern, a first additional connection pattern, a first auxiliary connection pattern, or a fourth connection pattern, but examples of the present disclosure are not limited thereto.

The auxiliary connection pattern 114a may be configured to transfer a poling voltage, applied from the outside, to the fourth connection member 118D. The auxiliary connection pattern 114a may be configured at the first surface 110a of the vibration generating part 110 so as to be electrically connected to the fourth connection member 118D. For example, the auxiliary connection pattern 114a may be disposed (or configured) in an island shape at the connection region CR of the vibration generating part 110 or the first vibration layer 111-1 so as to be electrically disconnected from the first electrode layer 113-1. The auxiliary connection pattern 114a may be disposed at the connection region CR of the first vibration layer 111-1 adjacent to the second dummy pattern 113d2 disposed at the first electrode layer 113-1. The auxiliary connection pattern 114a may be configured at the first surface 110a of the vibration generating part 110 so as to be electrically connected to the fourth connection member 118D and parallel to the connection pattern 112a. The auxiliary connection pattern 114a may be formed (or configured) together with the connection pattern 112a, and thus, their descriptions are omitted.

The vibration apparatus 100 or the vibration generating part 110 according to the third example of the present disclosure may further include a plurality of second auxiliary connection patterns (or fifth connection patterns) 114b and a plurality of third auxiliary connection patterns (or sixth connection patterns) 114c.

The plurality of second auxiliary connection patterns 114b may be disposed (or configured) at the first surface 111s1 of each of the second vibration layer 111-2 and the fourth vibration layer 111-4 corresponding to a region between each of the second electrode layer 113-2 and the fourth electrode layer 113-4 and the third connection member 118C. For example, the plurality of second auxiliary connection patterns 114b may be disposed (or configured) in an island shape at the connection region CR of each of the second vibration layer 111-2 and the fourth vibration layer 111-4 so as to be electrically disconnected (or insulated) from each of the second electrode layer 113-2 and the fourth electrode layer 113-4. The plurality of second auxiliary connection patterns 114b may be disposed (or configured) at the connection region CR of each of the second vibration layer 111-2 and the fourth vibration layer 111-4 so as to be adjacent to the first dummy pattern 113d1 disposed at each of the second electrode layer 113-2 and the fourth electrode layer 113-4. The plurality of second auxiliary connection patterns 114b may be disposed to be electrically connected to the third connection member 118C and parallel to each of the plurality of second connection patterns 112b. The plurality of second auxiliary connection patterns 114b may be formed (or configured) together with the plurality of second connection patterns 112b, and thus, their descriptions are omitted.

The plurality of second auxiliary connection patterns 114b may increase a coupling force between the vibration generating part 110 and the third connection member 118C. Accordingly, the third connection member 118C may be additionally connected (or coupled) to the plurality of second auxiliary connection patterns 114b, and thus, stripping of the third connection member 118C connected (or coupled) to the vibration generating part 110 may be prevented.

The plurality of third auxiliary connection patterns 114c may be disposed (or configured) at each of the third vibration layer 111-3 and the fifth vibration layer 111-5 corresponding to a region between each of the third electrode layer 113-3 and the fifth electrode layer 113-5 and the fourth connection member 118D. For example, the plurality of third auxiliary connection patterns 114c may be disposed (or configured) in an island shape at the connection region CR of each of the third vibration layer 111-3 and the fourth vibration layer 111-4 so as to be electrically disconnected (or insulated) from each of the third electrode layer 113-3 and the fifth electrode layer 113-5. The plurality of third auxiliary connection patterns 114c may be disposed (or configured) at the connection region CR of each of the third vibration layer 111-3 and the fifth vibration layer 111-5 so as to be adjacent to the second dummy pattern 113d2 disposed at each of the third electrode layer 113-3 and the fifth electrode layer 113-5. The plurality of third auxiliary connection patterns 114c may be disposed to be electrically connected to the fourth connection member 118D and parallel to each of the plurality of third connection patterns 112c. The plurality of third auxiliary connection patterns 114c may be formed (or configured) together with the plurality of third connection patterns 112c, and thus, their descriptions are omitted.

The plurality of third auxiliary connection patterns 114c may increase a coupling force between the vibration generating part 110 and the fourth connection member 118D. Accordingly, the fourth connection member 118D may be additionally connected (or coupled) to the plurality of third auxiliary connection patterns 114c, and thus, stripping of the fourth connection member 118D connected (or coupled) to the vibration generating part 110 may be prevented.

The edge portion (or periphery portion) of each of the first to fourth vibration layers 111-1 to 111-4 may be additionally poled by a certain voltage applied to the first to fourth dummy patterns 113d1, 113d2, 113d3, and 113d4 and the first to third electrode connection lines 113L1, 113L2, and 113L3 through the third connection member 118C and the fourth connection member 118D from the outside in a constant temperature atmosphere or a temperature atmosphere which is changed from a high temperature to a room temperature, but examples of the present disclosure are not limited thereto. A poling process on the edge portion (or periphery portion) of each of the first to fourth vibration layers 111-1 to 111-4 using the first to fourth dummy patterns 113d1, 113d2, 113d3, and 113d4 may be the same as a poling process using the first to fifth electrode layers 113-1 to 113-5, and thus, its description is omitted.

Based on poling of the vibration layers 111-1 to 111-4 using the first to fifth electrode layers 113-1 to 113-5 and the first to fourth dummy patterns 113d1, 113d2, 113d3, and 113d4, a displacement characteristic (or vibration characteristic) deviation between a region, corresponding to the first to fifth electrode layers 113-1 to 113-5, of the vibration layers 111-1 to 111-4 and a region corresponding to the first to fourth dummy patterns 113dl, 113d2, 113d3, and 113d4 may be minimized, and a deviation of a voltage characteristic and/or a resonance frequency needed for a displacement (or vibration) may be minimized.

According to an example of the present disclosure, each of the first to fourth dummy patterns 113d1, 113d2, 113d3, and 113d4 disposed at each of the first to fifth electrode layers 113-1 to 113-5 may maintain a ground voltage or the same voltage so as to prevent the accumulation of electric charges when the vibration generating part 110 is displaced (or vibrated), after a poling process. For example, each of the third connection member 118C and the fourth connection member 118D may be electrically connected to the ground voltage, and thus, the first to fourth dummy patterns 113d1, 113d2, 113d3, and 113d4 disposed at each of the first to fifth electrode layers 113-1 to 113-5 may maintain the ground voltage.

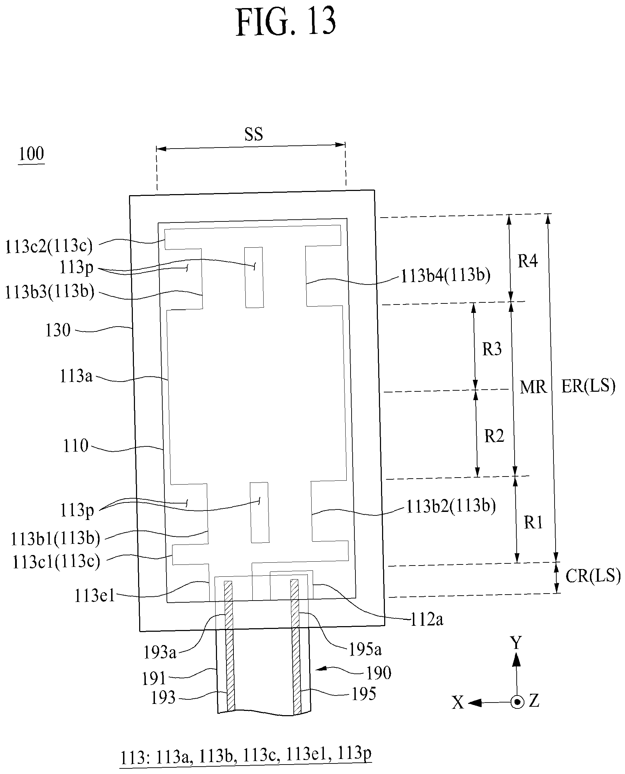

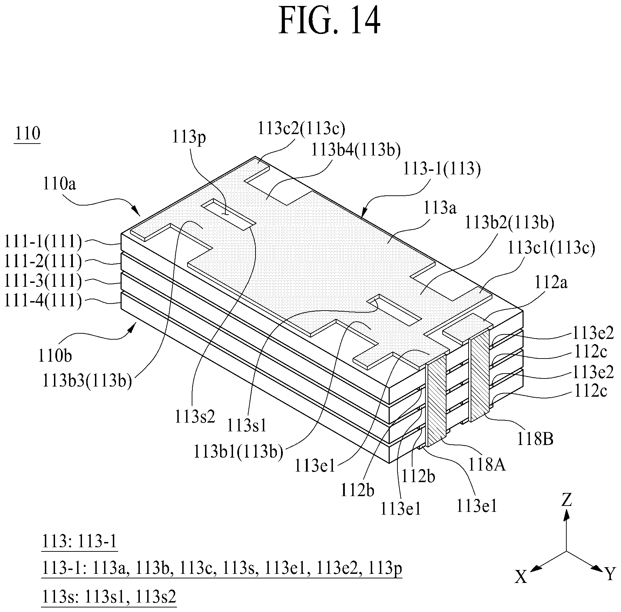

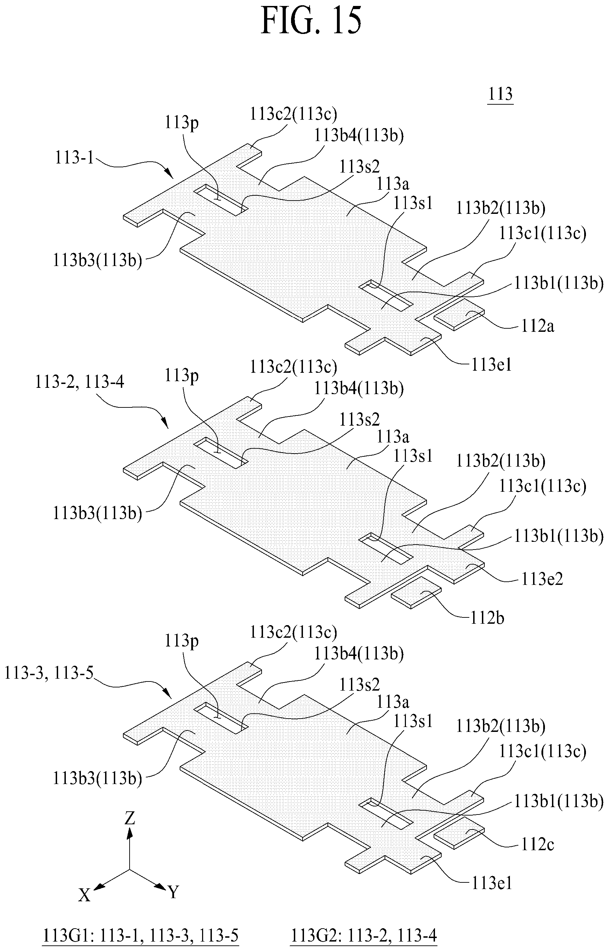

FIG. 13 illustrates a vibration apparatus according to another example (or a fourth example) of the present disclosure. FIG. 14 illustrates a vibration generating part illustrated in FIG. 13 according to an example of the present disclosure. FIG. 15 illustrates an electrode part illustrated in FIGs. 13 and 14 according to an example of the present disclosure. FIGs. 13 to 15 illustrate an example where a pattern electrode is additionally configured at the electrode part of the vibration apparatus described above with reference to FIGs. 1 to 7. Hereinafter, in describing the vibration apparatus 100 according to the fourth example of the present disclosure, elements differing from the elements of the vibration apparatus 100 according to the first example of the present disclosure will be mainly described. The descriptions of the vibration apparatus 100 described above with reference to FIGs. 1 to 7 may be included in descriptions of the vibration apparatus 100 illustrated in FIGs. 13 to 15, and thus, like reference numerals refer to like elements and repeated descriptions may be omitted or will be briefly given below.

With reference to FIGs. 13 to 15, in the vibration generating part 110 of the vibration apparatus 100 according to the fourth example of the present disclosure, an electrode part 113 may further include a pattern electrode (or a pattern line electrode) 113c. For example, each of first to fifth electrode layers 113-1 to 113-5 of the electrode part 113 may further include a pattern electrode 113c.

In each of first to fifth electrode layers 113-1 to 113-5, the pattern electrode 113c may further include first and second pattern electrodes 113c1 and 113c2.

In each of first to fifth electrode layers 113-1 to 113-5, the first pattern electrode (or a first pattern line electrode) 113c1 may be disposed (or configured) to be electrically connected to first and second sub-electrodes 113b1 and 113b2. The first pattern electrode 113c1 may be disposed at an electrode region ER, which is adjacent to a connection region CR, of a vibration generating part 110 or a vibration part 111. For example, the first pattern electrode 113c1 may be disposed (or configured) at the electrode region ER between the first and second sub-electrodes 113b1 and 113b2 and the connection region CR. For example, the first pattern electrode 113c1 may be disposed (or configured) at a first region R1 of the electrode region ER in parallel with a main electrode 113a with the first and second sub-electrodes 113b1 and 113b2 therebetween.

In each of first to fifth electrode layers 113-1 to 113-5, the first pattern electrode 113c1 may be disposed (or configured) to be connected to an end of each of the first and second sub-electrodes 113b1 and 113b2 in common. For example, the first pattern electrode 113c1 may be disposed (or configured) to intersect with (or cross) each of the first and second sub-electrodes 113b1 and 113b2 and to be connected to the end of each of the first and second sub-electrodes 113b1 and 113b2 in common. Accordingly, in each of first to fifth electrode layers 113-1 to 113-5, the first and second sub-electrodes 113b1 and 113b2 may be disposed (or configured) between the main electrode 113a and the first pattern electrode 113c1.

The first extension pattern 113e1 disposed (or configured) at the electrode layers 113-1, 113-3, and 113-5 included in a first group 113G1 among the first to fifth electrode layers 113-1 to 113-5 may extend toward the connection region CR from one side of the first pattern electrode 113c1 corresponding to an extension direction of the first sub-electrode 113b1, but examples of the present disclosure are not limited thereto. Except for that the first extension pattern 113e1 extends from the first pattern electrode 113c1, the first extension pattern 113e1 may be the same or substantially a same as the first extension pattern 113e1 described above with reference to FIGs. 1 to 7, and thus, its description is omitted.

In each of first to fifth electrode layers 113-1 to 113-5, the second pattern electrode (or a second pattern line electrode) 113c2 may be disposed (or configured) to be electrically connected to third and fourth sub-electrodes 113b3 and 113b4. The second pattern electrode 113c2 may be disposed at the electrode region ER, which is adjacent to third and fourth sub-electrodes 113b3 and 113b4 among the electrode region ER of the vibration generating part 110 or the vibration part 111. For example, the second pattern electrode 113c2 may be disposed (or configured) at a fourth region R4 of the electrode region ER in parallel with a main electrode 113a with the third and fourth sub-electrodes 113b3 and 113b4 therebetween.

In each of first to fifth electrode layers 113-1 to 113-5, the second pattern electrode 113c2 may be disposed (or configured) to be connected to an end of each of the third and fourth sub-electrodes 113b3 and 113b4 in common. For example, the second pattern electrode 113c2 may be disposed (or configured) to intersect with each of the third and fourth sub-electrodes 113b3 and 113b4 and to be connected to the end of each of the third and fourth sub-electrodes 113b3 and 113b4 in common. Accordingly, in each of first to fifth electrode layers 113-1 to 113-5, the third and fourth sub-electrodes 113b3 and 113b4 may be disposed (or configured) between the main electrode 113a and the second pattern electrode 113c2.

The second extension pattern 113e2 disposed (or configured) at the electrode layers 113-2 and 113-4 included in a second group 113G2 among the first to fifth electrode layers 113-1 to 113-5 may extend toward the connection region CR from one side of the second pattern electrode 113c2 corresponding to an extension direction of the second sub-electrode 113b2, but examples of the present disclosure are not limited thereto. Except for that the second extension pattern 113e2 extends from the second pattern electrode 113c2, the second extension pattern 113e2 may be the same or substantially a same as the second extension pattern 113e2 described above with reference to FIGs. 1 to 7, and thus, its description is omitted.

The vibration generating part 110 or the electrode part 113 according to an example of the present disclosure may include a patterning region 113p which is disposed (or configured) at a peripheral region of each of the main electrode 113a and the sub-electrode 113b of each of the first to fifth electrode layers 113-1 to 113-5. Each of the first to fifth electrode layers 113-1 to 113-5 may include a patterning region 113p which is disposed (or configured) at a peripheral region of the sub-electrode 113b. For example, the patterning region 113p may be disposed (or configured) at each of an outer region of each of the first to fourth sub-electrodes 113b1, 113d2, 113d3, and 113b4, a region between the first and second sub-electrodes 113b1 and 113b2, and a region between the third and fourth sub-electrodes 113b3, 113d2, 113d3, and 113b4.

According to an example of the present disclosure, a size of the main electrode 113a may be greater than a total size of the sub-electrode 113b and the pattern electrode 113c. For example, a ratio of a size of the main electrode 113a to a total size of the sub-electrode 113b and the pattern electrode 113c may be 10:8 to 10:2.

The vibration apparatus 100 according to a fourth example of the present disclosure may have the same effect as the vibration apparatus 100 described above with reference to FIGs. 1 to 7 and may further include the first and second pattern electrodes 113c1 and 113c2, and thus, a sound pressure level characteristic of a sound and/or a sound characteristic of a high-pitched sound band may be more enhanced by a vibration of an edge portion (or a periphery portion) adjacent to a short side of a vibration layer.

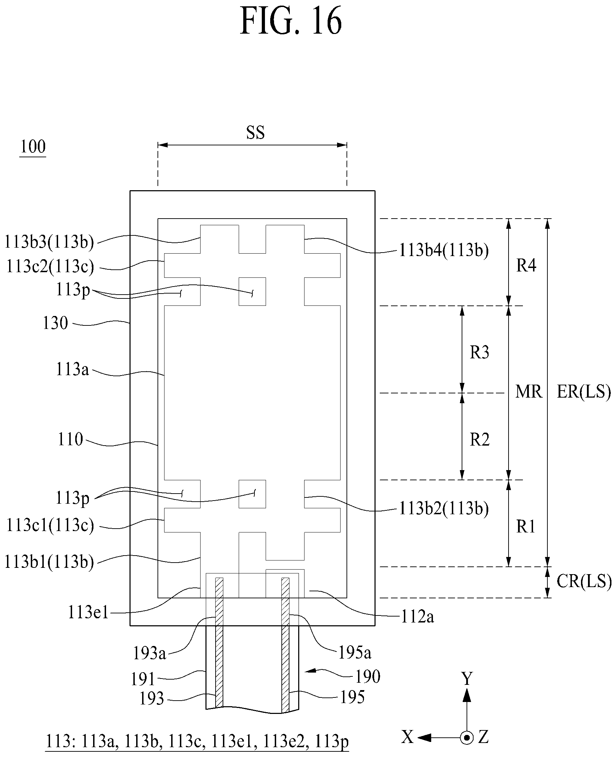

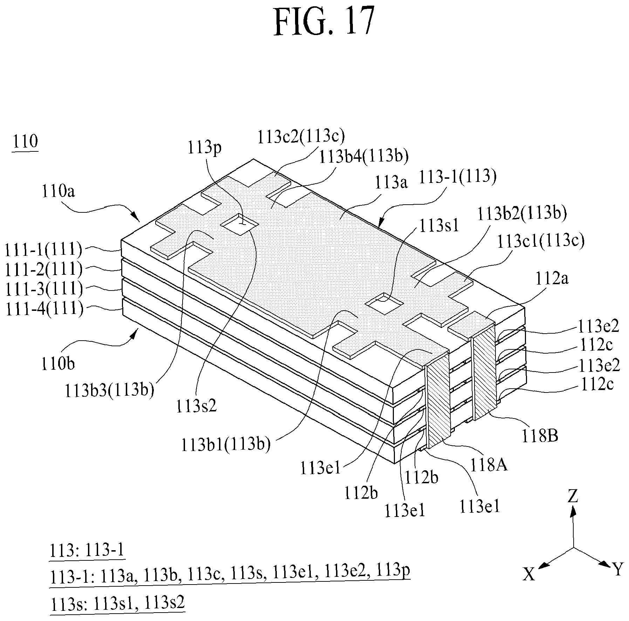

FIG. 16 illustrates a vibration apparatus according to another example (or a fifth example) of the present disclosure. FIG. 17 illustrates a vibration generating part illustrated in FIG. 16 according to an example of the present disclosure. FIGs. 16 and 17 illustrate an example implemented by changing a position of the pattern electrode in the vibration apparatus described above with reference to FIGs. 13 to 15. Hereinafter, in describing the vibration apparatus 100 according to the fifth example of the present disclosure, elements differing from the elements of the vibration apparatus 100 according to the fourth example of the present disclosure will be mainly described. In the descriptions of the vibration apparatus 100 described above with reference to FIGs. 1 to 7 and 14 to 15, the other description except the description of the position of the pattern electrode may be included in the descriptions of the vibration apparatus 100 illustrated in FIGs. 16 and 17, and thus, like reference numerals refer to like elements and repeated descriptions thereof are omitted.

With reference to FIGs. 16 and 17, in the vibration generating part 110 of the vibration apparatus 100 according to the fifth example of the present disclosure, each of first and second pattern electrodes 113c1 and 113c2 may be disposed (or configured) to be electrically connected to a sub-electrode 113b and intersect with the sub-electrode 113b.

The first pattern electrode 113c1 may be disposed (or configured) to be electrically (in common) connected to first and second sub-electrodes 113b1 and 113b2 and intersect with each of the first and second sub-electrodes 113b 1 and 113b2. For example, the first pattern electrode 113c1 may be disposed (or configured) to intersect with a center portion of each of the first and second sub-electrodes 113b1 and 113b2. For example, the first pattern electrode 113c1 may be disposed (or configured) between an end of each of the first and second sub-electrodes 113b1 and 113b2 and a main electrode 113a. For example, the first pattern electrode 113c1 may be disposed (or configured) at a middle region between an end of each of the first and second sub-electrodes 113b1 and 113b2 and the main electrode 113a.

The second pattern electrode 113c2 may be disposed (or configured) to be electrically (in common) connected to third and fourth sub-electrodes 113b3 and 113b4 and intersect with each of the third and fourth sub-electrodes 113b3 and 113b4. For example, the second pattern electrode 113c2 may be disposed (or configured) to intersect with a center portion of each of the third and fourth sub-electrodes 113b3 and 113b4. For example, the second pattern electrode 113c2 may be disposed (or configured) between an end of each of the third and fourth sub-electrodes 113b3 and 113b4 and the main electrode 113a. For example, the second pattern electrode 113c2 may be disposed (or configured) at a middle region between an end of each of the third and fourth sub-electrodes 113b3 and 113b4 and the main electrode 113a.

According to an example of the present disclosure, a size of the main electrode 113a may be greater than a total size of the sub-electrode 113b and the pattern electrode 113c. For example, a ratio of a size of the main electrode 113a to a total size of the sub-electrode 113b and the pattern electrode 113c may be 10:8 to 10:2.

The vibration apparatus 100 according to the fifth example of the present disclosure, like the vibration apparatus 100 according to the fourth example of the present disclosure, may further include the first and second pattern electrodes 113c1 and 113c2, and thus, a sound pressure level characteristic of a sound and/or a sound characteristic of a high-pitched sound band may be more enhanced by a vibration of an edge portion (or a periphery portion) adjacent to a short side of a vibration layer.

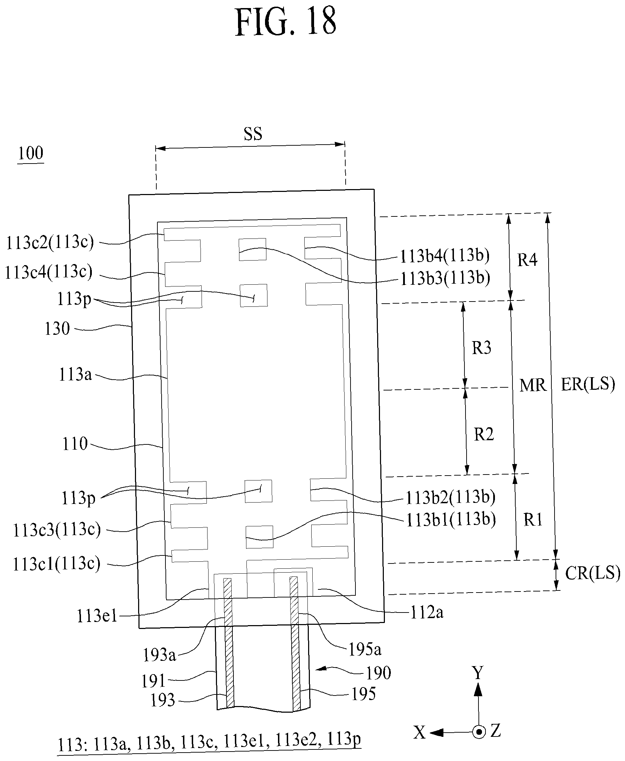

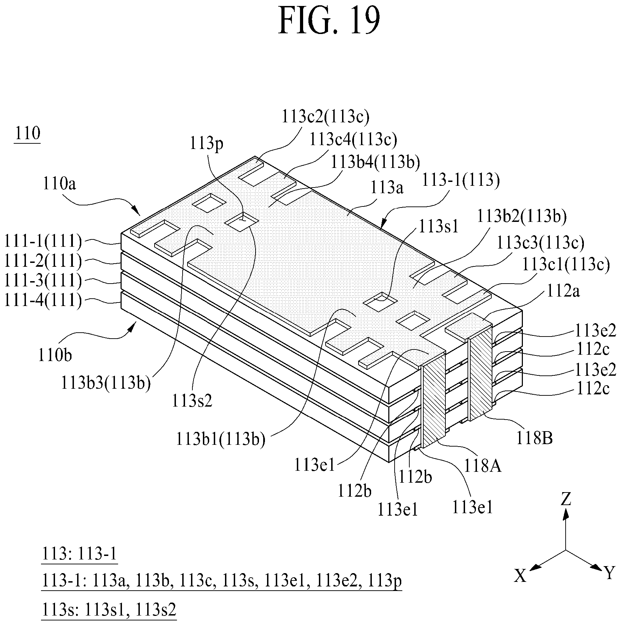

FIG. 18 illustrates a vibration apparatus according to another example (or a sixth example) of the present disclosure. FIG. 19 illustrates a vibration generating part illustrated in FIG. 18 according to an example of the present disclosure. FIGs. 18 to 19 illustrate an example where third and fourth pattern electrodes are additionally configured at the electrode part of the vibration apparatus described above with reference to FIGs. 13 to 15. Hereinafter, in describing the vibration apparatus 100 according to the sixth example of the present disclosure, elements differing from the elements of the vibration apparatus 100 according to the fourth example of the present disclosure will be mainly described. The descriptions of the vibration apparatus 100 described above with reference to FIGs. 13 to 15 may be included in descriptions of the vibration apparatus 100 illustrated in FIGs. 18 and 19, and thus, like reference numerals refer to like elements and repeated descriptions may be omitted or will be briefly given below.

With reference to FIGs. 18 and 19, in the vibration generating part 110 of the vibration apparatus 100 according to the sixth example of the present disclosure, a pattern electrode 113c of the electrode part 113 may include third and fourth pattern electrodes 113c3 and 113c4. Each of the third and fourth pattern electrodes 113c3 and 113c4 may be disposed (or configured) to be electrically connected to a sub-electrode 113b and intersect with the sub-electrode 113b.

The third pattern electrode 113c3 may be electrically (in common) connected to first and second sub-electrodes 113b1 and 113b2. The third pattern electrode 113c3 may be disposed (or configured) to intersect with each of the first and second sub-electrodes 113b1 and 113b2 between a main electrode 113a and a first pattern electrode 113c1. For example, the third pattern electrode 113c3 may be disposed (or configured) at a middle region of each of the first and second sub-electrodes 113b1 and 113b2. For example, the third pattern electrode 113c3 may be disposed (or configured) to intersect with a center portion of each of the first and second sub-electrodes 113b1 and 113b2.

The fourth pattern electrode 113c4 may be electrically (in common) connected to third and fourth sub-electrodes 113b3 and 113b4. The fourth pattern electrode 113c4 may be disposed (or configured) to intersect with each of the third and fourth sub-electrodes 113b3 and 113b4 between the main electrode 113a and a second pattern electrode 113c2. For example, the fourth pattern electrode 113c4 may be disposed (or configured) at a middle region of each of the third and fourth sub-electrodes 113b3 and 113b4. For example, the fourth pattern electrode 113c4 may be disposed (or configured) to intersect with a center portion of each of the third and fourth sub-electrodes 113b3 and 113b4.

According to an example of the present disclosure, a size of the main electrode 113a may be greater than a total size of the sub-electrode 113b and the pattern electrode 113c. For example, a ratio of a size of the main electrode 113a to a total size of the sub-electrode 113b and the pattern electrode 113c may be 10:8 to 10:2.

The vibration apparatus 100 according to the sixth example of the present disclosure, like the vibration apparatus 100 according to the fourth example of the present disclosure, may further include the third and fourth pattern electrodes 113c3 and 113c4, and thus, a sound pressure level characteristic of a sound and/or a sound characteristic of a high-pitched sound band may be more enhanced by a vibration of an edge portion (or a periphery portion) adjacent to a short side of a vibration layer.

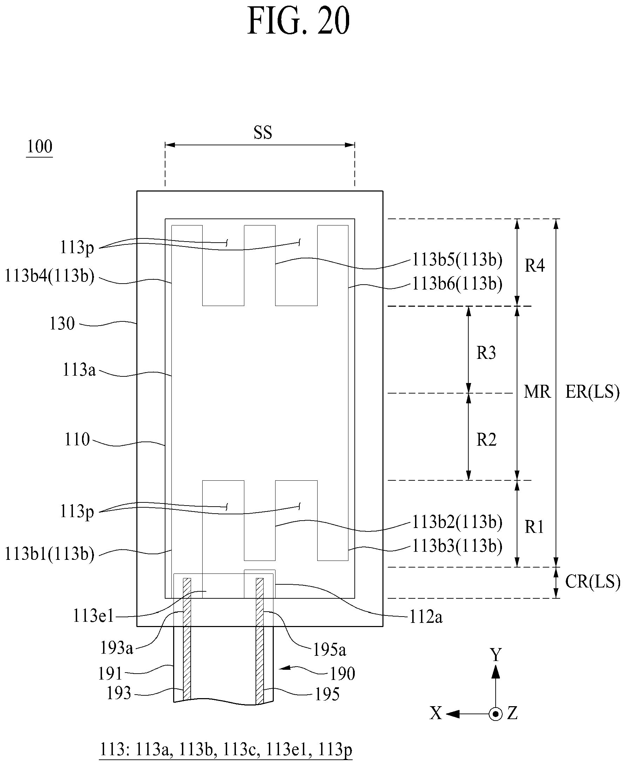

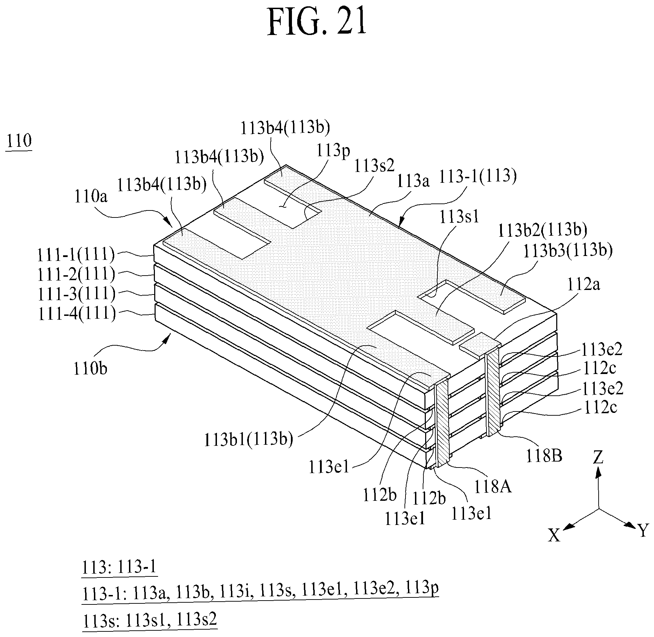

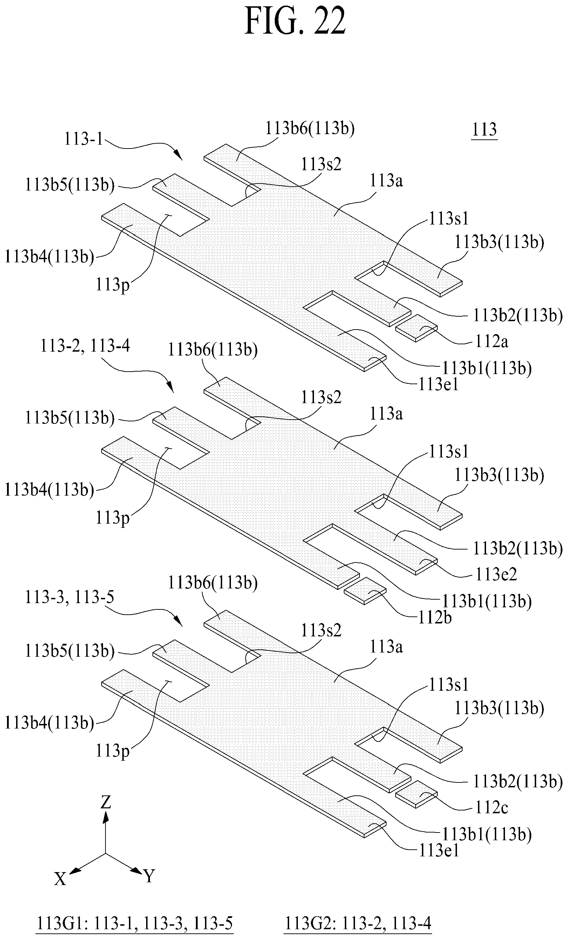

FIG. 20 illustrates a vibration apparatus according to another example (or a seventh example) of the present disclosure. FIG. 21 illustrates a vibration generating part illustrated in FIG. 20 according to an example of the present disclosure. FIG. 22 illustrates an electrode part illustrated in FIGs. 20 and 21 according to an example of the present disclosure. FIGs. 20 to 22 illustrate an example implemented by modifying the sub-electrode at the vibration apparatus described above with reference to FIGs. 1 to 7. Hereinafter, in describing the vibration apparatus 100 according to the seventh example of the present disclosure, elements differing from the elements of the vibration apparatus 100 according to the first example of the present disclosure will be mainly described. The descriptions of the vibration apparatus 100 described above with reference to FIGs. 1 to 7 may be included in descriptions of the vibration apparatus 100 illustrated in FIGs. 20 to 22, and thus, like reference numerals refer to like elements and repeated descriptions may be omitted or will be briefly given below.

With reference to FIGs. 20 to 22, in the vibration generating part 110 of the vibration apparatus 100 according to the seventh example of the present disclosure, a sub-electrode 113b of an electrode part 113 may include first to sixth sub-electrodes 113b1, 113b2, 113b3, 113b4, 113b5, and 113b6.

Except for that the sub-electrode 113b of the electrode part 113 includes the first to sixth sub-electrodes 113b1 to 113b6, the other elements of the vibration apparatus 100 according to the seventh example of the present disclosure may be the same as the vibration apparatus 100 described above with reference to FIGs. 1 to 7, and thus, its description is omitted.

Each of first to fifth electrode layers 113-1 to 113-5 or a sub-electrode 113b according to an example of the present disclosure may include first to sixth sub-electrodes 113b1, 113b2, 113b3, 113b4, 113b5, and 113b6.

The first to third sub-electrodes 113b1, 113b2, and 113b3 may be disposed in parallel at an electrode region ER adjacent to a connection region CR of a vibration generating part 110 or a vibration part 111 in corresponding vibration layers 111-1 to 111-4. The first to third sub-electrodes 113b 1, 1113b2, and 113b3 may be disposed in parallel at a first region R1 of the electrode region ER adjacent to the connection region CR in the corresponding vibration layers 111-1 to 111-4. Each of the first to third sub-electrodes 113b1, 113b2, and 113b3 may protrude (or extend) from a first side 113s1 of a main electrode 113a toward the first region R1. For example, the second sub-electrode 113b2 may be disposed (or configured) between the first sub-electrode 113b1 and the third sub-electrode 113b3.

The fourth to sixth sub-electrodes 113b4, 113b5, and 113b6 may protrude (or extend) in a direction opposite to the first to third sub-electrodes 113b1, 113b2, and 113b3 at the corresponding vibration layers 111-1 to 111-4. The fourth to sixth sub-electrodes 113b4, 113b5, and 113b6 may be disposed in parallel at a fourth region R4 of the electrode region ER of the corresponding vibration layers 111-1 to 111-4. Each of the fourth to sixth sub-electrodes 113b4, 113b5, and 113b6 may protrude (or extend) from a second side 113s2 of the main electrode 113a toward the fourth region R4. For example, the fifth sub-electrode 113b5 may be disposed (or configured) between the fourth sub-electrode 113b4 and the sixth sub-electrode 113b6.

According to an example of the present disclosure, in each of the first to fifth electrode layers 113-1 to 113-5, any one of the first to third sub-electrodes 113b1, 113b2, and 113b3 may extend (or protrude) to the connection region CR. An end (or an end surface) of one of the first to third sub-electrodes 113b 1, 113b2, and 113b3 disposed at the connection region CR may be exposed at one lateral surface (or one short side) of the vibration generating part 110 or the electrode part 113. For example, a portion which protrudes (or extends) from any one of the first to third sub-electrodes 113b1, 113b2, and 113b3 disposed at the connection region CR and is disposed at the connection region CR may be extension patterns 113e1 and 113e2.

According to an example of the present disclosure, a size of the main electrode 113a may be greater than a total size of the sub-electrode 113b. For example, a ratio of a size of the main electrode 113a to a total size of the sub-electrode 113b may be 10:8 to 10:2.

The vibration apparatus 100 according to the seventh example of the present disclosure may have the same effect as the vibration apparatus 100 according to the first example of the present disclosure.

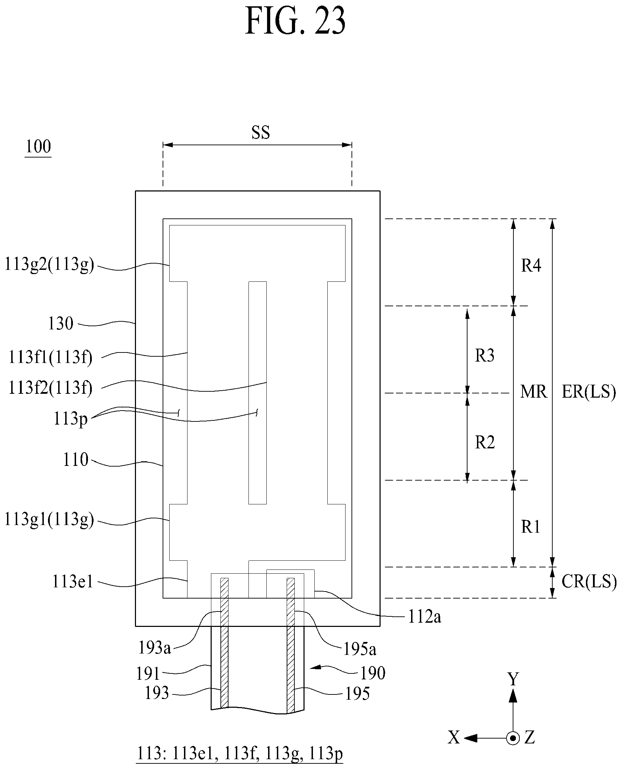

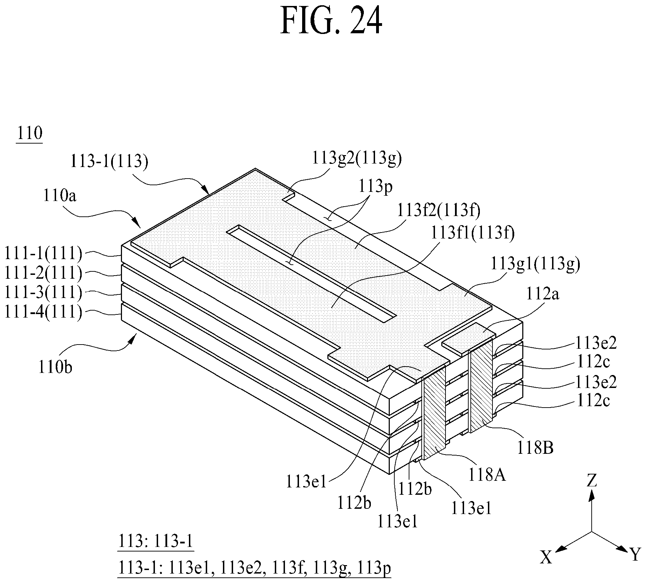

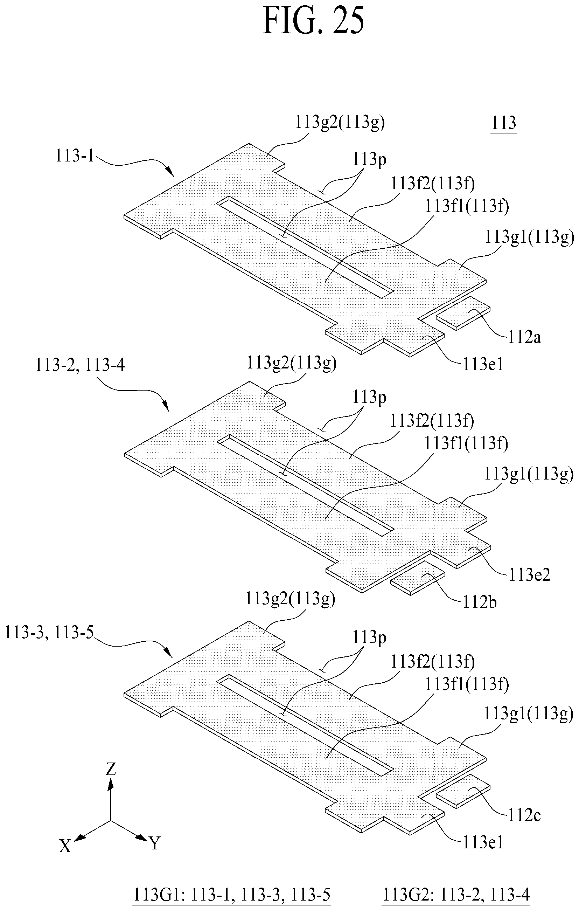

FIG. 23 illustrates a vibration apparatus according to another example (or an eighth example) of the present disclosure. FIG. 24 illustrates a vibration generating part illustrated in FIG. 23 according to an example of the present disclosure. FIG. 25 illustrates an electrode part illustrated in FIGs. 23 and 24 according to an example of the present disclosure. FIGs. 23 to 25 illustrate an example implemented by modifying the electrode part of the vibration apparatus described above with reference to FIGs. 1 to 7. In the descriptions of the vibration apparatus 100 described above with reference to FIGs. 1 to 7, the other description except the description of the electrode part may be included in the descriptions of the vibration apparatus 100 illustrated in FIGs. 23 to 25, and thus, like reference numerals refer to like elements and repeated descriptions thereof are omitted.

With reference to FIGs. 23 to 25, in the vibration generating part 110 of the vibration apparatus 100 according to the eighth example of the present disclosure, an electrode part 113 or each of first to fifth electrode layers 113-1 to 113-5 may include a main electrode 113f and a sub-electrode 113g.

In each of first to fifth electrode layers 113-1 to 113-5, the main electrode 113f may include a plurality of main electrodes 113f1 and 113f2. For example, the main electrode 113f may include first and second main electrodes 113f1 and 113f2. For example, each of the first and second main electrodes 113f1 and 113f2 may be a main line pattern or a main pattern line, but examples of the present disclosure are not limited thereto.

In each of first to fifth electrode layers 113-1 to 113-5, the first and second main electrodes 113f1 and 113f2 may be disposed (or configured) in parallel at a second region R2 and a third region R3 of an electrode region ER. The first and second main electrodes 113f1 and 113f2 may be disposed (or configured) at the second region R2 and the third region R3 of the electrode region ER to have a line shape extending along a long-side length direction of a vibration part 111. For example, one side of each of the first and second main electrodes 113f1 and 113f2 may extend up to a portion of the first region R1 of the electrode region ER, and the one side of each of the first and second main electrodes 113f1 and 113f2 may extend up to a portion of a fourth region R4 of the electrode region ER.

In each of first to fifth electrode layers 113-1 to 113-5, the first main electrode 113f1 may be disposed (or configured) adjacent to one long side (or a first long side) of the vibration part 111, and the second main electrode 113f2 may be disposed (or configured) so as to adjacent to the other long side (or a second long side) of the vibration part 111.

In each of the first to fifth electrode layers 113-1 to 113-5, the sub-electrode 113g may include a first sub-electrode 113g1 and a second sub-electrode 113g2.

In each of first to fifth electrode layers 113-1 to 113-5, the first sub-electrode 113g1 may be disposed (or configured) at the electrode region ER, which is adjacent to a connection region CR, of the vibration generating part 110 or the vibration part 111. The first sub-electrode 113g1 may be disposed (or configured) at the first region R1 of the electrode region ER and may be electrically (or in common) connected to one side of each of the first and second main electrodes 113f1 and 113f2. For example, the first sub-electrode 113g1 may have a size (or area) which is smaller than the first region R1 of the electrode region ER, but examples of the present disclosure are not limited thereto.

In each of first to fifth electrode layers 113-1 to 113-5, the second sub-electrode 113g2 may be disposed (or configured) at the fourth region R4 of the electrode region ER in parallel with the first sub-electrode 113g1 with the main electrode 113f therebetween. The second sub-electrode 113g2 may be disposed (or configured) in the fourth region R4 of the electrode region ER and may be electrically (or in common) connected to the other side of each of the first and second main electrodes 113f1 and 113f2. For example, the second sub-electrode 113g2 may have a size (or area) which is smaller than the fourth region R4 of the electrode region ER, but examples of the present disclosure are not limited thereto.

In each of first to fifth electrode layers 113-1 to 113-5, the first and second main electrodes 113f1 and 113f2 may be disposed (or configured) in parallel between the first sub-electrode 113g1 and the second sub-electrode 113g2. Therefore, in each of the first to fifth electrode layers 113-1 to 113-5, the first and second main electrodes 113f1 and 113f2 may be electrically connected to the first and second sub-electrodes 113g1 and 113g2 in the same plane. For example, each of the first to fifth electrode layers 113-1 to 113-5 may two-dimensionally have an "II"-shape, based on the first and second main electrodes 113f1 and 113f2 and the first and second sub-electrodes 113g1 and 113g2. For example, the main electrode and the sub-electrode may have a "II"-shape in plan.

According to an example of the present disclosure, a size of the main electrode 113f may be greater than a total size of the sub-electrode 113g. For example, a ratio of a size of the main electrode 113f to a total size of the sub-electrode 113g may be 10:8 to 10:2.

The first extension pattern 113e1 disposed (or configured) at the electrode layers 113-1, 113-3, and 113-5 included in a first group 113G1 among the first to fifth electrode layers 113-1 to 113-5 may extend toward the connection region CR from one side of the first sub-electrodes 113g1 corresponding to an extension direction of the first main electrode 113f1, but examples of the present disclosure are not limited thereto. Except for that the first extension pattern 113e1 extends from the first sub-electrodes 113g1, the first extension pattern 113e1 may be the same or substantially a same as the first extension pattern 113e1 described above with reference to FIGs. 1 to 7, and thus, its description is omitted.

The second extension pattern 113e2 disposed (or configured) at the electrode layers 113-2 and 113-4 included in a second group 113G2 among the first to fifth electrode layers 113-1 to 113-5 may extend toward the connection region CR from the other side of the first sub-electrodes 113g1 corresponding to an extension direction of the second main electrode 113f2, but examples of the present disclosure are not limited thereto. Except for that the second extension pattern 113e2 extends from the first sub-electrodes 113g1, the second extension pattern 113e2 may be the same or substantially a same as the second extension pattern 113e2 described above with reference to FIGs. 1 to 7, and thus, its description is omitted.

The vibration generating part 110 or the electrode part 113 according to an example of the present disclosure may include a patterning region 113p which is disposed (or configured) at a peripheral region of each of the first and second main electrodes 113f1 and 113f2 and the first and second sub-electrodes 113f1 and 113g2 of each of the first to fifth electrode layers 113-1 to 113-5. Each of the first to fifth electrode layers 113-1 to 113-5 may include a patterning region 113p which is disposed (or configured) at a peripheral region of the plurality of main electrodes 113f1 and 113f2. For example, the patterning region 113p may be disposed (or configured) at each of an outer region of each of the plurality of main electrodes 113f1 and 113f2 and a region between the plurality of main electrodes 113f1 and 113f2.

The vibration apparatus 100 according to the eighth example of the present disclosure may have the same effect as that of the vibration apparatus 100 described above with reference to FIGs. 1 to 7, and a vibration force (or displacement width or driving width) of an edge portion (or a periphery portion) adjacent to a short side of a vibration layer may be increased by the first and second sub-electrodes 113g1 and 113g2, and thus, a sound pressure level characteristic of a sound and/or a sound characteristic of a high-pitched sound band may be more enhanced.

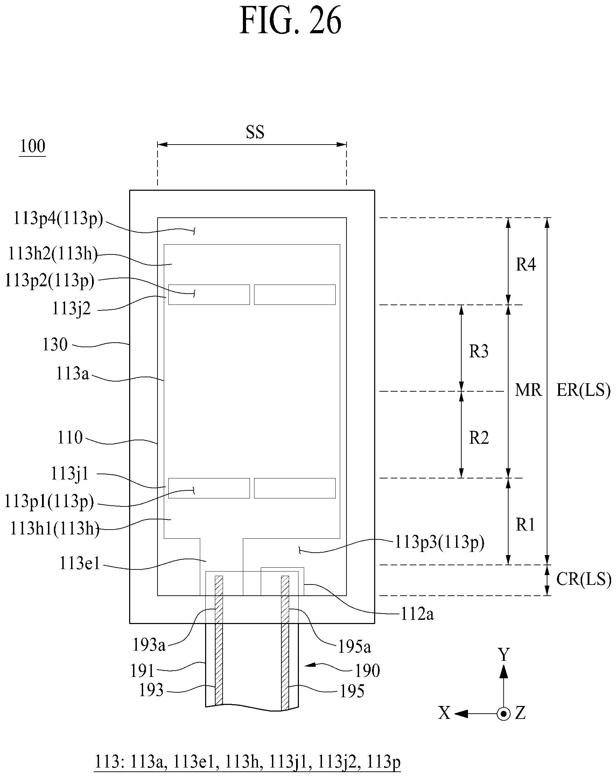

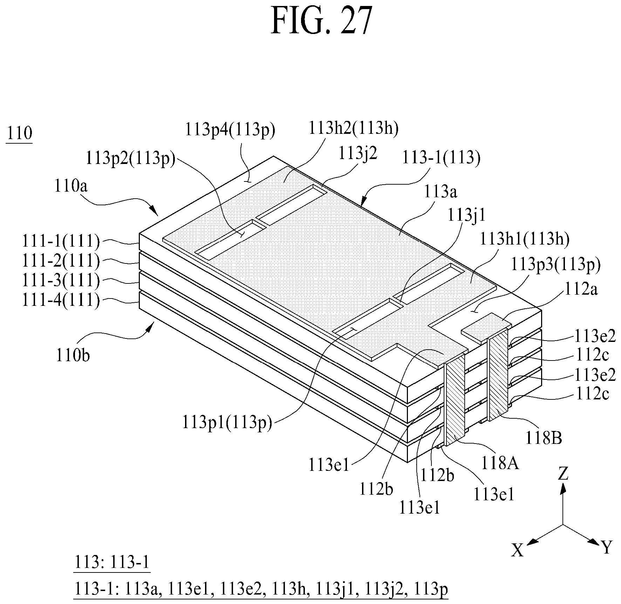

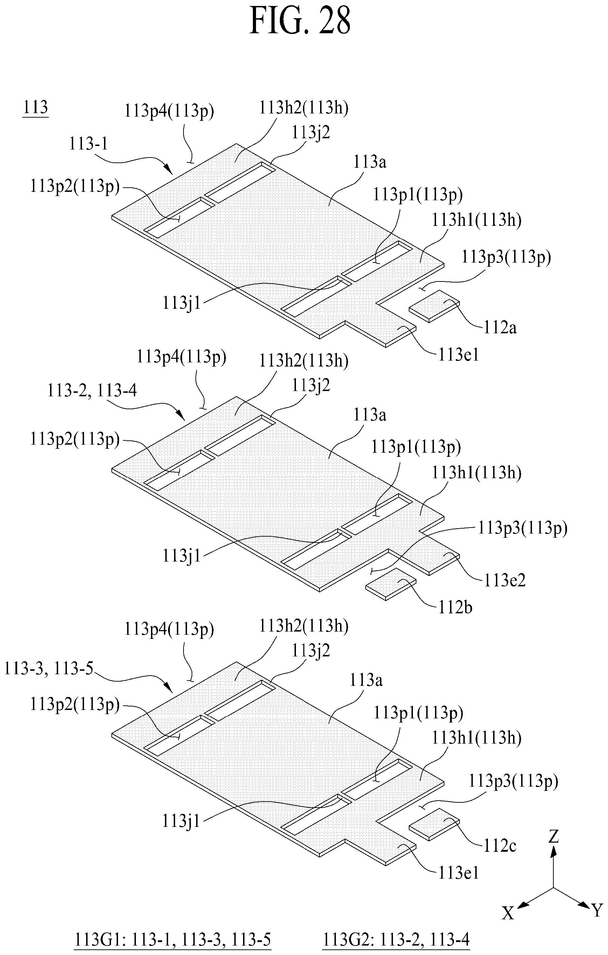

FIG. 26 illustrates a vibration apparatus according to another example (or a ninth example) of the present disclosure. FIG. 27 illustrates a vibration generating part illustrated in FIG. 26 according to an example of the present disclosure. FIG. 28 illustrates an electrode part illustrated in FIGs. 26 and 27 according to an example of the present disclosure. FIGs. 26 to 28 illustrate an example implemented by modifying the electrode part of the vibration apparatus described above with reference to FIGs. 1 to 7. In the descriptions of the vibration apparatus 100 described above with reference to FIGs. 1 to 7, the other description except the description of the electrode part may be included in the descriptions of the vibration apparatus 100 illustrated in FIGs. 26 to 28, and thus, like reference numerals refer to like elements and repeated descriptions thereof are omitted.

With reference to FIGs. 26 to 28, in the vibration generating part 110 of the vibration apparatus according to the ninth example of the present disclosure, an electrode part 113 or each of first to fifth electrode layers 113-1 to 113-5 may include a main electrode 113a, a sub-electrode 113h spaced apart from the main electrode 113a, and one or more electrode connection lines 113j 1 and 113j2 which electrically connect the main electrode 113a to the sub-electrode 113h.

In each of first to fifth electrode layers 113-1 to 113-5, the main electrode 113a may be disposed at a middle region MR among an electrode region ER of corresponding vibration layers 111-1 to 111-4. For example, the main electrode 113a may be disposed at second and third regions R2 and R3 of the electrode region ER. For example, the main electrode 113a may have a size corresponding to the second and third regions R2 and R3 of the electrode region ER. The main electrode 113a of each of the first to fifth electrode layers 113-1 to 113-5 may be a same as or substantially a same as the main electrode 113a described above with reference to FIGs. 1 to 7, and thus, repeated descriptions thereof are omitted.

In each of the first to fifth electrode layers 113-1 to 113-5, the sub-electrode 113h may include a first sub-electrode 113h1 and a second sub-electrode 113h2.

In each of the first to fifth electrode layers 113-1 to 113-5, the first sub-electrode 113h1 may be disposed (or configured) spaced apart from one side of the main electrode 113a. The first sub-electrode 113h1 may be spaced apart from and parallel to the one side of the main electrode 113a and may be disposed (or configured) at the electrode region ER, which is adjacent to a connection region CR, of a vibration generating part 110 or a vibration part 111. For example, the first sub-electrode 113h1 may be disposed (or configured) at a first region R1 of the electrode region ER adjacent to the connection region CR. The first sub-electrode 113h1 may be disposed (or configured) at the first region R1 of the electrode region ER in parallel with the main electrode 113a. For example, the first sub-electrode 113h1 may have a size (or area) which is smaller than the first region R1 of the electrode region ER, but examples of the present disclosure are not limited thereto.

In each of the first to fifth electrode layers 113-1 to 113-5, the second sub-electrode 113h2 may be disposed (or configured) spaced apart from the other side of the main electrode 113a. The second sub-electrode 113h2 may be disposed (or configured) at the electrode region ER to be spaced apart from and parallel to the other side of the main electrode 113a. For example, the second sub-electrode 113h2 may be disposed (or configured) at a fourth region R4 of the electrode region ER adjacent to the other short side of the vibration part 111. For example, the second sub-electrode 113h2 may have a size (or area) which is smaller than the fourth region R4 of the electrode region ER, but examples of the present disclosure are not limited thereto.

In each of the first to fifth electrode layers 113-1 to 113-5, one or more first electrode connection lines 113j1 may be disposed (or configured) to electrically connect the main electrode 113a to the first sub-electrode 113h1. The one or more first electrode connection lines 113j1 may be disposed (or configured) at a portion between the main electrode 113a and the first sub-electrode 113h1. For example, the one or more first electrode connection lines 113j1 may be disposed (or configured) at the portion between the main electrode 113a and the first sub-electrode 113h1 within the first region R1 of the electrode region ER. For example, the one or more first electrode connection lines 113j1 may be for an electrical connection between the main electrode 113a and the first sub-electrode 113h1, and thus, may include a line shape having a relatively thin width. Accordingly, the main electrode 113a may be electrically connected to the first sub-electrode 113h1 through the one or more first electrode connection lines 113j1.

In each of the first to fifth electrode layers 113-1 to 113-5, one or more second electrode connection lines 113j2 may be disposed (or configured) to electrically connect the main electrode 113a to the second sub-electrode 113h2. The one or more second electrode connection lines 113j2 may be disposed (or configured) at a portion between the main electrode 113a and the second sub-electrode 113h2. For example, the one or more second electrode connection lines 113j2 may be disposed (or configured) at the portion between the main electrode 113a and the second sub-electrode 113h2 within the fourth region R4 of the electrode region ER. For example, the one or more second electrode connection lines 113j2 may be for an electrical connection between the main electrode 113a and the second sub-electrode 113h2, and thus, may include a line shape having a relatively thin width. Accordingly, the main electrode 113a may be electrically connected to the second sub-electrode 113h2 through the one or more second electrode connection lines 113j2.

In each of the first to fifth electrode layers 113-1 to 113-5, the main electrode 113a may be electrically connected to the first sub-electrode 113h1 through the one or more first electrode connection lines 113j1 and may be electrically connected to the second sub-electrode 113h2 through the one or more second electrode connection lines 113j2.

The first extension pattern 113e1 disposed (or configured) at the electrode layers 113-1, 113-3, and 113-5 included in a first group 113G1 among the first to fifth electrode layers 113-1 to 113-5 may extend toward the connection region CR from one side of one lateral surface (or one short side) of the first sub-electrodes 113h1, but examples of the present disclosure are not limited thereto. Except for that the first extension pattern 113e1 extends from the first sub-electrodes 113h1, the first extension pattern 113e1 may be the same or substantially a same as the first extension pattern 113e1 described above with reference to FIGs. 1 to 7, and thus, its description is omitted.

The second extension pattern 113e2 disposed (or configured) at the electrode layers 113-2 and 113-4 included in a second group 113G2 among the first to fifth electrode layers 113-1 to 113-5 may extend toward the connection region CR from the other side of one lateral surface (or one short side) of the first sub-electrodes 113h1, but examples of the present disclosure are not limited thereto. Except for that the second extension pattern 113e2 extends from the first sub-electrodes 113h1, the second extension pattern 113e2 may be the same or substantially a same as the second extension pattern 113e2 described above with reference to FIGs. 1 to 7, and thus, its description is omitted.

The vibration generating part 110 or the electrode part 113 according to an example of the present disclosure may include a patterning region 113p which is disposed (or configured) at a peripheral region of each of the main electrode 113a, the first sub-electrode 113h1, and the second sub-electrode 113h2 of each of the first to fifth electrode layers 113-1 to 113-5. For example, each of the first to fifth electrode layers 113-1 to 113-5 may include a patterning region 113p disposed at each of a first region R1 and the fourth region R4 of the electrode region ER.

The patterning region 113p may include one or more first patterning regions 113p1, one or more second patterning regions 113p2, one or more third patterning regions 113p3, and one or more fourth patterning regions 113p4.

The one or more first patterning regions 113p1 may be disposed (or configured) between the main electrode 113a and the first sub-electrode 113h1. For example, the one or more first patterning regions 113p1 may be disposed (or configured) between the main electrode 113a and the first sub-electrode 113h1, in the first region R1 of the electrode region ER. For example, the one or more first patterning regions 113p1 may be divided into a plurality of regions by the one or more first electrode connection lines 113j1, between the main electrode 113a and the first sub-electrode 113h1.

The one or more second patterning regions 113p2 may be disposed (or configured) between the main electrode 113a and the second sub-electrode 113h2. For example, the one or more second patterning regions 113p2 may be disposed (or configured) between the main electrode 113a and the second sub-electrode 113h2, in the fourth region R4 of the electrode region ER. For example, the one or more second patterning regions 113p2 may be divided into a plurality of regions by the one or more second electrode connection lines 113j2, between the main electrode 113a and the second sub-electrode 113h2.

The one or more third patterning regions 113p3 may be disposed (or configured) between the first sub-electrode 113h1 and the connection region CR. For example, the one or more third patterning regions 113p3 may be disposed (or configured) between the first sub-electrode 113h1 and the connection region CR, in the first region R1 of the electrode region ER. For example, the one or more third patterning regions 113p1 may be divided into a plurality of regions by one of first and second extension patterns 113e1 and 113e2, between the first sub-electrode 113h1 and the connection region CR.

The one or more fourth patterning regions 113p4 may be disposed (or configured) between the second sub-electrode 113h2 and the other short side of the vibration part 110. For example, the one or more fourth patterning regions 113p4 may be disposed (or configured) between the second sub-electrode 113h2 and the other short side of the vibration part 110, in the fourth region R4 of the electrode region ER.

The vibration apparatus 100 according to the ninth example of the present disclosure may have the same effect as that of the vibration apparatus 100 described above with reference to FIGs. 1 to 7, and a vibration force (or displacement width or driving width) of an edge portion (or a periphery portion) adjacent to a short side of a vibration layer may be increased by the first and second sub-electrodes 113h1 and 113h2, and thus, a sound pressure level characteristic of a sound and/or a sound characteristic of a high-pitched sound band may be more enhanced.

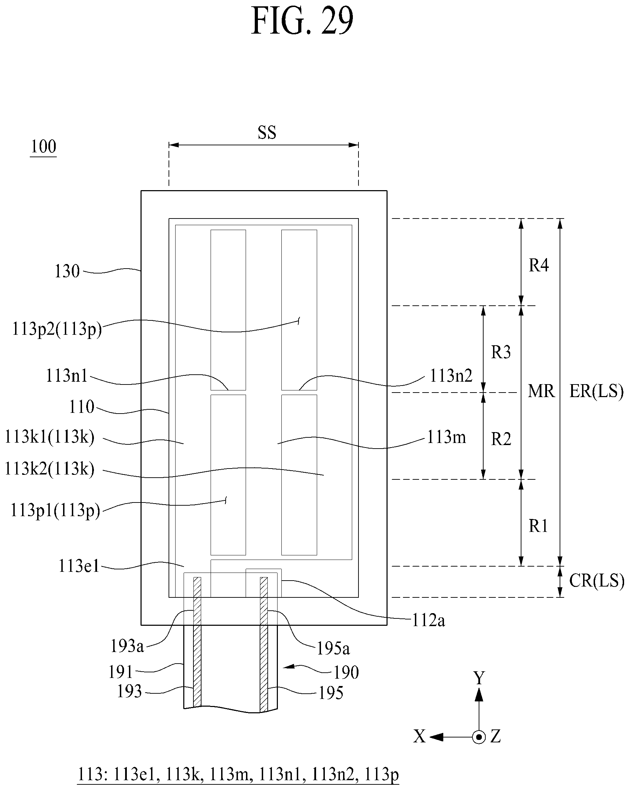

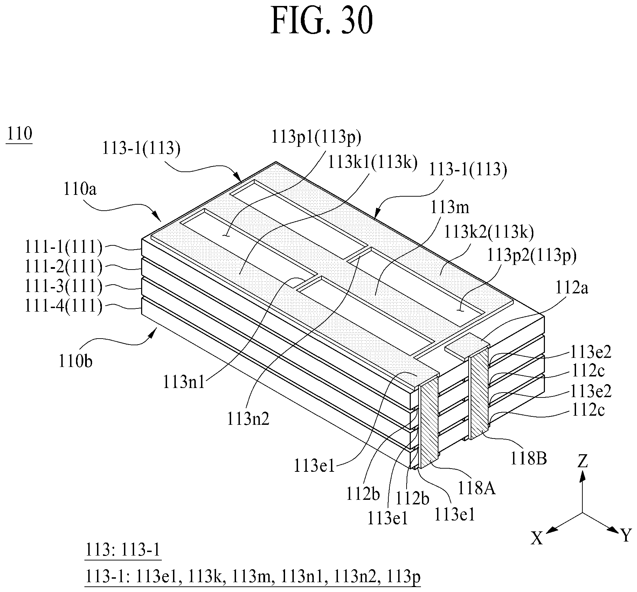

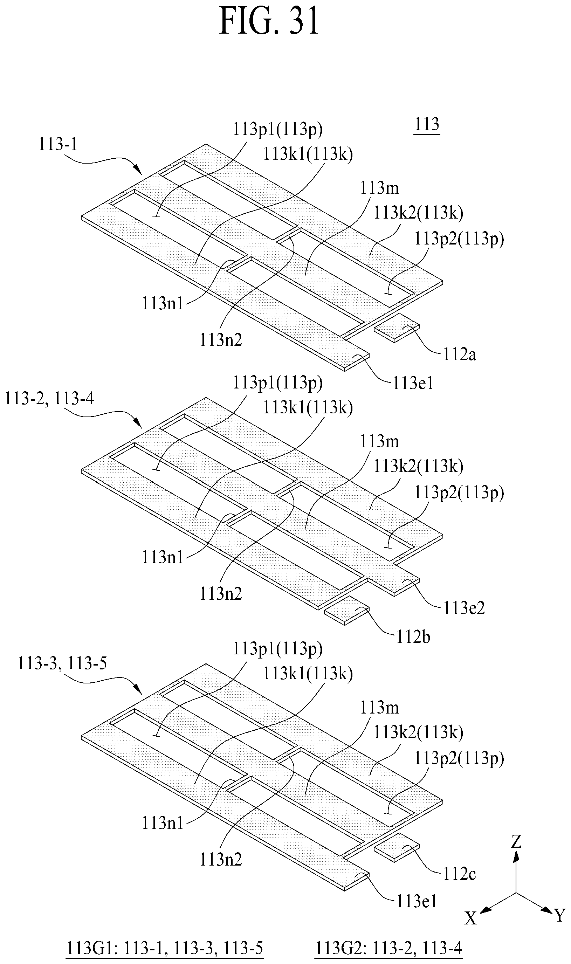

FIG. 29 illustrates a vibration apparatus according to another example (or a tenth example) of the present disclosure. FIG. 30 illustrates a vibration generating part illustrated in FIG. 29 according to an example of the present disclosure. FIG. 31 illustrates an electrode part illustrated in FIGs. 29 and 30 according to an example of the present disclosure. FIGs. 29 to 31 illustrate an example implemented by modifying the electrode part of the vibration apparatus described above with reference to FIGs. 1 to 7. In the descriptions of the vibration apparatus 100 described above with reference to FIGs. 1 to 7, the other description except the description of the electrode part may be included in the descriptions of the vibration apparatus 100 illustrated in FIGs. 29 to 31, and thus, like reference numerals refer to like elements and repeated descriptions thereof are omitted.

With reference to FIGs. 29 to 31, in the vibration generating part 110 of the vibration apparatus according to the ninth example of the present disclosure, an electrode part 113 or each of first to fifth electrode layers 113-1 to 113-5 may include a main electrode 113k, a sub-electrode 113m spaced apart from the main electrode 113k, and one or more electrode connection lines 113n1 and 113n2 which electrically connect the main electrode 113k to the sub-electrode 113m.

In each of first to fifth electrode layers 113-1 to 113-5, the main electrode 113k may include a first main electrode 113k1 and a second main electrode 113k2, which are disposed (or configured) spaced apart from each other and parallel to each other.

The first main electrode 113k1 may be disposed (or configured) at one edge portion (or a first edge portion or a first periphery portion) of an electrode region ER, which is adjacent to one long side (or a first long side), of a vibration generating part 110 or a vibration part 111. For example, the first main electrode 113k1 may be disposed (or configured) at one edge portion (or a first edge portion or a first periphery portion) of each of first to fourth regions R1, R2, R3, and R4 of the electrode region ER. The first main electrode 113k1 may be disposed (or configured) at one edge portion (or the first periphery portion) of each of first to fourth regions R1, R2, R3, and R4 of the electrode region ER to extend in a line shape parallel to a second direction Y or a long side of the vibration part 111.

In each of first to fifth electrode layers 113-1 to 113-5, the second main electrode 113k2 may be disposed (or configured) at the other edge portion (or a second edge portion) of the electrode region ER, which is adjacent to the other long side (or a second long side), of the vibration part 111 so as to be spaced apart from and parallel to the first main electrode 113k1. For example, the second main electrode 113k2 may be disposed (or configured) at the other edge portion (or a second edge portion or a second periphery portion) of each of first to fourth regions R1, R2, R3, and R4 of the electrode region ER. The second main electrode 113k2 may be disposed (or configured) at the other edge portion (or the second periphery portion) of each of first to fourth regions R1, R2, R3, and R4 of the electrode region ER to extend in a line shape parallel to the second direction Y or the long side of the vibration part 111.

In each of first to fifth electrode layers 113-1 to 113-5, the sub-electrode 113m may be disposed (or configured) between the first main electrode 113k1 and the second main electrode 113k2 so as to be spaced apart from and parallel to the first main electrode 113k1 and the second main electrode 113k2. The sub-electrode 113m may be disposed (or configured) at a center portion of the electrode region ER in parallel with each of the first main electrode 113k1 and the second main electrode 113k2. For example, the sub-electrode 113m may be disposed (or configured) at a center portion of each of first to fourth regions R1, R2, R3, and R4 of the electrode region ER. The sub-electrode 113m may be disposed (or configured) at the center portion of each of first to fourth regions R1, R2, R3, and R4 of the electrode region ER to extend in a line shape parallel to the second direction Y or the long side of the vibration part 111.

Each of the first and second main electrodes 113k1 and 113k2 and the sub-electrode 113m may have a length parallel to the second direction Y and a width parallel to a first direction X. The first and second main electrodes 113k1 and 113k2 and the sub-electrode 113m may have a same size (or area), but examples of the present disclosure are not limited thereto. The first and second main electrodes 113k1 and 113k2 and the sub-electrode 113m may have a same length and a same width, but examples of the present disclosure are not limited thereto. For example, the sub-electrode 113m may have a size (or width) greater than the first main electrode 113k1 and the second main electrode 113k2.

According to an example of the present disclosure, a size of the main electrode 113k may be greater than a total size of the sub-electrode 113m. For example, a ratio of a size of the main electrode 113k to a total size of the sub-electrode 113m may be 10:8 to 10:2.

In each of the first to fifth electrode layers 113-1 to 113-5, one or more first electrode connection lines 113n1 may be disposed (or configured) to electrically connect the first main electrode 113k1 to the sub-electrode 113m. The one or more first electrode connection lines 113n1 may be disposed (or configured) at a portion between the first main electrode 113k1 and the sub-electrode 113m. For example, the one or more first electrode connection lines 113n1 may be for an electrical connection between the first main electrode 113k1 and the sub-electrode 113m, and thus, may include a line shape having a relatively thin width. Accordingly, the first main electrode 113k1 and the sub-electrode 113m may be electrically connected to each other through the one or more first electrode connection lines 113n1.

In each of the first to fifth electrode layers 113-1 to 113-5, one or more second electrode connection lines 113n2 may be disposed (or configured) to electrically connect the sub-electrode 113m to the second main electrode 113k2. The one or more second electrode connection lines 113n2 may be disposed (or configured) at a portion between the sub-electrode 113m and the second main electrode 113k2. For example, the one or more second electrode connection lines 113n2 may be for an electrical connection between the sub-electrode 113m to the second main electrode 113k2, and thus, may include a line shape having a relatively thin width. Accordingly, the sub-electrode 113m and the second main electrode 113k2 may be electrically connected to each other through the one or more second electrode connection lines 113n2.

In each of the first to fifth electrode layers 113-1 to 113-5, the sub-electrode 113m may be electrically connected to the first main electrode 113k1 through the one or more first electrode connection lines 113n1, and may be electrically connected to the second main electrode 113k2 through the one or more second electrode connection lines 113n2.

The first extension pattern 113e1 disposed (or configured) at the electrode layers 113-1, 113-3, and 113-5 included in a first group 113G1 among the first to fifth electrode layers 113-1 to 113-5 may extend toward the connection region CR from one lateral side (or one short side) of the first main electrode 113k1 adjacent to the connection region CR. Except for that the first extension pattern 113e1 extends from the first main electrode 113k1, the first extension pattern 113e1 may be the same or substantially a same as the first extension pattern 113e 1 described above with reference to FIGs. 1 to 7, and thus, its description is omitted.

The second extension pattern 113e2 disposed (or configured) at the electrode layers 113-2 and 113-4 included in a second group 113G2 among the first to fifth electrode layers 113-1 to 113-5 may extend toward the connection region CR from one lateral side (or one short side) of the sub-electrode 113m adjacent to the connection region CR. Except for that the second extension pattern 113e2 extends from the sub-electrode 113m, the second extension pattern 113e2 may be the same or substantially a same as the second extension pattern 113e2 described above with reference to FIGs. 1 to 7, and thus, its description is omitted.

The vibration generating part 110 or the electrode part 113 according to an example of the present disclosure may include a patterning region 113p which is disposed (or configured) at a region between the first main electrode 113k1, the second main electrode 113k2, and the sub-electrode 113m of each of the first to fifth electrode layers 113-1 to 113-5.

The patterning region 113p may include one or more first patterning regions 113p1 and one or more second patterning regions 113p2.

The one or more first patterning regions 113p1 may be disposed (or configured) between the first main electrode 113k1 and the sub-electrode 113m. For example, the one or more first patterning regions 113p1 may be a region between the first main electrode 113k1 and the sub-electrode 113m. For example, the one or more first patterning regions 113p1 may be divided into a plurality of regions by the one or more first electrode connection lines 113n1, between the first main electrode 113k1 and the sub-electrode 113m.

The one or more second patterning regions 113p2 may be disposed (or configured) between the sub-electrode 113m and the second main electrode 113k2. For example, the one or more second patterning regions 113p2 may be a region between the sub-electrode 113m and the second main electrode 113k2. For example, the one or more second patterning regions 113p2 may be divided into a plurality of regions by the one or more second electrode connection lines 113n2, between the sub-electrode 113m and the second main electrode 113k2.

The vibration apparatus 100 according to the tenth example of the present disclosure may have the same effect as the vibration apparatus 100 described above with reference to FIGs. 1 to 7.

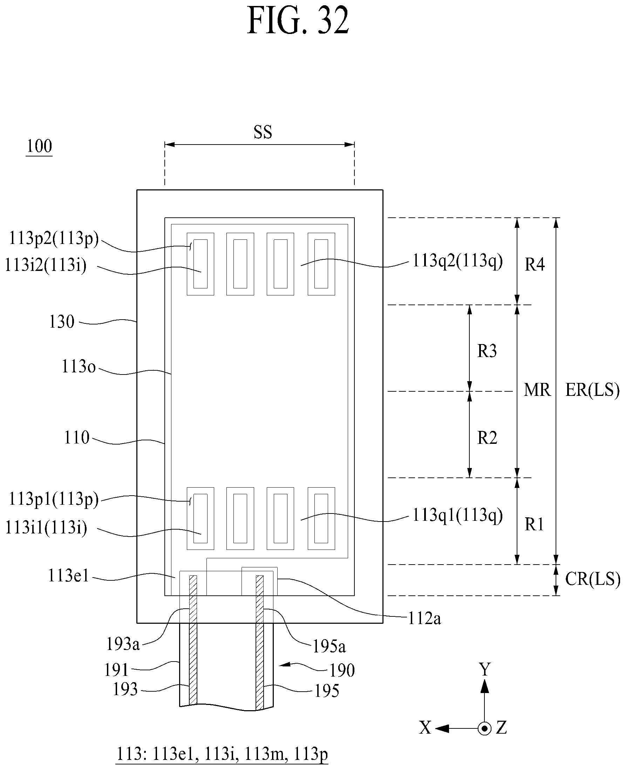

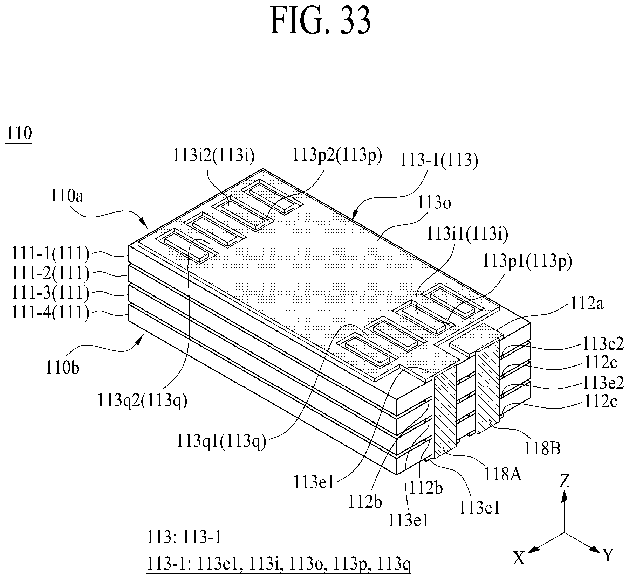

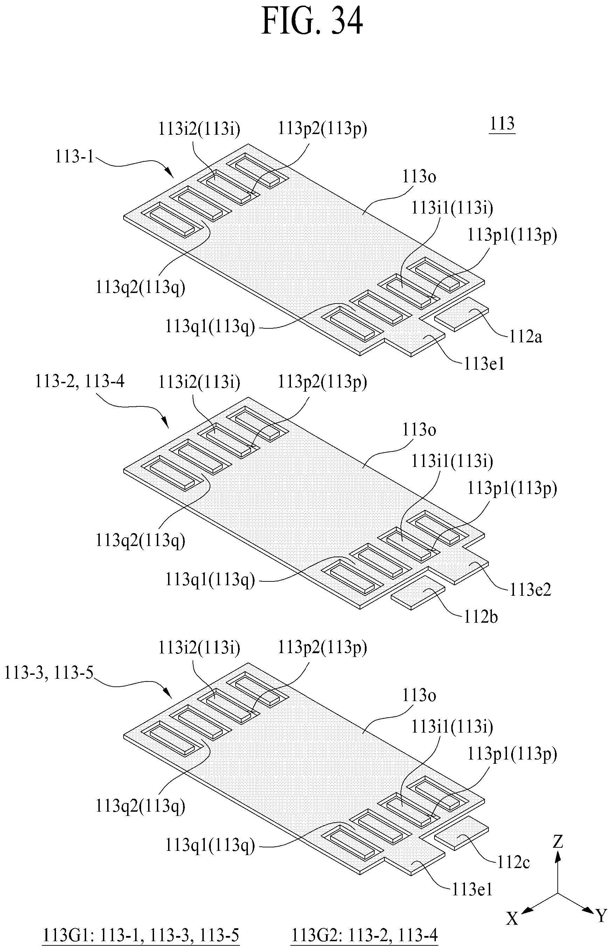

FIG. 32 illustrates a vibration apparatus according to another example (or an eleventh example) of the present disclosure. FIG. 33 illustrates a vibration generating part illustrated in FIG. 32 according to an example of the present disclosure. FIG. 34 illustrates an electrode part illustrated in FIGs. 32 and 33 according to an example of the present disclosure. FIGs. 32 to 34 illustrate an example implemented by modifying the electrode part of the vibration apparatus described above with reference to FIGs. 1 to 7. In the descriptions of the vibration apparatus 100 described above with reference to FIGs. 1 to 7, the other description except the description of the electrode part may be included in the descriptions of the vibration apparatus 100 illustrated in FIGs. 32 to 34, and thus, like reference numerals refer to like elements and repeated descriptions thereof are omitted.

With reference to FIGs. 32 to 34, in the vibration generating part 110 of the vibration apparatus 100 according to the eleventh example of the present disclosure, an electrode part 113 or each of first to fifth electrode layers 113-1 to 113-5 may include a main electrode 113o, a patterning region 113p, and a sub-electrode 113q.

In each of first to fifth electrode layers 113-1 to 113-5, the main electrode 113o may be disposed (or configured) at an electrode region ER of the vibration generating part 110 or the vibration part 111. For example, the main electrode 113o may be disposed (or configured) at all of first to fourth regions R1, R2, R3, and R4 of the electrode region ER.

The patterning region 113p may be disposed (or configured) at the main electrode 113o. For example, the patterning region 113p may be disposed (or configured) at the main electrode 113o to correspond to a peripheral region of a peripheral vibration region of a vibration part 111 based on a frequency-based vibration characteristic (or a vibration mode shape) of a vibration apparatus 100 or a vibration generating part 110. For example, the patterning region 113p may be disposed (or configured) in the main electrode 113o to correspond to an effective vibration region (or a peripheral region) of the vibration part 111.

The patterning region 113p according to an example of the present disclosure may include one or more first patterning regions 113p1 and one or more second patterning regions 113p2.

The one or more first patterning regions 113p1 may be disposed (or configured) at the main electrode 113o in the first region R1 of the electrode region ER. For example, the one or more first patterning regions 113p1 may be disposed (or configured) by patterning (or removing) a portion of the main electrode 113o in the first region R1 of the electrode region ER. For example, the one or more first patterning regions 113p1 may be a region which is configured by removing a portion of the main electrode 113o in the first region R1 of the electrode region ER, or may be a region where the main electrode 113o is not disposed at the first region R1 of the electrode region ER. For example, the one or more first patterning regions 113p1 may include a rectangular shape, but examples of the present disclosure are not limited thereto. Accordingly, in each of the first to fourth vibration layers 111-1 to 111-4, a region, corresponding to (or overlapping) the one or more first patterning regions 113p1 among the first region R1 of the electrode region ER may not be covered by the main electrode 113o and may be exposed through the one or more first patterning regions 113p1.

The patterning region 113p may include a plurality of first patterning regions 113p1 which are disposed (or configured) at the first region R1 of the electrode region ER. For example, the patterning region 113p may include four first patterning regions 113p1 which are disposed (or configured) at the main electrode 113o in the first region R1 of the electrode region ER, but examples of the present disclosure are not limited thereto. The plurality of first patterning regions 113p1 may be disposed (or configured) to have a predetermined interval along a first direction X or a short-side length direction of the vibration part 111.

The one or more second patterning regions 113p2 may be disposed (or configured) at the main electrode 113o in the fourth region R4 of the electrode region ER. For example, the one or more second patterning regions 113p2 may be disposed (or configured) by patterning (or removing) a portion of the main electrode 113o in the fourth region R4 of the electrode region ER. For example, the one or more second patterning regions 113p2 may be a region which is configured by removing a portion of the main electrode 113o in the fourth region R4 of the electrode region ER, or may be a region where the main electrode 113o is not disposed at the fourth region R4 of the electrode region ER. For example, the one or more second patterning regions 113p2 may include a rectangular shape, but examples of the present disclosure are not limited thereto. Accordingly, in each of the first to fourth vibration layers 111-1 to 111-4, a region, corresponding to (or overlapping) the one or more second patterning regions 113p2 among the fourth region R4 of the electrode region ER may not be covered by the main electrode 113o and may be exposed through the one or more second patterning regions 113p2.

The patterning region 113p may include a plurality of second patterning regions 113p2 which are disposed (or configured) at the fourth region R4 of the electrode region ER. For example, the patterning region 113p may include four second patterning regions 113p2 which are disposed (or configured) at the main electrode 113o in the fourth region R4 of the electrode region ER, but examples of the present disclosure are not limited thereto. The plurality of second patterning regions 113p2 may be disposed (or configured) to have a predetermined interval along the first direction X or the short-side length direction of the vibration part 111.

The one or more first patterning regions 113p1 and the one or more second patterning regions 113p2 may have a symmetrical structure with respect to a center portion of the main electrode 113o, but examples of the present disclosure are not limited thereto. For example, the one or more first patterning regions 113p1 and the one or more second patterning regions 113p2 may have an asymmetrical structure with respect to the center portion of the main electrode 113o, based on a frequency-based vibration characteristic (or a vibration mode shape) of the vibration apparatus 100 or the vibration generating part 110.

The sub-electrode 113q may include a first sub-electrode 113q1 and a second sub-electrode 113q2.

The first sub-electrode 113q1 may include one side region of the main electrode 113o which surrounds the one or more first patterning regions 113p1. For example, the first sub-electrode 113q1 may be disposed (or configured) at the first region R1 of an electrode region ER among the main electrode 113o and may include one side region of the main electrode 113o which surrounds the one or more first patterning regions 113p1. For example, the first sub-electrode 113q1 may two-dimensionally have an "E"-shape.

The second sub-electrode 113q2 may include the other side region of the main electrode 113o which surrounds the one or more second patterning regions 113p2. For example, the second sub-electrode 113q2 may be disposed (or configured) at the fourth region R4 of the electrode region ER among the main electrode 113o and may the other side region of the main electrode 113o which surrounds the one or more second patterning regions 113p2. For example, the second sub-electrode 113q2 may two-dimensionally have an "E"-shape.

According to another example of the present disclosure, in each of the first to fifth electrode layers 113-1 to 113-5, the main electrode 113o may be disposed (or configured) at a middle region MR of the electrode region ER. For example, the main electrode 113o may be disposed (or configured) at second and third regions R2 and R3 of the electrode region ER.

In each of the first to fifth electrode layers 113-1 to 113-5, the first sub-electrode 113q1 may include a plurality of first protrusion patterns, which protrude from one side of the main electrode 113o in the middle region MR of the electrode region ER to the first region R1 of the electrode region ER, and a first pattern electrode which is commonly connected to an end of each of the plurality of first protrusion patterns. For example, the first sub-electrode 113q1 may two-dimensionally have an "E"-shape, based on the plurality of first protrusion patterns and the first pattern electrode. For example, the one or more first patterning regions 113p1 may include a region which is surrounded by one side of the main electrode 113o, the plurality of first protrusion patterns, and the first pattern electrode.

In each of the first to fifth electrode layers 113-1 to 113-5, the second sub-electrode 113q2 may include a plurality of second protrusion patterns, which protrude from the other side of the main electrode 113o in the middle region MR of the electrode region ER to the fourth region R4 of the electrode region ER, and a second pattern electrode which is commonly connected to an end of each of the plurality of second protrusion patterns. For example, the second sub-electrode 113q2 may two-dimensionally have an "E"-shape, based on the plurality of second protrusion patterns and the second pattern electrode. For example, the one or more second patterning regions 113p2 may include a region which is surrounded by the other side of the main electrode 113o, the plurality of second protrusion patterns, and the second pattern electrode.

The first extension pattern 113e1 disposed (or configured) at the electrode layers 113-1, 113-3, and 113-5 included in a first group 113G1 among the first to fifth electrode layers 113-1 to 113-5 may extend toward the connection region CR from one side of one lateral side (or one short side) of the first sub-electrode 113q1 adjacent to the connection region CR. Except for that the first extension pattern 113e1 extends from the first sub-electrode 113q1, the first extension pattern 113e1 may be the same or substantially a same as the first extension pattern 113e1 described above with reference to FIGs. 1 to 7, and thus, its description is omitted.

The second extension pattern 113e2 disposed (or configured) at the electrode layers 113-2 and 113-4 included in a second group 113G2 among the first to fifth electrode layers 113-1 to 113-5 may extend toward the connection region CR from the other side of one lateral side (or one short side) of the first sub-electrode 113q1 adjacent to the connection region CR. Except for that the second extension pattern 113e2 extends from the first sub-electrode 113q1, the second extension pattern 113e2 may be the same or substantially a same as the second extension pattern 113e2 described above with reference to FIGs. 1 to 7, and thus, its description is omitted.

In the vibration apparatus 100 according to the eleventh example of the present disclosure, the vibration generation part 110 or the electrode part 113 may further include a dummy pattern 113i. Each of the first to fifth electrode layers 113-1 to 113-5 may further include a dummy pattern 113i.

In each of the first to fifth electrode layers 113-1 to 113-5, the dummy pattern 113i may be disposed (or configured) at the patterning region 113p to be electrically isolated (or insulated) from the main electrode 113o. The dummy pattern 113i may be disposed (or configured) in an island shape within the patterning region 113p so as to be electrically separated (or insulated) from the main electrode 113o. For example, the dummy pattern 113i may be an island pattern, a non-driving electrode, or a non-driving main electrode.

The dummy pattern 113i may be formed at the corresponding vibration layers 111-1 to 111-4 together with each of the first to fifth electrode layers 113-1 to 113-5. For example, the dummy pattern 113i may be an electrode material layer of the electrode layers 113-1 to 113-5 which intactly remains without being patterned or removed by a patterning process of each of the first to fifth electrode layers 113-1 to 113-5.

The dummy pattern 113i may minimize a space (or a gap space) between the first to fourth vibration layers 111-1 to 111-4 which are vertically stacked, thereby minimizing or preventing the damage of a vibration layer which occurs in a space or a spacer periphery between the first to fourth vibration layers 111-1 to 111-4 due to pressing of the vibration generating part 110. Also, the dummy pattern 113i may increase a mass of each of corresponding vibration layers 111-1 to 111-4. Accordingly, a natural frequency of each of the first to fourth vibration layers 111-1 to 111-4 may increase due to an increase in mass caused by the dummy pattern 113i.

The dummy pattern 113i according to an example of the present disclosure may include one or more first dummy patterns 113i1 and one or more second dummy patterns 113i2.

The one or more first dummy patterns 113i1 may be disposed (or configured) in an island shape within the one or more first patterning regions 113p1 so as to be electrically disconnected from the main electrode 113o. The one or more second dummy patterns 113i2 may be disposed (or configured) in an island shape within the one or more second patterning regions 113p2 so as to be electrically disconnected (or insulated) from the main electrode 113o.

The vibration apparatus 100 according to the eleventh example of the present disclosure may have the same effect as the vibration apparatus 100 described above with reference to FIGs. 1 to 7 and may include the dummy pattern 113i, thereby minimizing or preventing the damage of a vibration layer which occurs in a space or a spacer periphery between the first to fourth vibration layers 111-1 to 111-4.

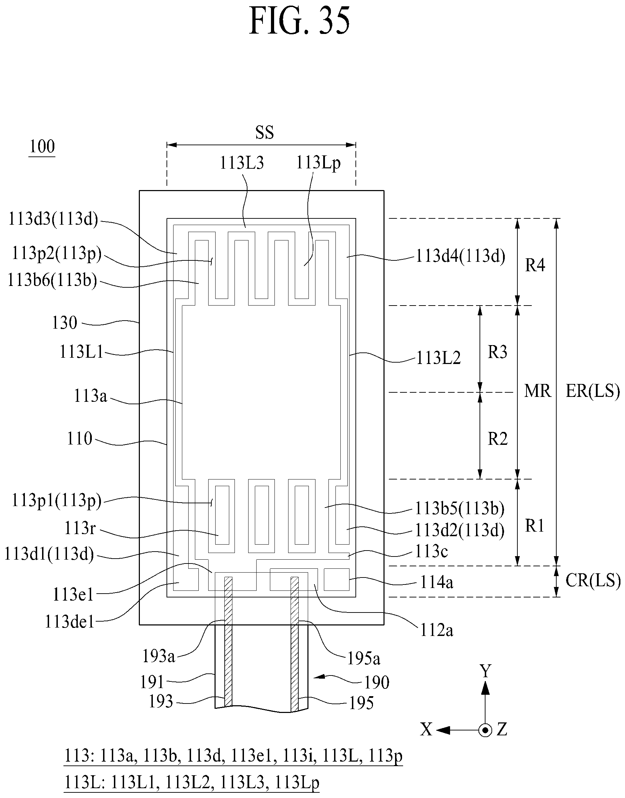

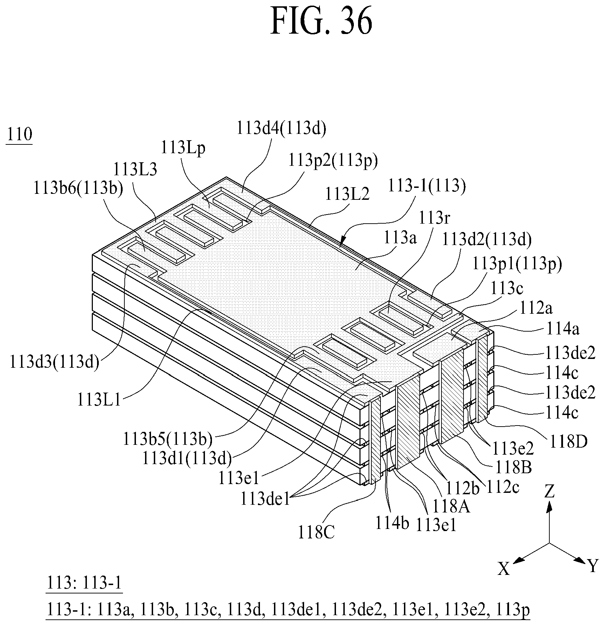

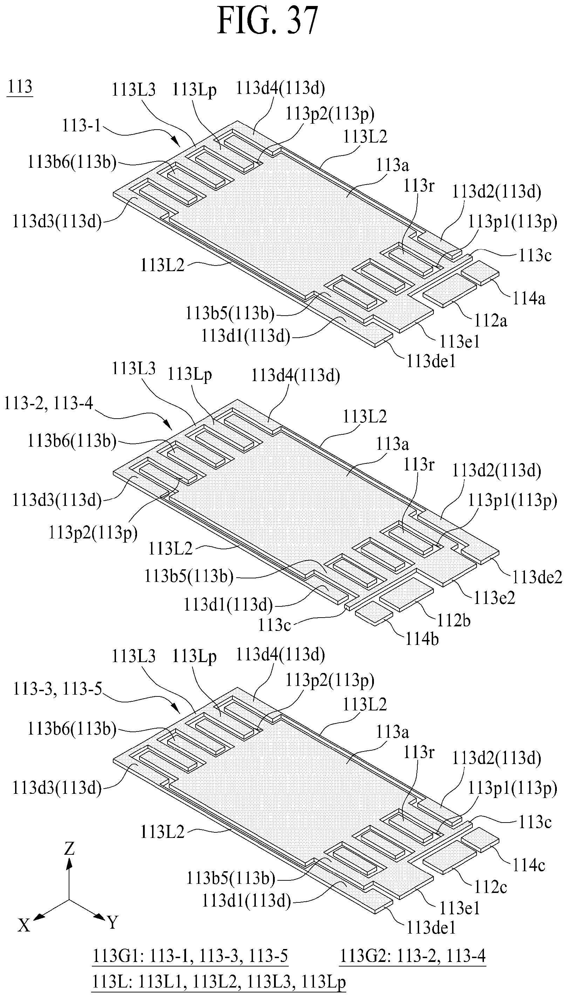

FIG. 35 illustrates a vibration apparatus according to another example (or a twelfth example) of the present disclosure. FIG. 36 illustrates a vibration generating part illustrated in FIG. 35 according to an example of the present disclosure. FIG. 37 illustrates an electrode part illustrated in FIGs. 35 and 36 according to an example of the present disclosure. FIGs. 35 to 37 illustrate an example implemented by modifying the electrode part of the vibration apparatus described above with reference to FIGs. 10 to 12. In the descriptions of the vibration apparatus 100 described above with reference to FIGs. 1 to 12, the other description except the description of the electrode part may be included in the descriptions of the vibration apparatus 100 illustrated in FIGs. 35 to 37, and thus, like reference numerals refer to like elements and repeated descriptions thereof are omitted.

With reference to FIGs. 35 to 37, in the vibration generating part 110 of the vibration apparatus 100 according to the twelfth example of the present disclosure, an electrode part 113 or each of first to fifth electrode layers 113-1 to 113-5 may include a main electrode 113a, a sub-electrode 113b, and a pattern electrode 113c.

In each of first to fifth electrode layers 113-1 to 113-5, the main electrode 113a, the sub-electrode 113b, and the pattern electrode 113c may be disposed (or configured) at a same plane as corresponding vibration layers 111-1 to 111-4 and may be electrically connected to each other.

In each of first to fifth electrode layers 113-1 to 113-5, the main electrode 113a may be disposed at a second region R2 and a third region R3 of an electrode region ER of corresponding vibration layers 111-1 to 111-4. The main electrode 113a of each of first to fifth electrode layers 113-1 to 113-5 may be substantially a same as the main electrode 113a described above with reference to FIGs. 1 to 12, and thus, repeated descriptions thereof are omitted.

The sub-electrode 113b may be disposed (or configured) at a same plane as the main electrode 113a. For example, the sub-electrode 113b may protrude (or extend) from the main electrode 113a in the same plane of the corresponding vibration layers 111-1 to 111-4.

The sub-electrode 113b may be disposed at a first region R1 and a fourth region R4 of an electrode region ER of corresponding vibration layers 111-1 to 111-4. The sub-electrode 113b may protrude (or extend) toward each of the first region R1 and the fourth region R4 from each of a first side (or a first short side) and a second side (or a second short side), which is opposite to the first side, of the main electrode 113a.

The sub-electrode 113b according to an example of the present disclosure may include a plurality of first sub-electrodes 113b5 and a plurality of second sub-electrodes 113b6. For example, the sub-electrode 113b may include four first sub-electrode 113b5 and four second sub-electrodes 113b6, but examples of the present disclosure are not limited thereto.

The plurality of (or four) first sub-electrodes 113b5 may be disposed at the electrode region ER, which is adjacent to a connection region CR, of a vibration generating part 110 or a vibration part 111 in the corresponding vibration layers 111-1 to 111-4. The plurality of first sub-electrodes 113b5 may be disposed at a first region R1 of the electrode region ER adjacent to the connection region CR in the corresponding vibration layers 111-1 to 111-4. Each of the plurality of first sub-electrodes 113b5 may protrude (or extend) toward the first region R1 of the electrode region ER from one side (or a first side) of the main electrode 113a. For example, the plurality of first sub-electrodes 113b5 may be disposed (or configured) spaced apart from and parallel to each other. One or more of the plurality of first sub-electrodes 113b5 may have different sizes (or areas).

The plurality of (or four) second sub-electrodes 113b6 may be disposed at the fourth region R4 of the electrode region ER of the corresponding vibration layers 111-1 to 111-4. Each of the plurality of second sub-electrodes 113b6 may protrude (or extend) in a direction opposite to the plurality of first sub-electrodes 113b5 in the corresponding vibration layers 111-1 to 111-4. Each of the plurality of second sub-electrodes 113b6 may protrude (or extend) toward the fourth region R4 of the electrode region ER from the other side (or a second side) of the main electrode 113a. For example, the plurality of second sub-electrodes 113b6 may be disposed (or configured) spaced apart from and parallel to each other. One or more of the plurality of second sub-electrodes 113b6 may have different sizes (or areas).

The plurality of first sub-electrodes 113b5 and the plurality of second sub-electrodes 113b6 may have a symmetrical structure with respect to one or more of a first direction X and a second direction Y passing through a center portion of the corresponding vibration layers 111-1 to 111-4. A driving signal applied to the electrode layers 113-1 to 113-5 may be uniformly applied to the corresponding vibration layers 111-1 to 111-4, based on the symmetricity of the main electrode 113a and the sub-electrode 113b.

In each of first to fifth electrode layers 113-1 to 113-5, the pattern electrode 113c may be disposed (or configured) to be connected to the plurality of first sub-electrodes 113b5. The pattern electrode 113c may be disposed at the electrode region ER adjacent to the connection region CR. For example, the pattern electrode 113c may be disposed (or configured) at the electrode region ER between the plurality of first sub-electrodes 113b5 and the connection region CR. For example, the pattern electrode 113c may be disposed (or configured) at the first region R1 of the electrode region ER so as to be parallel to the main electrode 113a with the plurality of first sub-electrodes 113b5 therebetween. The pattern electrode 113c may be disposed (or configured) to be commonly connected to an end of each of the plurality of first sub-electrodes 113b5. Accordingly, the main electrode 113a may be electrically connected to the pattern electrode 113c through the plurality of first sub-electrodes 113b5.

The first extension pattern 113e1 disposed (or configured) at the electrode layers 113-1, 113-3, and 113-5 included in a first group 113G1 among the first to fifth electrode layers 113-1 to 113-5 may extend toward the connection region CR from one side of one lateral side (or one short side) of the pattern electrode 113c adjacent to the connection region CR. Except for that the first extension pattern 113e1 extends from the pattern electrode 113c, the first extension pattern 113e1 may be the same or substantially a same as the first extension pattern 113e 1 described above with reference to FIGs. 1 to 12, and thus, its description is omitted.

The second extension pattern 113e2 disposed (or configured) at the electrode layers 113-2 and 113-4 included in a second group 113G2 among the first to fifth electrode layers 113-1 to 113-5 may extend toward the connection region CR from the other side of one lateral side (or one short side) of the pattern electrode 113c adjacent to the connection region CR. Except for that the second extension pattern 113e2 extends from the pattern electrode 113c, the second extension pattern 113e2 may be the same or substantially a same as the second extension pattern 113e2 described above with reference to FIGs. 1 to 12, and thus, its description is omitted.

The vibration generating part 110 or the electrode part 113 according to an example of the present disclosure may include a patterning region 113p which is disposed (or configured) at a peripheral region of each of the main electrode 113a and the sub-electrode 113b of each of the first to fifth electrode layers 113-1 to 113-5. Each of the first to fifth electrode layers 113-1 to 113-5 may include one or more patterning regions 113p which is disposed (or configured) at a peripheral region of the sub-electrode 113b. For example, the first to fifth electrode layers 113-1 to 113-5 may include a patterning region 113p corresponding to each corner portion of the vibration layers 111-1 to 111-4, a peripheral region of the plurality of first sub-electrodes 113b5, and a peripheral region of the plurality of second sub-electrodes 113b6.

The patterning region 113p may include a plurality of first patterning regions 113p1 and a plurality of second patterning regions 113p2.

Each of the plurality of first patterning regions 113p1 may be disposed (or configured) at a region between the plurality of first sub-electrodes 113b5. Each of the plurality of first patterning regions 113p1 may be surrounded by the main electrode 113a, the plurality of first sub-electrodes 113b5, and the pattern electrode 113c. Each of a plurality of first patterning regions 113p1 may be disposed (or configured) at the first region R1 of the electrode region ER. For example, each of the plurality of first patterning regions 113p 1 may be disposed (or configured) in an island shape at a region between the plurality of first sub-electrodes 113b5.

The second patterning region 113p2 may be disposed (or configured) to include a region between the plurality of second sub-electrodes 113b6 and a peripheral region of each of the plurality of second sub-electrodes 113b6. For example, the second patterning region 113p2 may be disposed (or configured) to correspond to a region between the plurality of second sub-electrodes 113b6 and the other short side (or a second short side) of the vibration part 111.

In the vibration apparatus 100 according to the twelfth example of the present disclosure, the vibration generating part 110 or the electrode part 113 may further include a dummy pattern part 113d.

The dummy pattern part 113d according to an example of the present disclosure may include first to fourth dummy patterns 113d1, 113d2, 113d3, and 113d4 corresponding to a corner portion of each of first to fourth vibration layers 111-1 to 111-4. The first to fourth dummy patterns 113d1, 113d2, 113d3, and 113d4 may be substantially a same as the first to fourth dummy patterns 113d1, 113d2, 113d3, and 113d4 described above with reference to FIGs. 8 and 9, and thus, their repeated descriptions are omitted.

The electrode part 113 or the dummy pattern part 113d according to an example of the present disclosure may further include an electrode connection line 113L which is configured to be electrically connected to the first to fourth dummy patterns 113d1, 113d2, 113d3, and 113d4.

The electrode connection line 113L may include a first electrode connection line 113L1 configured to electrically connect the first dummy pattern 113d1 to the third dummy pattern 113d3, a second electrode connection line 113L2 configured to electrically connect the second dummy pattern 113d2 to the fourth dummy pattern 113d4, and a third electrode connection line 113L3 configured to electrically connect the third dummy pattern 113d3 to the fourth dummy pattern 113d4. The first to third electrode connection line 113L1, 113L2, and 113L3 may be substantially a same as the first to third electrode connection line 113L1, 113L2, and 113L3 described above with reference to FIGs. 10 to 12, and thus, their repeated descriptions are omitted.

In the vibration apparatus 100 according to the twelfth example of the present disclosure, the vibration generating part 110 or the electrode part 113 may further include one or more (or three) dummy protrusion lines 113Lp.

The one or more dummy protrusion lines 113Lp may protrude (or extend) toward one or more of regions between the plurality of second sub-electrodes 113b6 from the third electrode connection line 113L3 of the dummy pattern part 113d. For example, each of the three dummy protrusion lines 113Lp may protrude (or extend) toward a region between four second sub-electrodes 113b6 from one side of the third electrode connection line 113L3. For example, the one or more dummy protrusion lines 113Lp may protrude (or extend) toward the second patterning region 113p2 between the plurality of second sub-electrodes 113b6 from the third electrode connection line 113L3. For example, each of the three dummy protrusion lines 113Lp may protrude (or extend) toward the second patterning region 113p2 between four second sub-electrodes 113b6 from one side of the third electrode connection line 113L3.

In the vibration apparatus 100 according to the twelfth example of the present disclosure, the vibration generating part 110 or the electrode part 113 may further include a plurality of auxiliary patterns 113r.

The plurality of auxiliary patterns 113r may be disposed (or configured) at each of the plurality of first patterning regions 113p1. The plurality of auxiliary patterns 113r may be disposed (or configured) in an island shape at each of the plurality of first patterning regions 113p1 so as to be electrically disconnected (or insulated) from the main electrode 113a, the plurality of first sub-electrodes 113b5, and the pattern electrode 113c.

The vibration apparatus 100 according to the twelfth example of the present disclosure may have the same effect as the vibration apparatus 100 described above with reference to FIGs. 1 to 12.

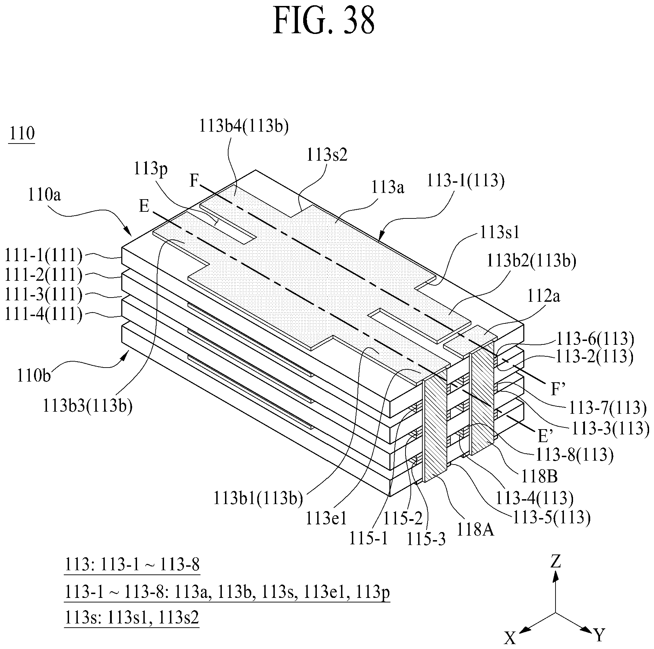

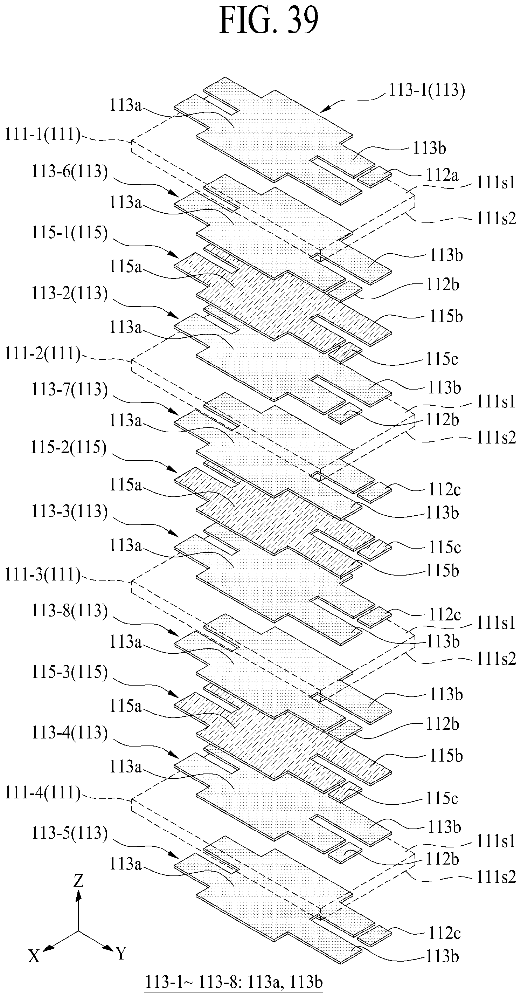

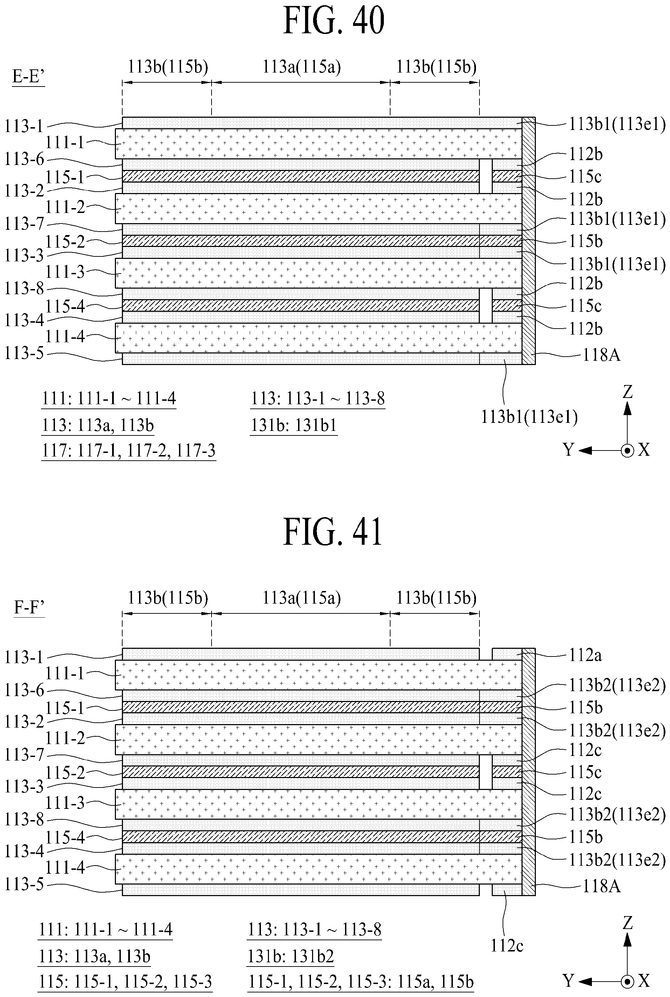

FIG. 38 illustrates a vibration generating part of a vibration apparatus according to another example (or a thirteenth example) of the present disclosure. FIG. 39 illustrates an electrode part and a bonding member illustrated in FIG. 38 according to an example of the present disclosure. FIG. 40 is a cross-sectional view taken along line E-E' illustrated in FIG. 38 according to an example of the present disclosure. FIG. 41 is a cross-sectional view taken along line F-F' illustrated in FIG. 38 according to an example of the present disclosure. FIGs. 38 to 41 illustrate an example where the electrode part of the vibration apparatus described above with reference to FIGs. 1 to 7 is modified and a bonding member is additionally configured. In the descriptions of the vibration apparatus 100 described above with reference to FIGs. 1 to 7, the other description except the description of the electrode part may be included in the descriptions of the vibration apparatus 100 illustrated in FIGs. 38 to 41, and thus, like reference numerals refer to like elements and repeated descriptions thereof are omitted.

With reference to FIGs. 38 to 41, in the vibration generating part 110 of the vibration apparatus 100 according to the thirteenth example of the present specification, an electrode part 113 may include a plurality of electrode layers 113-1 to 113-8. For example, the electrode part 113 may include first to eighth electrode layers 113-1 to 113-8.

Each of the first to fifth electrode layers 113-1 to 113-5 of the electrode part 113 may be substantially a same as each of the first to fifth electrode layers 113-1 to 113-5 described above with reference to FIGs. 1 to 7, and thus, their repeated descriptions are omitted.

The sixth electrode layer 113-6 of the electrode part 113 may be disposed (or configured) between the first vibration layer 111-1 and the second electrode layer 113-2. The sixth electrode layer 113-6 may be electrically connected to a second surface 11 1s2 of the first vibration layer 111-1. The sixth electrode layer 113-6 may overlap the first electrode layer 113-1 with the first vibration layer 111-1 therebetween. For example, the first electrode layer 113-1 may be an upper electrode layer (or a first upper electrode layer) of the first vibration layer 111-1, and the sixth electrode layer 113-6 may be a lower electrode layer (or a first lower electrode layer) of the first vibration layer 111-1. Accordingly, the first vibration layer 111-1 may vibrate based on a driving signal applied through the first electrode layer 113-1 and the sixth electrode layer 113-6 from the outside.

The sixth electrode layer 113-6 may include a main electrode 113a and one or more sub-electrodes 113b protruding from the main electrode 113a. The sixth electrode layer 113-6 may further include a first connection pattern 112b. The main electrode 113a, one or more sub-electrodes 113b, and the first connection pattern 112b of the sixth electrode layer 113-6 may respectively be substantially a same as the main electrode 113a, one or more sub-electrodes 113b, and the first connection pattern 112b of the second electrode layer 113-2, and thus, like reference numerals refer to like elements and their repeated descriptions are omitted.

The seventh electrode layer 113-7 of the electrode part 113 may be disposed (or configured) between the second vibration layer 111-2 and the third electrode layer 113-3. The seventh electrode layer 113-7 may be electrically connected to a second surface 111s2 of the second vibration layer 111-2. The seventh electrode layer 113-7 may overlap the second electrode layer 113-2 with the second vibration layer 111-2 therebetween. For example, the second electrode layer 113-2 may be an upper electrode layer (or a second upper electrode layer) of the second vibration layer 111-2, and the seventh electrode layer 113-7 may be a lower electrode layer (or a second lower electrode layer) of the second vibration layer 111-2. Accordingly, the second vibration layer 111-2 may vibrate based on a driving signal applied through the second electrode layer 113-2 and the seven electrode layer 113-7 from the outside.

The seventh electrode layer 113-7 may include a main electrode 113a and one or more sub-electrodes 113b protruding from the main electrode 113a. The seventh electrode layer 113-7 may further include a second connection pattern 112c. The main electrode 113a, one or more sub-electrodes 113b, and the second connection pattern 112c of the seventh electrode layer 113-7 may respectively be substantially a same as the main electrode 113a, one or more sub-electrodes 113b, and the second connection pattern 112c of the third electrode layer 113-3, and thus, like reference numerals refer to like elements and their repeated descriptions are omitted.

The eighth electrode layer 113-8 of the electrode part 113 may be disposed (or configured) between the third vibration layer 111-3 and the fourth electrode layer 113-4. The eighth electrode layer 113-8 may be electrically connected to a second surface 111s2 of the third vibration layer 111-3. The eighth electrode layer 113-8 may overlap the fourth electrode layer 113-4 with the third electrode layer 113-3 therebetween. For example, the third electrode layer 113-3 may be an upper electrode layer (or a third upper electrode layer) of the third vibration layer 111-3, and the eighth electrode layer 113-8 may be a lower electrode layer (or a third lower electrode layer) of the third vibration layer 111-3. Accordingly, the third vibration layer 111-3 may vibrate based on a driving signal applied through the third electrode layer 113-3 and the eighth electrode layer 113-8 from the outside.

The eighth electrode layer 113-8 may include a main electrode 113a and one or more sub-electrodes 113b protruding from the main electrode 113a. The eighth electrode layer 113-8 may further include a first connection pattern 112b. The main electrode 113a, one or more sub-electrodes 113b, and the second connection pattern 112c of the eighth electrode layer 113-8 may respectively be substantially a same as the main electrode 113a, one or more sub-electrodes 113b, and the second connection pattern 112c of the fourth electrode layer 113-4, and thus, like reference numerals refer to like elements and their repeated descriptions are omitted.

The fourth electrode layer 113-4 of the electrode part 113 may be an upper electrode layer (or a fourth upper electrode layer) of the fourth vibration layer 111-4, and the fifth electrode layer 113-5 may be a lower electrode layer (or a fourth lower electrode layer) of the fourth vibration layer 111-4. Accordingly, the fourth vibration layer 111-4 may vibrate based on a driving signal applied through the fourth electrode layer 113-4 and the fifth electrode layer 113-5 from the outside.

In the vibration apparatus 100 or the vibration generating part 110 according to the thirteenth example of the present disclosure, the first connection member 118A may be configured to be electrically connected to electrode layers 113-1, 113-3, 113-5, and 113-7 of a first group among the first to eighth electrode layers 113-1 to 113-8. The first connection member 118A may be formed (or disposed) at one lateral surface (or one short side) of the vibration generating part 110 or the electrode part 113 and may be electrically (or in common) connected to (or coupled to or contact) a first sub-electrode 113b1 (or a first extension pattern 113e1) of each of the first, third, fifth, and seventh electrode layers 113-1, 113-3, 113-5, and 113-7 among the first to eighth electrode layers 113-1 to 113-8.

In the vibration apparatus 100 or the vibration generating part 110 according to the thirteenth example of the present disclosure, the second connection member 118B may be configured to be electrically connected to electrode layers 113-2, 113-4, 113-6, and 113-8 of a second group among the first to eighth electrode layers 113-1 to 113-8. The second connection member 118B may be formed (or disposed) at one lateral surface (or one short side) of the vibration generating part 110 or the electrode part 113 so as to electrically disconnected (or insulated) from the first connection member 118A and may be electrically (or in common) connected to (or coupled to or contact) a second sub-electrode 113b2 (or a second extension pattern 113e2) of each of the second, fourth, sixth, and eighth electrode layers 113-2, 113-4, 113-6, and 113-8 among the first to eighth electrode layers 113-1 to 113-8.

The vibration apparatus 100 or the vibration generating part 110 according to a thirteenth example of the present disclosure may further include a bonding member (or an adhesive member) 115.

The bonding member 115 may be disposed (or configured) between two vertically adjacent electrode layers which are disposed (or configured) between two vertically adjacent vibration layers among a plurality of vibration layers 111-1 to 111-4. The bonding member 115 may be configured to electrically connect (or couple), with each other, the two vertically adjacent electrode layers which are disposed (or configured) between the two vertically adj acent vibration layers. The bonding member 115 may include a conductive adhesive material. Accordingly, the bonding member 115 may enhance a bonding force (or a coupling force) between two electrode layers vertically adjacent to each other between two vibration layers vertically adjacent to each other.

The bonding member 115 according to an example of the present disclosure may include first to third bonding members 115-1, 115-2, and 115-3.

The first bonding member 115-1 may be disposed (or interposed) between the sixth electrode layer 113-6 and the second electrode layer 113-2 which are disposed between the first vibration layer 111-1 and the second vibration layer 111-2. For example, the first bonding member 115-1 may be bonded (or interposed) between a first lower electrode of the first vibration layer 111-1 and a second upper electrode of the second vibration layer 111-2. Accordingly, the second electrode layer 113-2 may be electrically connected (or bonded) to the sixth electrode layer 113-6 through the first bonding member 115-1.

The first bonding member 115-1 may have a same shape and a same size as the second electrode layer 113-2. For example, the first bonding member 115-1 may include a first bonding pattern 115a and one or more second bonding patterns 115b. The first bonding member 115-1 may further include a third bonding pattern 115c.

In the first bonding member 115-1, the first bonding pattern 115a may have a same shape and a same size as a main electrode 113a of the second electrode layer 113-2. The first bonding pattern 115a may be bonded (or interposed) between the main electrode 113a of the second electrode layer 113-2 and a main electrode 113a of the sixth electrode layer 113-6. Accordingly, the main electrode 113a of the sixth electrode layer 113-6 and the main electrode 113a of the second electrode layer 113-2 may be electrically (or in common) connected (or coupled) to the first bonding pattern 115a.

In the first bonding member 115-1, the one or more second bonding patterns 115b may have a same shape and a same size as one or more sub-electrodes 113b of the second electrode layer 113-2. The one or more second bonding patterns 115b may be bonded (or interposed) between the one or more sub-electrodes 113b of the second electrode layer 113-2 and one or more sub-electrodes 113b of the sixth electrode layer 113-6. Accordingly, the one or more sub-electrodes 113b of the sixth electrode layer 113-6 and the one or more sub-electrodes 113b of the second electrode layer 113-2 may be electrically (or in common) connected (or coupled) to the one or more second bonding patterns 115b.

In the first bonding member 115-1, the third bonding pattern 115c may have a same shape and a same size as a first connection pattern 112b of the second electrode layer 113-2. The third bonding pattern 115c may be bonded (or interposed) between the first connection pattern 112b of the second electrode layer 113-2 and a first connection pattern 112b of the sixth electrode layer 113-6. Accordingly, the first connection pattern 112b of the sixth electrode layer 113-6 and the first connection pattern 112b of the second electrode layer 113-2 may be electrically (or in common) connected (or coupled) to the third bonding pattern 115c.

The second bonding member 115-2 may be disposed (or interposed) between the seventh electrode layer 113-7 and the third electrode layer 113-3 which are disposed between the second vibration layer 111-2 and the third vibration layer 111-3. The second bonding member 115-2 may be configured to electrically connect the seventh electrode layer 113-7 to the third electrode layer 113-3. For example, the second bonding member 115-2 may be bonded (or interposed) between a second lower electrode of the second vibration layer 111-2 and a third upper electrode of the third vibration layer 111-3. Accordingly, the third electrode layer 113-3 may be electrically connected (or bonded) to the seventh electrode layer 113-7 through the second bonding member 115-2.

The second bonding member 115-2 may have a same shape and a same size as the third electrode layer 113-3. For example, the second bonding member 115-2 may include a first bonding pattern 115a and one or more second bonding patterns 115b. The second bonding member 115-2 may further include a third bonding pattern 115c.

In the second bonding member 115-2, the first bonding pattern 115a may have a same shape and a same size as a main electrode 113a of the third electrode layer 113-3. The first bonding pattern 115a may be bonded (or interposed) between the main electrode 113a of the third electrode layer 113-3 and a main electrode 113a of the seventh electrode layer 113-7. Accordingly, the main electrode 113a of the seventh electrode layer 113-7 and the main electrode 113a of the third electrode layer 113-3 may be electrically (or in common) connected (or coupled) to the first bonding pattern 115a.

In the second bonding member 115-2, the one or more second bonding patterns 115b may have a same shape and a same size as one or more sub-electrodes 113b of the third electrode layer 113-3. The one or more second bonding patterns 115b may be bonded (or interposed) between the one or more sub-electrodes 113b of the third electrode layer 113-3 and one or more sub-electrodes 113b of the seventh electrode layer 113-7. Accordingly, the one or more sub-electrodes 113b of the seventh electrode layer 113-7 and the one or more sub-electrodes 113b of the third electrode layer 113-3 may be electrically (or in common) connected (or coupled) to the one or more second bonding patterns 115b.

In the second bonding member 115-2, the third bonding pattern 115c may have a same shape and a same size as a second connection pattern 112c of the third electrode layer 113-3. The third bonding pattern 115c may be bonded (or interposed) between the second connection pattern 112c of the third electrode layer 113-3 and a second connection pattern 112c of the seventh electrode layer 113-7. Accordingly, the second connection pattern 112c of the seventh electrode layer 113-7 and the second connection pattern 112c of the third electrode layer 113-3 may be electrically (or in common) connected (or coupled) to the third bonding pattern 115c.

The third bonding member 115-3 may be disposed (or interposed) between the eighth electrode layer 113-8 and the fourth electrode layer 113-4 which are disposed between the third vibration layer 111-3 and the fourth vibration layer 111-4. The third bonding member 115-3 may be configured to electrically connect the eighth electrode layer 113-8 to the fourth electrode layer 113-4. For example, the third bonding member 115-3 may be bonded (or interposed) between a third lower electrode of the third vibration layer 111-3 and a fourth upper electrode of the fourth vibration layer 111-4. Accordingly, the fourth electrode layer 113-4 may be electrically connected (or bonded) to the eighth electrode layer 113-8 through the third bonding member 115-3.

The third bonding member 115-3 may have a same shape and a same size as the fourth electrode layer 113-4. For example, the third bonding member 115-3 may include a first bonding pattern 115a and one or more second bonding patterns 115b. Also, the first bonding member 115-1 may include a third bonding pattern 115c.

In the third bonding member 115-3, the first bonding pattern 115a may have a same shape and a same size as a main electrode 113a of the fourth electrode layer 113-4. The first bonding pattern 115a may be bonded (or interposed) between the main electrode 113a of the fourth electrode layer 113-4 and a main electrode 113a of the eighth electrode layer 113-8. Accordingly, the main electrode 113a of the eighth electrode layer 113-8 and the main electrode 113a of the fourth electrode layer 113-4 may be electrically (or in common) connected (or coupled) to the first bonding pattern 115a.

In the third bonding member 115-3, the one or more second bonding patterns 115b may have a same shape and a same size as one or more sub-electrodes 113b of the fourth electrode layer 113-4. The one or more second bonding patterns 115b may be bonded (or interposed) between the one or more sub-electrodes 113b of the fourth electrode layer 113-4 and one or more sub-electrodes 113b of the eighth electrode layer 113-8. Accordingly, the one or more sub-electrodes 113b of the eighth electrode layer 113-8 and the one or more sub-electrodes 113b of the fourth electrode layer 113-4 may be electrically (or in common) connected (or coupled) to the one or more second bonding patterns 115b.

In the third bonding member 115-3, the third bonding pattern 115c may have a same shape and a same size as a first connection pattern 112b of the fourth electrode layer 113-4. The third bonding pattern 115c may be bonded (or interposed) between the first connection pattern 112b of the fourth electrode layer 113-4 and a first connection pattern 112b of the eighth electrode layer 113-8. Accordingly, the first connection pattern 112b of the eighth electrode layer 113-8 and the first connection pattern 112b of the fourth electrode layer 113-4 may be electrically (or in common) connected (or coupled) to the third bonding pattern 115c.

Each of the first to third bonding members 115-1, 115-2, and 115-3 according to an example of the present disclosure may include a conductive adhesive material. For example, each of the first to third bonding members 115-1, 115-2, and 115-3 may include a conductive material (or a particle) and an adhesive material. For example, each of the first to third bonding members 115-1, 115-2, and 115-3 may include a conductive epoxy resin, a conductive acrylic resin, a conductive silicone resin, or a conductive urethane resin, but examples of the present disclosure are not limited thereto.

The vibration apparatus 100 according to the thirteenth example of the present disclosure may have the same effect as that of the vibration apparatus 100 described above with reference to FIGs. 1 to 7 and may further include the bonding member 115, and thus, a bonding force (or a coupling force) between two electrode layers vertically adjacent to each other may be enhanced.

The sixth to eighth electrode layers 113-6, 113-7, and 113-8 described above with reference to FIGs. 38 to 41 may be identically applied (or added) to the vibration apparatuses 100 according to the second to twelfth examples of the present disclosure described above with reference to FIGs. 8 to 37, and thus, their descriptions are omitted. For example, a patterning structure of each of the electrode layers 113-1 to 113-8 described above with reference to FIGs. 38 to 41 may be changed to a patterning structure of the electrode layer described above with reference to FIGs. 8 to 37.

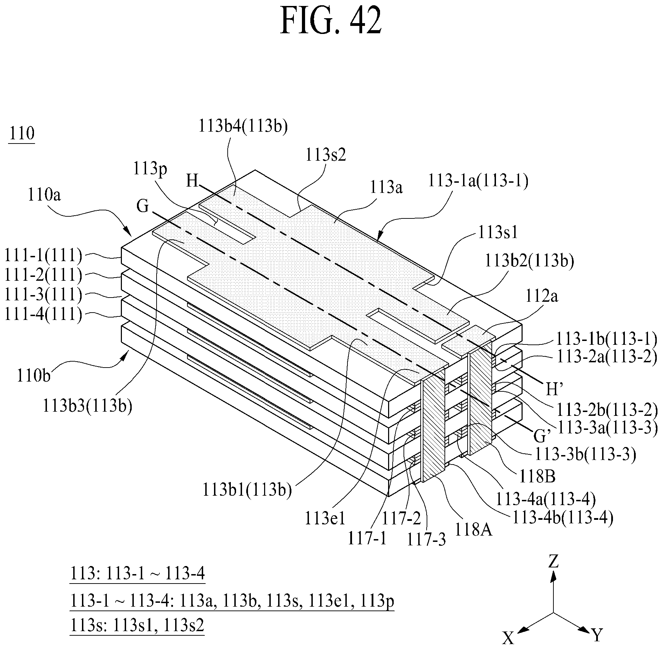

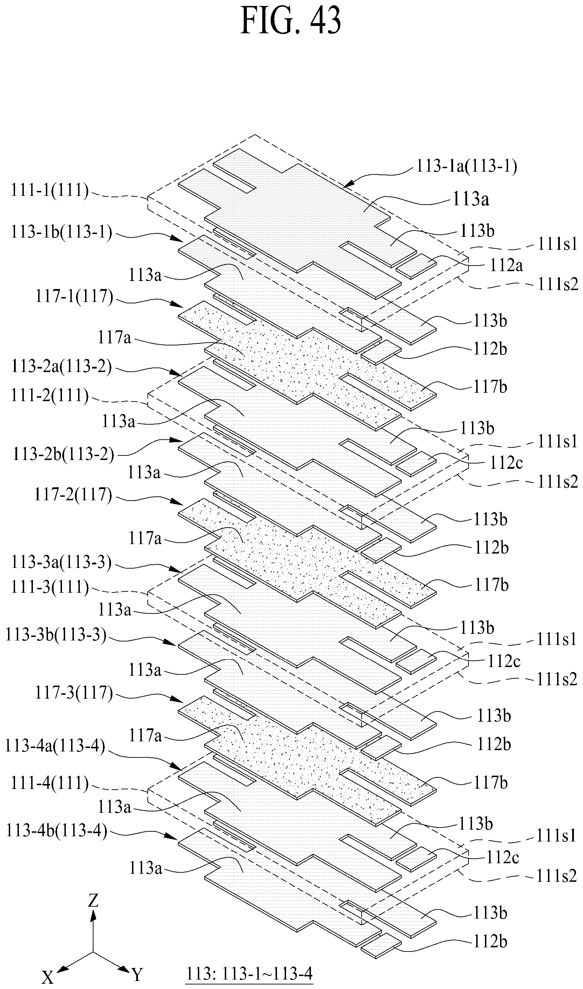

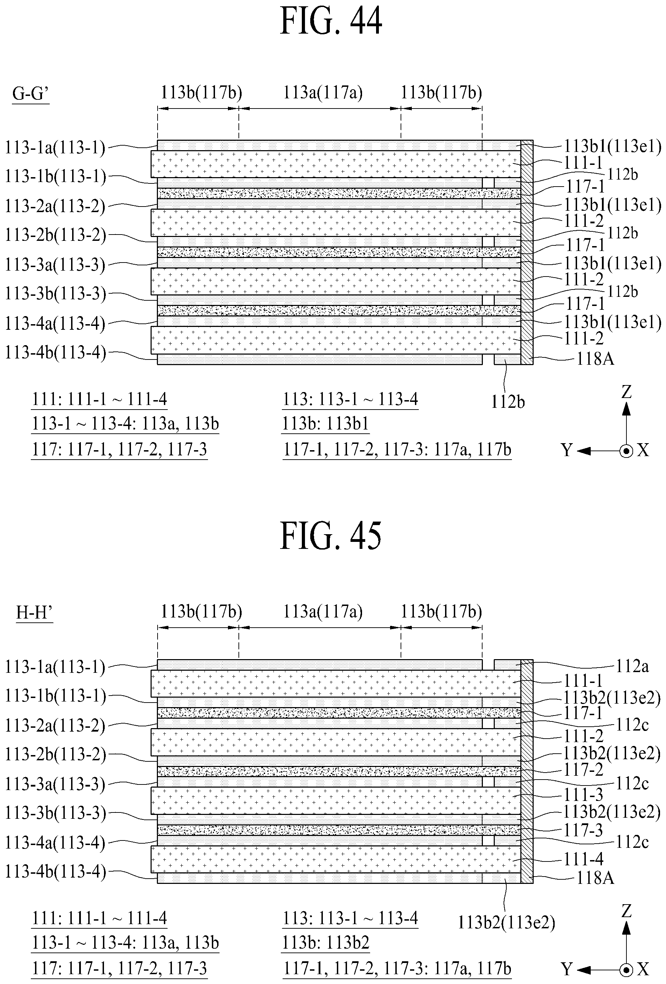

FIG. 42 illustrates a vibration generating part of a vibration apparatus according to another example (or a fourteenth example) of the present disclosure. FIG. 43 illustrates an electrode part and a bonding member illustrated in FIG. 42 according to an example of the present disclosure. FIG. 44 is a cross-sectional view taken along line G-G' illustrated in FIG. 44 according to an example of the present disclosure. FIG. 45 is a cross-sectional view taken along line H-H' illustrated in FIG. 44 according to an example of the present disclosure. FIGs. 42 to 45 illustrate an example where the electrode part of the vibration apparatus described above with reference to FIGs. 1 to 7 is modified and a bonding member is additionally configured. In the descriptions of the vibration apparatus 100 described above with reference to FIGs. 1 to 7, the other description except the description of the electrode part may be included in the descriptions of the vibration apparatus 100 illustrated in FIGs. 42 to 45, and thus, like reference numerals refer to like elements and repeated descriptions thereof are omitted.

With reference to FIGs. 42 to 45, in the vibration generating part 110 of the vibration apparatus 100 according to the fourteenth example of the present disclosure, an electrode part 113 may include a plurality of electrode layers 113-1 to 113-4. For example, the electrode part 113 may include first to fourth electrode layers 113-1 to 113-4.

The first electrode layer 113-1 may be disposed (or configured) at a first vibration layer 111-1. The first electrode layer 113-1 may be disposed (or configured) at a first surface 111s1 and a second surface 111s2 of the first vibration layer 111-1. The first electrode layer 113-1 according to an example of the present disclosure may include a first upper electrode layer 113-1a which is disposed (or configured) at the first surface 111s1 of the first vibration layer 111-1 and a first lower electrode layer 113-1b which is disposed (or configured) at the second surface 111s2 of the first vibration layer 111-1.

The first upper electrode layer 113-1a may include a main electrode 113a and one or more sub-electrodes 113b protruding from the main electrode 113a. The first upper electrode layer 113-1a may further include a first connection pattern 112a. The main electrode 113a and the one or more sub-electrodes 113b of the first upper electrode layer 113-1a and the first connection pattern 112a may be substantially a same as the main electrode 113a and the one or more sub-electrodes 113b of the first electrode layer 113-1 and the first connection pattern 112a described above with reference to FIGs. 1 to 7, and thus, repeated descriptions thereof are omitted.

The first lower electrode layer 113-1b may include a main electrode 113a and one or more sub-electrodes 113b protruding from the main electrode 113a. The first lower electrode layer 113-1b may further include a second connection pattern 112b. Except for that the main electrode 113a and the one or more sub-electrodes 113b of the first lower electrode layer 113-1b and the second connection pattern 112b are disposed (or configured) at the second surface 111s2 of the first vibration layer 111-1, the main electrode 113a and the one or more sub-electrodes 113b of the first lower electrode layer 113-1b and the second connection pattern 112b may be substantially a same as the main electrode 113a and the one or more sub-electrodes 113b of the second electrode layer 113-2 and the second connection pattern 112b described above with reference to FIGs. 1 to 7, and thus, repeated descriptions thereof are omitted.

The second electrode layer 113-2 may be disposed (or configured) at a second vibration layer 111-2. The second electrode layer 113-2 may be disposed (or configured) at a first surface 111s1 and a second surface 111s2 of the second vibration layer 111-2. The second electrode layer 113-2 according to an example of the present disclosure may include a second upper electrode layer 113-2a which is disposed (or configured) at the first surface 111s1 of the second vibration layer 111-2 and a second lower electrode layer 113-2b which is disposed (or configured) at the second surface 11 1s2 of the second vibration layer 111-2.

The second upper electrode layer 113-2a may include a main electrode 113a and one or more sub-electrodes 113b protruding from the main electrode 113a. The second upper electrode layer 113-2a may further include a third connection pattern 112c. Except for that the main electrode 113a and the one or more sub-electrodes 113b of the second upper electrode layer 113-2a and the third connection pattern 112c are disposed (or configured) at the first surface 111s1 of the second vibration layer 111-2, the main electrode 113a and the one or more sub-electrodes 113b of the second upper electrode layer 113-2a and the third connection pattern 112c may be substantially a same as the main electrode 113a and the one or more sub-electrodes 113b of the third electrode layer 113-3 and the third connection pattern 112c described above with reference to FIGs. 1 to 7, and thus, repeated descriptions thereof are omitted.

The second lower electrode layer 113-2b may include a main electrode 113a and one or more sub-electrodes 113b protruding from the main electrode 113a. The second lower electrode layer 113-2b may further include a second connection pattern 112b. Except for that the main electrode 113a and the one or more sub-electrodes 113b of the second lower electrode layer 113-2b and a second connection pattern 112b are disposed (or configured) at the second surface 111s2 of the second vibration layer 111-2, the main electrode 113a and the one or more sub-electrodes 113b of the second lower electrode layer 113-2b and the second connection pattern 112b may be substantially a same as the main electrode 113a and the one or more sub-electrodes 113b of the third electrode layer 113-3 and the second connection pattern 112b described above with reference to FIGs. 1 to 7, and thus, repeated descriptions thereof are omitted. For example, the second lower electrode layer 113-2b may be substantially a same as the first lower electrode layer 113-1b.

The third electrode layer 113-3 may be disposed (or configured) at a third vibration layer 111-3. The third electrode layer 113-3 may be disposed (or configured) at a first surface 111s1 and a second surface 11 1s2 of the third vibration layer 111-3. The third electrode layer 113-3 according to an example of the present disclosure may include a third upper electrode layer 113-3a which is disposed (or configured) at the first surface 111s1 of the third vibration layer 111-3 and a third lower electrode layer 113-3b which is disposed (or configured) at the second surface 111s2 of the third vibration layer 111-3.

The third upper electrode layer 113-3a may include a main electrode 113a and one or more sub-electrodes 113b protruding from the main electrode 113a. The third upper electrode layer 113-3a may further include a third connection pattern 112c. The main electrode 113a and the one or more sub-electrodes 113b of the third upper electrode layer 113-3a and the third connection pattern 112c may be substantially a same as the main electrode 113a and the one or more sub-electrodes 113b of the third electrode layer 113-3 and the third connection pattern 112c described above with reference to FIGs. 1 to 7, and thus, repeated descriptions thereof are omitted. For example, the third upper electrode layer 113-3a may be substantially a same as the second upper electrode layer 113-2a.

The third lower electrode layer 113-3b may include a main electrode 113a and one or more sub-electrodes 113b protruding from the main electrode 113a. The third lower electrode layer 113-3b may further include a second connection pattern 112b. Except for that the main electrode 113a and the one or more sub-electrodes 113b of the third lower electrode layer 113-3b and the second connection pattern 112b are disposed (or configured) at the second surface 11 1s2 of the third vibration layer 111-3, the main electrode 113a and the one or more sub-electrodes 113b of the third lower electrode layer 113-3b and the second connection pattern 112b may be substantially a same as the main electrode 113a and the one or more sub-electrodes 113b of the fourth electrode layer 113-4 and the second connection pattern 112b described above with reference to FIGs. 1 to 7, and thus, repeated descriptions thereof are omitted. For example, the third lower electrode layer 113-3b may be substantially a same as the second lower electrode layer 113-2b.

The fourth electrode layer 113-4 may be disposed (or configured) at a fourth vibration layer 111-4. The fourth electrode layer 113-4 may be disposed (or configured) at a first surface 111s1 and a second surface 111s2 of the fourth vibration layer 111-4. The fourth electrode layer 113-4 according to an example of the present disclosure may include a fourth upper electrode layer 113-4a which is disposed (or configured) at the first surface 111s1 of the fourth vibration layer 111-4 and a fourth lower electrode layer 113-4b which is disposed (or configured) at the second surface 11 1s2 of the fourth vibration layer 111-4.

The fourth upper electrode layer 113-4a may include a main electrode 113a and one or more sub-electrodes 113b protruding from the main electrode 113a. The fourth upper electrode layer 113-4a may further include a third connection pattern 112c. Except for that the main electrode 113a and the one or more sub-electrodes 113b of the fourth upper electrode layer 113-4a and the third connection pattern 112c are disposed (or configured) at the first surface 111s1 of the fourth vibration layer 111-4, the main electrode 113a and the one or more sub-electrodes 113b of the fourth upper electrode layer 113-4a and the third connection pattern 112c may be substantially a same as the main electrode 113a and the one or more sub-electrodes 113b of the fourth electrode layer 113-3 and the third connection pattern 112c described above with reference to FIGs. 1 to 7, and thus, repeated descriptions thereof are omitted. For example, the fourth upper electrode layer 113-4a may be substantially a same as the second upper electrode layer 113-2a and the third upper electrode layer 113-3a.

The fourth lower electrode layer 113-4b may include a main electrode 113a and one or more sub-electrodes 113b protruding from the main electrode 113a. The fourth lower electrode layer 113-4b may further include a second connection pattern 112b. Except for that the main electrode 113a and the one or more sub-electrodes 113b of the fourth lower electrode layer 113-4b and the second connection pattern 112b are disposed (or configured) at the second surface 111s2 of the fourth vibration layer 111-4, the main electrode 113a and the one or more sub-electrodes 113b of the fourth lower electrode layer 113-4b and the second connection pattern 112b may be substantially a same as the main electrode 113a and the one or more sub-electrodes 113b of the fourth electrode layer 113-4 and the second connection pattern 112b described above with reference to FIGs. 1 to 7, and thus, repeated descriptions thereof are omitted. For example, the fourth lower electrode layer 113-4b may be substantially a same as the first to third lower electrode layers 113-1b, 113-2b, and 113-3b.

In the vibration apparatus 100 or the vibration generating part 110 according to the fourteenth example of the present disclosure, each of the first to fourth vibration layers 111-1 to 111-4 may have a same poling direction. For example, each of the first to fourth vibration layers 111-1 to 111-4 may have a poling direction toward the second surface 111a2 from the first surface 111a1, but examples of the present disclosure are not limited thereto. For example, each of the first to fourth vibration layers 111-1 to 111-4 may have a poling direction toward the first surface 111a1 from the second surface 111a2.

In the vibration apparatus 100 or the vibration generating part 110 according to the fourteenth example of the present disclosure, the first connection member 118A may be configured to be electrically connected to electrode layers 113-1a, 113-2a, 113-3 a, and 113-4a of a first group of each of the first to fourth electrode layers 113-1 to 113-4. The first connection member 118A may be formed (or disposed) at one lateral surface (or one short side) of the vibration generating part 110 or the electrode part 113 and may be electrically (or in common) connected to (or coupled to or contact) a first sub-electrode 113b1 (or a first extension pattern 113e1) of the first to fourth upper electrode layers 113-1a, 113-2a, 113-3a, and 113-4a of each of the first to fourth electrode layers 113-1 to 113-4.

In the vibration apparatus 100 or the vibration generating part 110 according to the fourteenth example of the present disclosure, the second connection member 118B may be configured to be electrically connected to electrode layers 113-1b, 113-2b, 113-3b, and 113-4b of a second group of each of the first to fourth electrode layers 113-1 to 113-4. The second connection member 118B may be formed (or disposed) at one lateral surface (or one short side) of the vibration generating part 110 or the electrode part 113 so as to electrically disconnected (or insulated) from the first connection member 118A and may be electrically (or in common) connected to (or coupled to or contact) a second sub-electrode 113b2 (or a second extension pattern 113e2) of the first to fourth lower electrode layers 113-1b, 113-2b, 113-3b, and 113-4b of each of the first to fourth electrode layers 113-1 to 113-4.

The vibration apparatus 100 or the vibration generating part 110 according to the fourteenth example of the present disclosure may further include a bonding member 117.

The bonding member 117 may be configured to electrically disconnect (or insulate), from each other, two electrode layers vertically adjacent to each other between two adjacent vibration layers among a plurality of vibration layers 111-1 to 111-4 which are vertically stacked. The bonding member 117 may include an adhesive material, an insulating adhesive material, or a non-conductive adhesive material. Accordingly, the bonding member 117 may enhance a bonding force (or a coupling force) between upper electrode layers 113-1a to 113-4a and lower electrode layers 113-1b to 113-4b vertically adjacent to each other among the first to fourth electrode layers 113-1 to 113-4. For example, the bonding member 117 may be an adhesive, an adhesive member, a coupling member, or an insulation member, but examples of the present disclosure are not limited thereto.

The bonding member 117 according to an example of the present disclosure may include first to third bonding members 117-1, 117-2, and 117-3.

The first bonding member 117-1 may be disposed (or interposed) between the first lower electrode layer 113-1b of the first electrode layer 113-1 and the second upper electrode layer 113-2a of the second electrode layer 113-2 which are disposed between the first vibration layer 111-1 and the second vibration layer 111-2. The first bonding member 117-1 may be configured to electrically disconnect (or insulate) the first lower electrode layer 113-1b from the second upper electrode layer 113-2a. Accordingly, the first electrode layer 113-1 or the first lower electrode layer 113-1b may be electrically disconnected (or insulated) from the second electrode layer 113-2 or the second upper electrode layer 113-2a by the first bonding member 117-1.

The first bonding member 117-1 according to an example of the present disclosure may have a same shape and a same size as the first lower electrode layer 113-1b of the first electrode layer 113-1. For example, the first bonding member 117-1 may include a first bonding pattern 117a and one or more second bonding patterns 117b.

In the first bonding member 117-1, the first bonding pattern 117a may have a same shape and a same size as a main electrode 113a of the second electrode layer 113-2. The first bonding pattern 115a may be bonded (or interposed) between the main electrode 113a of the first lower electrode layer 113-1b and a main electrode 113a of the second upper electrode layer 113-2a. Accordingly, the main electrode 113a of the first lower electrode layer 113-1b may be electrically disconnected (or insulated) from the main electrode 113a of the second upper electrode layer 113-2a by the first bonding pattern 117a.

In the first bonding member 117-1, the one or more second bonding patterns 117b may have a same shape and a same size as one or more sub-electrodes 113b of the first lower electrode layer 113-1b. The one or more second bonding patterns 117b may be bonded (or interposed) between the one or more sub-electrodes 113b of the first lower electrode layer 113-1b and one or more sub-electrodes 113b of the second upper electrode layer 113-2a. Accordingly, the one or more sub-electrodes 113b of the first lower electrode layer 113-1b may be electrically disconnected (or insulated) from the one or more sub-electrodes 113b of the second upper electrode layer 113-2a by the one or more second bonding patterns 117b.

The first bonding member 117-1 according to another example of the present disclosure may have a same shape and a same size as the first vibration layer 111-1 or the second vibration layer 111-2. For example, the first bonding member 117-1 may have a shape and a size corresponding to an entire region between the second surface 111s2 of the first vibration layer 111-1 and the first surface 111s1 of the second vibration layer 111-2. Accordingly, the first bonding member 117-1 may electrically disconnect (or insulate) the first lower electrode layer 113-1b (or the first electrode layer 113-1) from the second upper electrode layer 113-2a (or the second electrode layer 113-2).

The second bonding member 117-2 may be disposed (or interposed) between the second lower electrode layer 113-2b of the second electrode layer 113-2 and the third upper electrode layer 113-3a of the third electrode layer 113-3 which are disposed between the second vibration layer 111-2 and the third vibration layer 111-3. The second bonding member 117-2 may electrically disconnect (or insulate) the second lower electrode layer 113-2b from the third upper electrode layer 113-3a. Accordingly, the second electrode layer 113-2 or the second lower electrode layer 113-2b may be electrically disconnected (or insulated) from the third electrode layer 113-3 or the third upper electrode layer 113-3a by the second bonding member 117-2.

Except for that the second bonding member 117-2 is configured to electrically disconnect (or insulate), from each other, the second lower electrode layer 113-2b and the third upper electrode layer 113-3a which are disposed between the second vibration layer 111-2 and the third vibration layer 111-3, the second bonding member 117-2 may be the same or substantially a same as the first bonding member 117-1, and thus, descriptions thereof are omitted.

The third bonding member 117-3 may be disposed (or interposed) between the third lower electrode layer 113-3b of the third electrode layer 113-3 and the fourth upper electrode layer 113-4a of the fourth electrode layer 113-4 which are disposed between the third vibration layer 111-3 and the fourth vibration layer 111-4. The third bonding member 117-3 is configured to electrically disconnect (or insulate) the third lower electrode layer 113-3b from the fourth upper electrode layer 113-4a. Accordingly, the third electrode layer 113-3 or the third lower electrode layer 113-3b may be electrically disconnected (or insulated) from the fourth electrode layer 113-4 or the fourth upper electrode layer 113-4a by the third bonding member 117-3.

Except for that the third bonding member 117-3 is configured to electrically disconnect (or insulate), from each other, the third lower electrode layer 113-3b and the fourth upper electrode layer 113-4a which are disposed between the third vibration layer 111-3 and the fourth vibration layer 111-4, the third bonding member 117-3 may be the same or substantially a same as the first bonding member 117-1, and thus, descriptions thereof are omitted.

Each of the first to third bonding member 117-1, 117-2, and 117-3 according to an example of the present disclosure may be configured as an adhesive material, an insulating adhesive material, or a non-conductive adhesive material. For example, each of the first to third bonding member 117-1, 117-2, and 117-3 may include epoxy resin, acrylic resin, silicone resin, or urethane resin, but examples of the present disclosure are limited thereto.

Each of the first to third bonding member 117-1, 117-2, and 117-3 according to another example of the present disclosure may include one or more of a thermo-curable adhesive, a photo-curable adhesive, and a hot melt adhesive (or a thermal bonding adhesive or a heat fusion adhesive), a pressure sensitive adhesive (PSA), an optically cleared adhesive (OCA), or an optically cleared resin (OCR), but examples of the present disclosure are limited thereto. For example, each of the first to third bonding member 117-1, 117-2, and 117-3 may include the hot melt adhesive. The hot melt adhesive may be a heat-active type or a thermo-curable type, but examples of the present disclosure are not limited thereto. For example, the bonding member 117-1, 117-2, and 117-3 including the hot melt adhesive may attach (or adhere) or couple two electrode layers vertically adjacent to each other by heat and pressure and may be electrically separated (or insulated) two electrode layers vertically adjacent to each other.

The vibration apparatus 100 according to the fourteenth example of the present disclosure may have the same effect as that of the vibration apparatus 100 described above with reference to FIGs. 1 to 7 and may further include the bonding member 117, and thus, a bonding force (or a coupling force) between two electrode layers vertically adjacent to each other may be enhanced.

The first to fourth electrode layers 113-1 to 113-4 described above with reference to FIGs. 42 to 45 may be identically applied (or added) to the vibration apparatuses 100 according to the second to twelfth examples of the present disclosure described above with reference to FIGs. 8 to 37, and thus, their descriptions are omitted. For example, a patterning structure of each of the electrode layers 113-1 to 113-4 described above with reference to FIGs. 42 to 45 may be changed to a patterning structure of the electrode layer described above with reference to FIGs. 8 to 37.

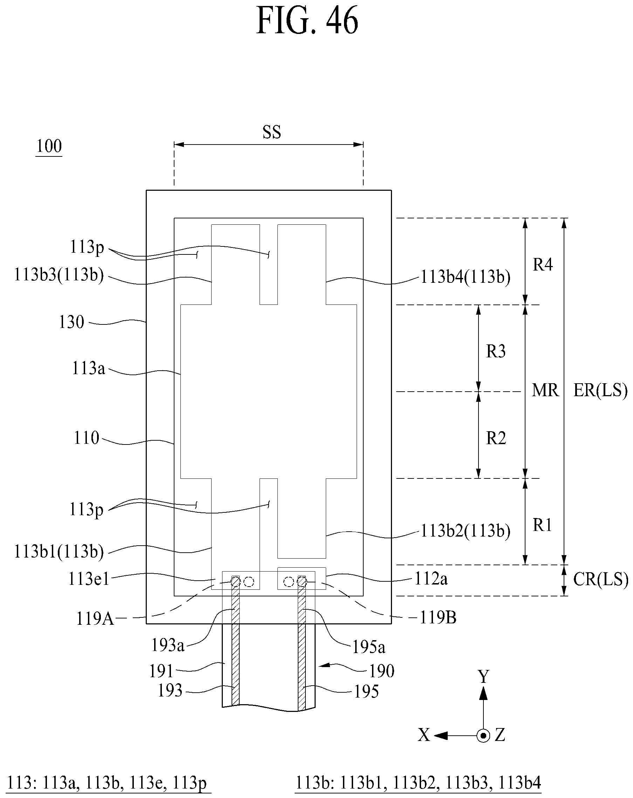

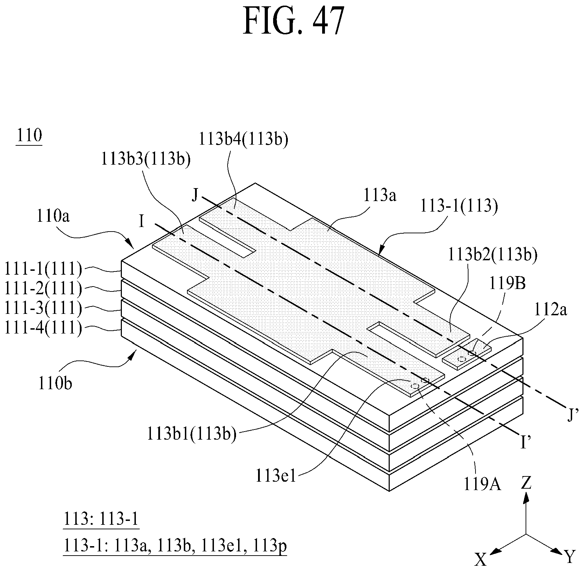

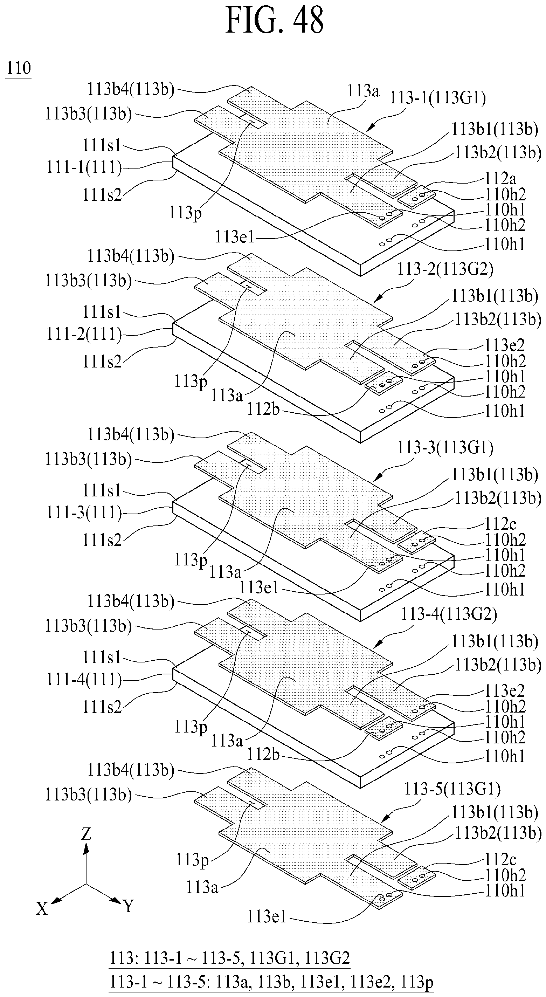

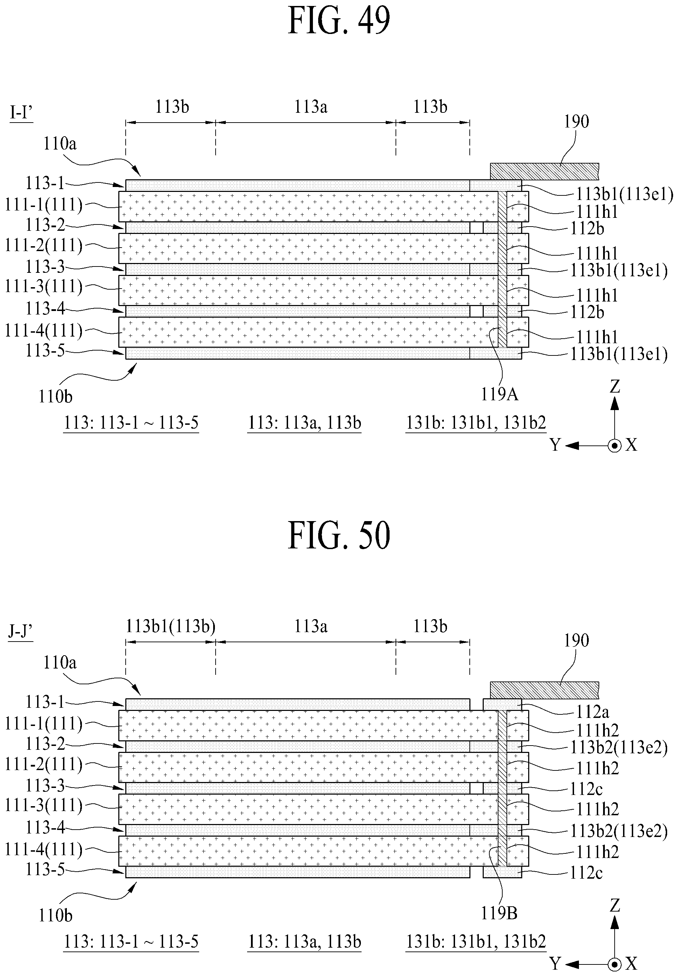

FIG. 46 illustrates a vibration apparatus according to another example (fifteenth example) of the present disclosure. FIG. 47 illustrates a vibration generating part illustrated in FIG. 46 according to an example of the present disclosure. FIG. 48 is an exploded perspective view of a vibration part and an electrode part illustrated in FIG. 47 according to an example of the present disclosure. FIG. 49 is a cross-sectional view taken along line I-I' illustrated in FIG. 47 according to an example of the present disclosure. FIG. 50 is a cross-sectional view taken along line J-J' illustrated in FIG. 47 according to an example of the present disclosure. FIGs. 46 to 50 illustrate an example implemented by modifying the first connection member and the second connection member in the vibration apparatus described above with reference to FIGs. 1 to 7. In the descriptions of the vibration apparatus 100 described above with reference to FIGs. 1 to 7, the other description except the description of the first connection member and the second connection member may be included in the descriptions of the vibration apparatus 100 illustrated in FIGs. 46 to 50, and thus, like reference numerals refer to like elements and repeated descriptions thereof are omitted.

With reference to FIGs. 46 to 50, a vibration apparatus 100 or a vibration generating part 110 according to the fifteenth example of the present disclosure may further include a first connection member 119A and a second connection member 119B. For example, the first connection member 119A may be a first hole contact member or a first hole connection member, but examples of the present disclosure are not limited thereto. The second connection member 119B may be a second hole contact member or a second hole connection member, but examples of the present disclosure are not limited thereto.

The first connection member 119A may be configured to electrically connect, with each other, electrode layers 113-1, 113-3, and 113-5 of a first group 113G1 among a plurality of electrode layers 113-1 to 113-5 by using a hole contact type (or structure). The first connection member 119A may pass through (or via) the plurality of vibration layers 111-1 to 111-4 and may be electrically connected to the electrode layers 113-1, 113-3, and 113-5 of the first group 113G1 among the plurality of electrode layers 113-1 to 113-5. The first connection member 119A may pass through (or via) the plurality of vibration layers 111-1 to 111-4 and may be electrically connected to the electrode layers 113-1, 113-3, and 113-5 of the first group 113G1 and electrode layers 113-2 and 113-4 of a second group 113G2 among the plurality of electrode layers 113-1 to 113-5.

The first connection member 119A may pass through (or via) each of the first to fourth vibration layers 111-1 to 111-4 and may be electrically connected to first, third, and fifth electrode layers 113-1, 113-3, and 113-5 of the plurality of electrode layers 113-1 to 113-5. For example, the first connection member 119A may pass through (or via) each of the first to fourth vibration layers 111-1 to 111-4 and may be electrically connected to a first extension pattern 113e1 of a first sub-electrode 113b1 of each of the first, third, and fifth electrode layers 113-1, 113-3, and 113-5. For example, the first connection member 119A may pass through (or via) each of the first to fourth vibration layers 111-1 to 111-4, may be electrically connected to the first extension pattern 113e1 of each of the first, third, and fifth electrode layers 113-1, 113-3, and 113-5, and may be electrically (or in common) connected to a second connection pattern 112b of each of second and fourth electrode layers 113-2 and 113-4.

The second connection member 119B may be configured to electrically connect, with each other, the electrode layers 113-2 and 113-4 of the second group 113G2 among the plurality of electrode layers 113-1 to 113-5 by using a hole contact type (or structure). The second connection member 119B may pass through (or via) the plurality of vibration layers 111-1 to 111-4 and may be electrically connected to the electrode layers 113-2 and 113-4 of the second group 113G2 among the plurality of electrode layers 113-1 to 113-5. The second connection member 119B may pass through (or via) the plurality of vibration layers 111-1 to 111-4 and may be electrically (or in common) connected to the first connection pattern 112a, the electrode layers 113-2 and 113-4 of the second group 113G2, and the third connection pattern 112c of the electrode layers 113-1, 113-3, and 113-5 of the first group 113G1 among the plurality of electrode layers 113-1 to 113-5.

The second connection member 119B may pass through (or via) each of the first to fourth vibration layers 111-1 to 111-4 and may be electrically connected to the first connection pattern 112a and second and fourth electrode layers 113-2 and 113-4 of the plurality of electrode layers 113-1 to 113-5. For example, the second connection member 119B may pass through (or via) each of the first to fourth vibration layers 111-1 to 111-4 and may be electrically connected to a second extension pattern 113e2 of a second sub-electrode 113b2 of each of the second and fourth electrode layers 113-2 and 113-4. For example, the second connection member 119B may pass through (or via) each of the first to fourth vibration layers 111-1 to 111-4, may be electrically connected to the second extension pattern 113e2 of each of the second and fourth electrode layers 113-2 and 113-4, and may be electrically (or in common) connected to the first connection pattern 112a of the first electrode layer 113-1, and a third connection pattern 112c of each of the third, and fifth electrode layers 113-3, and 113-5.

The vibration apparatus 100 or the vibration generating part 110 according to the fifteenth example of the present disclosure may include one or more first holes 110h1 and one or more second holes 110h2.

The one or more first holes 110h1 may vertically pass through the first to fourth vibration layers 111-1 to 111-4 to correspond to the first connection member 119A and may be formed (or configured) to vertically pass through the first sub-electrode 113b1 of each of the electrode layers 113-1, 113-3, and 113-5 of the first group 113G1 among the plurality of electrode layers 113-1 to 113-5. For example, the one or more first holes 1 10h1 may be formed (or configured) to vertically pass through each of the first to fourth vibration layers 111-1 to 111-4, vertically pass through the first extension pattern 113e1 of the first sub-electrode 113b1 of each of the first, third, and fifth electrode layers 113-1, 113-3, and 113-5, and vertically pass through the second connection pattern 112b of each of the second and fourth electrode layers 113-2 and 113-4. For example, the one or more first holes 110h1 may be a first via hole, a first through hole, or a first contact hole, but examples of the present disclosure are not limited thereto.

The one or more second holes 110h2 may vertically pass through the first to fourth vibration layers 111-1 to 111-4 to correspond to the second connection member 119B and may be formed (or configured) to vertically pass through the first sub-electrode 113b1 of each of the electrode layers 113-2 and 113-4 of the second group 113G2 among the plurality of electrode layers 113-1 to 113-5. For example, the one or more second holes 110h2 may be formed (or configured) to vertically pass through each of the first to fourth vibration layers 111-1 to 111-4, vertically pass through the second extension pattern 113e2 of the second sub-electrode 113b2 of each of the second and fourth electrode layers 113-2 and 113-4, and vertically pass through the first connection pattern 112a of the first electrode layer 113-1 and the third connection pattern 112c of each of the third and fifth electrode layers 113-3 and 113-5. For example, the one or more second holes 110h2 may be a second via hole, a second through hole, or a second contact hole, but examples of the present disclosure are not limited thereto.

According to an example of the present disclosure, the first connection member 119A may be filled in the one or more first holes 110h1, and thus, may be electrically (or in common) connected to the first extension pattern 113e1 of the first sub-electrode 113b1 of each of the first, third, and fifth electrode layers 113-1, 113-3, and 113-5 and may be electrically (or in common) connected to the second connection pattern 112b of each of the second and fourth electrode layers 113-2 and 113-4. Accordingly, the first, third, and fifth electrode layers 113-1, 113-3, and 113-5 may receive in common a driving signal (or sound signal or voice sound signal) supplied from a signal supply member 190 through the first connection member 119A filled in the one or more first holes 110h1.

According to an example of the present disclosure, the second connection member 119B may be filled in the one or more second holes 110h2, and thus, may be electrically (or in common) connected to the second extension pattern 113e2 of the second sub-electrode 113b2 of each of the second and fourth electrode layers 113-2 and 113-4 and may be electrically (or in common) connected to the first connection pattern 112a of the first electrode layer 113-1, and the third connection pattern 112c of each of the third, and fifth electrode layers 113-3, and 113-5. Accordingly, the second and fourth electrode layers 113-2 and 113-4 may receive in common the driving signal

(or sound signal or voice sound signal) supplied from the signal supply member 190 through the first connection member 119A filled in the one or more second holes 110h2.

Each of the first and second connection member 119A and 119B according to an example of the present disclosure may be configured as a conductive material or a conductive adhesive. For example, the conductive material of each of the first and second connection members 119A and 119B may include a thermos-curable electrode material, a photo-curable (or ultraviolet (UV)-curable) electrode material, or a solution-type electrode material, but examples of the present disclosure are not limited thereto. For example, the electrode material of each of the first and second connection members 119A and 119B may include silver (Ag), nickel (Ni), an Ag alloy, or a Ni alloy, but examples of the present disclosure are not limited thereto. For example, each of the first and second connection members 119A and 119B may be configured in a silver (Ag) paste. For example, the conductive adhesive may include a conductive epoxy resin, a conductive acrylic resin, a conductive silicone resin, or a conductive urethane resin, but examples of the present disclosure are not limited thereto.

The vibration apparatus 100 according to the fifteenth example of the present disclosure may have the same effect as the vibration apparatus 100 described above with reference to FIGs. 1 to 7.

The first and second connection members 119A and 119B of a hole contact type described above with reference to FIGs. 46 to 50 may be identically applied to the vibration apparatuses according to the second to eleventh examples of the present disclosure described above with reference to FIGs. 8 to 37. For example, the first and second connection members 118A and 118B of an edge contact type described above with reference to FIGs. 8 to 37 may be changed to the first and second connection members 119A and 119B of a hole contact type described above with reference to FIGs. 46 to 50, and in this case, the electrode layers 113-1 to 113-5 and the vibration layers 111-1 to 111-4 described above with reference to FIGs. 8 to 37 may further include one or more first and second holes corresponding to each of the first and second connection members 119A and 119B of a hole contact type, and thus, their descriptions are omitted.

The third and fourth connection members 118C and 118D of an edge contact type described above with reference to FIGs. 10 to 12 and 35 to 37 may be changed to the first and second connection members 119A and 119B of a hole contact type described above with reference to FIGs. 46 to 50, and in this case, the electrode layers 113-1 to 113-5 and the vibration layers 111-1 to 111-4 described above with reference to FIGs. 10 to 12 and 35 to 37 may further include one or more third and fourth holes corresponding to each of the third and fourth connection members 119A and 119B of a hole contact type, and thus, their descriptions are omitted.

The first and second connection members 119A and 119B of a hole contact type described above with reference to FIGs. 46 to 50 may be identically applied to the vibration apparatuses according to the twelfth example of the present disclosure described above with reference to FIGs. 38 to 41. For example, the first and second connection members 118A and 118B of an edge contact type described above with reference to FIGs. 38 to 41 may be changed to the first and second connection members 119A and 119B of a hole contact type described above with reference to FIGs. 46 to 50, and in this case, the electrode layers 113-1 to 113-4, the vibration layers 111-1 to 111-4, and the bonding member 115 (or the first to third bonding members 115-1, 115-2, 115-3) described above with reference to FIGs. 38 to 41 may further include one or more first and second holes corresponding to each of the first and second connection members 119A and 119B of a hole contact type, and thus, their descriptions are omitted.

The first and second connection members 119A and 119B of a hole contact type described above with reference to FIGs. 46 to 50 may be identically applied to the vibration apparatuses according to the thirteenth example of the present disclosure described above with reference to FIGs. 42 to 45. For example, the first and second connection members 118A and 118B of an edge contact type described above with reference to FIGs. 42 to 45 may be changed to the first and second connection members 119A and 119B of a hole contact type described above with reference to FIGs. 46 to 50, and in this case, the electrode layers 113-1 to 113-4, the vibration layers 111-1 to 111-4, and the bonding member 117 (or the first to third bonding members 117-1, 117-2, 117-3) described above with reference to FIGs. 42 to 45 may further include one or more first and second holes corresponding to each of the first and second connection members 119A and 119B of a hole contact type, and thus, their descriptions are omitted.

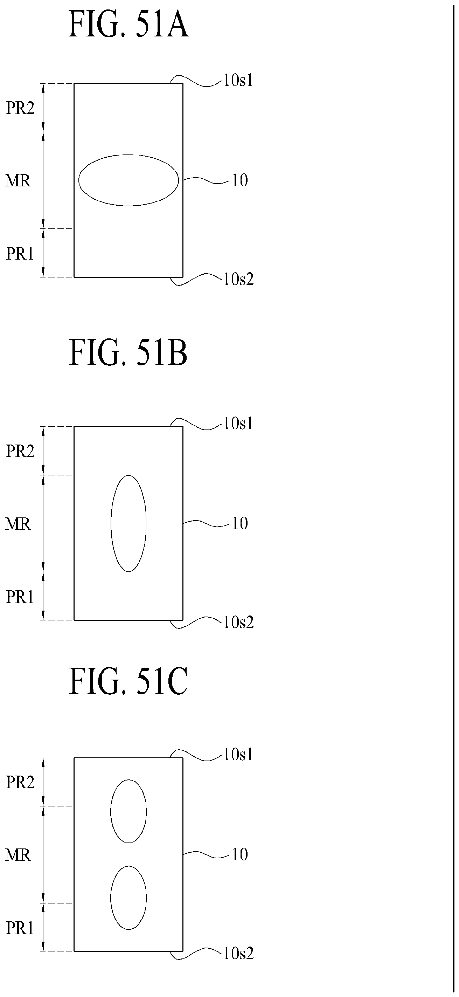

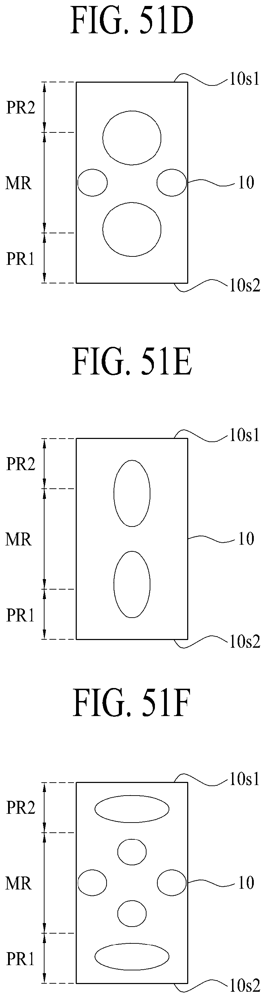

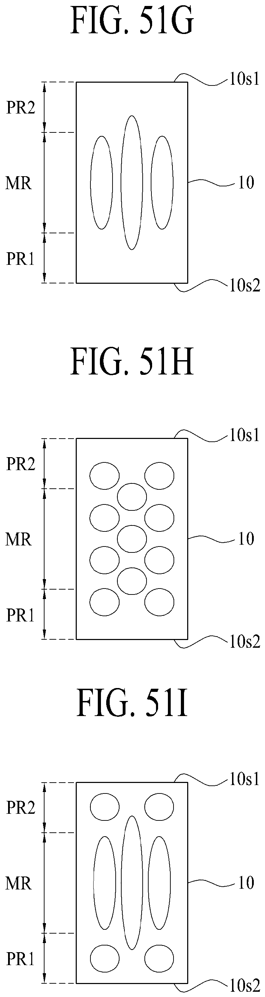

FIGs. 51A to 51I illustrate a main vibration region having a vibration mode shape based on a frequency-based driving signal, in a vibration apparatus according to an experiment example. The vibration apparatus according to the experiment example may include a vibration layer having a reference thickness and a reference size and upper and lower electrode layers having the same size as that of the vibration layer. In each of FIGs. 51A to 51I, an oval portion and/or a circular portion represent a maximum vibration region (or displacement region) which is concave or convex. FIG. 51A illustrates a main vibration region corresponding to a vibration mode shape based on a driving signal of 200 Hz. FIG. 51B illustrates a main vibration region corresponding to a vibration mode shape based on a driving signal of 470 Hz. FIG. 51C illustrates a main vibration region corresponding to a vibration mode shape based on a driving signal of 900 Hz. FIG. 51D illustrates a main vibration region corresponding to a vibration mode shape based on a driving signal of 1.3 kHz. FIG. 51E illustrates a main vibration region corresponding to a vibration mode shape based on a driving signal of 2 kHz. FIG. 51F illustrates a main vibration region corresponding to a vibration mode shape based on a driving signal of 2.9 kHz. FIG. 51G illustrates a main vibration region corresponding to a vibration mode shape based on a driving signal of 3.7 kHz. FIG. 51H illustrates a main vibration region corresponding to a vibration mode shape based on a driving signal of 4.6 kHz. FIG. 51I illustrates a main vibration region corresponding to a vibration mode shape based on a driving signal of 7.3 kHz.

With reference to FIGs. 51A to 51I, in a vibration mode shape based on a frequency-based driving signal of a vibration apparatus 10 according to the experiment example, it may be seen that a main vibration region is based on a frequency of the driving signal. For example, it may be seen that the main vibration region based on the frequency-based driving signal is disposed in a middle region MR of the vibration apparatus 10. Accordingly, the middle region MR of the vibration apparatus 10 may be the main vibration region, and the other regions PA1 and PA2, except the middle region MR, of the vibration apparatus 10 may be an effective vibration region.

In a case where an electrode layer of the vibration apparatus 10 is patterned to be disposed in the middle region MR of the vibration apparatus 10, a sound characteristic and a sound pressure level characteristic of a low-pitched sound band may be enhanced. In a case where the electrode layer of the vibration apparatus 10 is patterned to be additionally disposed in peripheral regions PA1 and PA2 adjacent to the middle region MR, a sound characteristic and a sound pressure level characteristic of a high-pitched sound band may be additionally enhanced.

Therefore, as described above with reference to FIGs. 1 to 37, the vibration apparatuses 100 according to the first to twelfth examples of the present disclosure may include an electrode layer which is patterned to the main vibration region and the effective vibration region or the main vibration region corresponding to the vibration mode shape based on the frequency-based driving signal of the vibration apparatus 10 according the experiment example, and thus, a sound characteristic and a sound pressure level characteristic of a low-pitched sound band may be enhanced, or a sound characteristic and a sound pressure level characteristic of a low-pitched sound band and a high-pitched sound band may be enhanced.

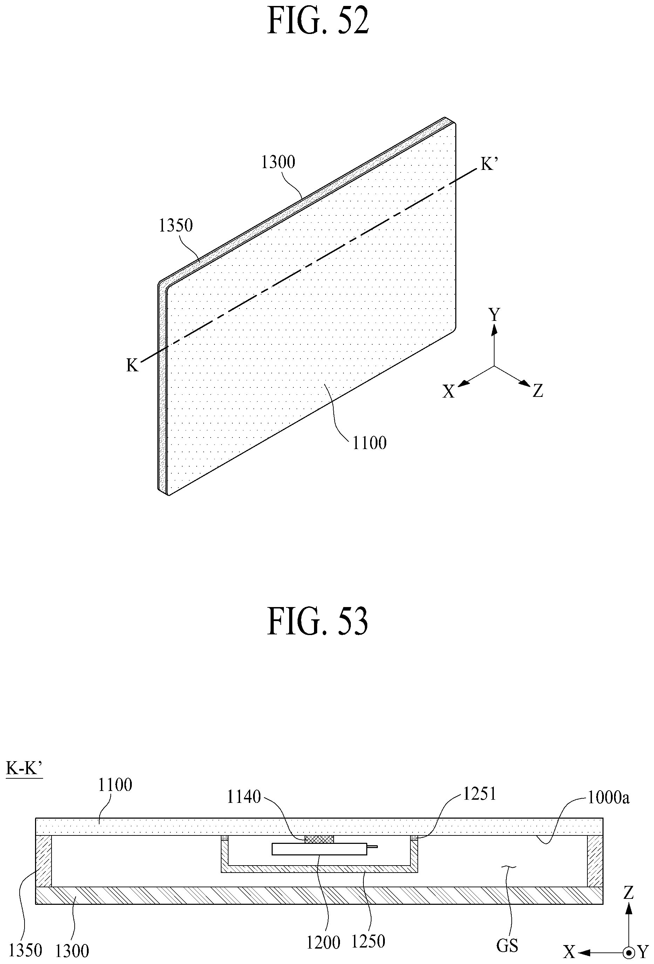

FIG. 52 illustrates an electronic apparatus according to an example of the present disclosure. FIG. 53 is a cross-sectional view taken along line K-K' illustrated in FIG. 52 according to an example of the present disclosure

With reference to FIGs. 52 and 53, the electronic apparatus according to an example of the present disclosure may include a passive vibration member 1100 and one or more vibration generating apparatuses 1200.

The "electronic apparatus" according to an example of the present disclosure may be applied to implement a display apparatus, a sound apparatus, a sound generating apparatus, a sound bar, an analog signage, or a digital signage, or the like, but examples of the present disclosure are not limited thereto.

The display apparatus may include a display panel which includes a plurality of pixels for implementing a black/white or color image, and a driver for driving the display panel. For example, the display panel may be a liquid crystal display panel, an organic light emitting display panel, a light emitting diode display panel, an electrophoresis display panel, an electro-wetting display panel, a micro light emitting diode display panel, or a quantum dot light emitting display panel, or the like, but examples of the present disclosure are not limited thereto. For example, in the organic light emitting display panel, a pixel may include an organic light emitting device having an organic light emitting layer or the like, and the pixel may be a subpixel which implements any one of a plurality of colors configuring a color image. Accordingly, the "electronic apparatus" according to an example of the present disclosure may include a set electronic apparatus or a set device (or a set apparatus) such as a notebook computer, a television, a computer monitor, an equipment apparatus including an automotive apparatus or another type apparatus for vehicles, or a mobile electronic apparatus such as a smartphone or an electronic pad, or the like, which is a complete product (or a final product) including the display panel such as the liquid crystal display panel or the organic light emitting display panel, or the like.

The analog signage may be an advertising signboard, a poster, a noticeboard, or the like. The analog signage may include signage content such as a sentence, a picture, and a sign, or the like. The signage content may be disposed at the passive vibration member 1100 of the apparatus to be visible. For example, the signage content may be directly attached on the passive vibration member 1100 and the signage content may be printed or the like on a medium such as paper, and the medium may be attached on the passive vibration member 1100.

The passive vibration member 1100 may vibrate based on driving (or vibration) of the one or more vibration generating apparatuses 1200. For example, the passive vibration member 1100 may generate one or more of a vibration and a sound based on driving of the one or more vibration generating apparatuses 1200.

The passive vibration member 1100 according to an example of the present disclosure may be a display panel including a display part (or a screen) including a plurality of pixels which implement a black/white or color image. Therefore, the passive vibration member 1100 may generate one or more of a vibration and a sound based on driving of the one or more vibration generating apparatuses 1200. For example, the passive vibration member 1100 may vibrate based on driving of the vibration generating apparatus 1200 while displaying an image on the display area, thereby generating or outputting a sound synchronized with the image in the display area. For example, the passive vibration member 1100 may be a vibration object, a display member, a display panel, a signage panel, a passive vibration plate, a front cover, a front member, a vibration panel, a sound panel, a passive vibration panel, a sound output plate, a sound vibration plate, or an image screen, or the like, but examples of the present disclosure are not limited thereto.

The passive vibration member 1100 according to another example of the present disclosure may be a vibration plate which includes a metal material or a nonmetal material or a composite nonmetal material having a material characteristic suitable for being vibrated by the one or more vibration generating apparatuses 1200 to output sound. For example, the passive vibration member 1100 may include a vibration plate including one or more materials of metal, plastic, wood, paper, fiber, cloth, leather, glass, rubber, carbon and mirror. For example, the paper may be cone paper for speakers. For example, the cone paper may be pulp or foamed plastic, or the like, but examples of the present disclosure are not limited thereto.

The passive vibration member 1100 according to another example of the present disclosure may include a display panel including a pixel which displays an image, or may include a non-display panel. For example, the passive vibration member 1100 may include one or more of a display panel including a pixel displaying an image, a screen panel on which an image is to be projected from a display apparatus, a lighting panel, a signage panel, a vehicular interior material, a vehicular exterior material, a vehicular glass window, a vehicular seat interior material, a building ceiling material, a building exterior material, a building interior material, a building glass window, an aircraft interior material, an aircraft glass window, and a mirror, but examples of the present disclosure are not limited thereto. For example, the non-display panel may be a light emitting diode lighting panel (or apparatus), an organic light emitting lighting panel (or apparatus), or an inorganic light emitting lighting panel (or apparatus), but examples of the present disclosure are not limited thereto.

The one or more vibration generating apparatuses 1200 may be configured to vibrate the passive vibration member 1100. The one or more vibration generating apparatuses 1200 may be configured to be connected to a rear surface 1000a of the passive vibration member 1100 by a supporting member 1140. Accordingly, the one or more vibration generating apparatuses 1200 may vibrate the passive vibration member 1100 to generate or output one or more of a vibration and a sound based on a vibration of the passive vibration member 1100.

The one or more vibration generating apparatuses 1200 may include one or more of the vibration apparatus described above with reference to FIGs. 1 to 50. Accordingly, descriptions of the vibration apparatus described above with reference to FIGs. 1 to 50 may be included in descriptions of the vibration generating apparatus 1200 illustrated in FIGs. 52 and 53, and thus, like reference numerals refer to like elements, and repeated descriptions may be omitted.

The supporting member 1140 may be disposed between the vibration generating apparatus 1200 and the passive vibration member 1100. The supporting member 1140 may be disposed between at least a portion of the vibration generating apparatus 1200 and the passive vibration member 1100. For example, the supporting member 1140 may be a support part, a transmission member, a vibration transmission member, a panel connection member, or a panel coupling member.

The supporting member 1140 according to an example of the present disclosure may be connected between the passive vibration member 1100 and a center portion, except a periphery portion, of the vibration generating apparatus 1200, but examples of the present disclosure are not limited thereto.

According to an example of the present disclosure, the supporting member 1140 may be connected between the passive vibration member 1100 and the center portion of the vibration generating apparatus 1200 based on a partial attachment scheme (or a partial bonding scheme). The center portion (or a central portion) of the vibration generating apparatus 1200 may be a center of a vibration, and thus, a vibration of the vibration generating apparatus 1200 may be effectively transferred to the passive vibration member 1100 through (or by) the supporting member 1140. A periphery portion of the vibration generating apparatus 1200 may be spaced apart from each of the supporting member 1140 and the passive vibration member 1100 and lifted without being connected to the supporting member 1140 and/or the passive vibration member 1100, and thus, in a flexural vibration (or a bending vibration) of the vibration generating apparatus 1200, a vibration of a periphery portion of the vibration generating apparatus 1200 may be prevented (or reduced) by the supporting member 1140 and/or the passive vibration member 1100, whereby a vibration amplitude (or a displacement amplitude) of the vibration generating apparatus 1200 may increase. Accordingly, a vibration amplitude (or a displacement amplitude) of the passive vibration member 1100 based on a vibration of the vibration generating apparatus 1200 may increase, and thus, a sound characteristic and/or a sound pressure level characteristic of a sound band including a low-pitched sound band generated based on a vibration of the passive vibration member 1100 may be more enhanced.

The supporting member 1140 according to another example of the present disclosure may be connected between the passive vibration member 1100 and an edge portion (or a periphery portion), except a center portion, of the vibration generating apparatus 1200. For example, the supporting member 1140 may be connected between the passive vibration member 1100 and the edge portion (or the periphery portion) of the vibration generating apparatus 1200 adjacent to a short side of the vibration generating apparatus 1200.

The supporting member 1140 according to another example of the present disclosure may be connected to or attached on an entire front surface of each of the one or more vibration generating apparatuses 1200 and the rear surface 1000a of the passive vibration member 1100 based on an entire surface attachment scheme (or an entire surface bonding scheme).

The supporting member 1140 according to an example of the present disclosure may be configured as a material including an adhesive layer which is good in adhesive force or attaching force with respect to each of the one or more vibration generating apparatuses 1200 and a rear surface of the display panel or a rear surface 1000a of the passive vibration member 1100. For example, the supporting member 1140 may include a foam pad, a double-sided tape, a double-sided foam tape, or an adhesive, or the like, but examples of the present disclosure are not limited thereto. For example, the adhesive layer of the supporting member 1140 may include epoxy, acrylic, silicone, or urethane, but examples of the present disclosure are not limited thereto. For example, the adhesive layer of the supporting member 1140 may include an acrylic-based material (or substance) having a characteristic where an adhesive force is relatively better and hardness is higher than urethane. Accordingly, a vibration of one or more vibration generating apparatuses 1200 may be efficiently transferred to the passive vibration member 1100.

According to another example of the present disclosure, the supporting member 1140 may be omitted. For example, the one or more vibration generating apparatuses 1200 may be directly connected (or coupled) or adhered (or attached) to the rear surface 1000a of the passive vibration member 1100 without a separate intermediate member such as the supporting member 1140. In this case, the vibration apparatus 100 configuring the vibration generating apparatuses 1200 may include a vibration generating part 110, a first adhesive layer 133, a second adhesive layer 135, and a first cover member 131 in the structures illustrated in FIGs. 6 and 7. For example, when one or more vibration generating apparatuses 1200 are directly connected (or coupled) or adhered (or attached) to the rear surface 1000a of the passive vibration member 1100 without a separate intermediate member such as the supporting member 1140, the second cover member 137 is omitted from the vibration apparatus 100 illustrated in FIGs. 6 and 7. Accordingly, the vibration apparatus 100 configuring the vibration generating apparatuses 1200 may be directly connected (or coupled) or adhered (or attached) to the rear surface 1000a of the passive vibration member 1100 through the second adhesive layer 135. For example, when the second adhesive layer 135 of the vibration apparatus 100 includes the hot melt adhesive, the second adhesive layer 135 of the vibration apparatus 100 configuring the vibration generating apparatuses 1200 may be connected (or coupled) or adhered (or attached) to the rear surface 1000a of the passive vibration member 1100 by a laminating process using one or more of heat and pressure.

The electronic apparatus according to an example of the present disclosure may further include a rear member 1300 and a coupling member 1350.

The rear member 1300 may be disposed at the rear surface 1000a of the passive vibration member 1100. The rear member 1300 may be disposed at the rear surface 1000a of the passive vibration member 1100 to cover the one or more vibration generating apparatuses 1200. The rear member 1300 may be disposed at the rear surface 1000a of the passive vibration member 1100 to cover all of the rear surface 1000a of the passive vibration member 1100 and the one or more vibration generating apparatuses 1200. For example, the rear member 1300 may have a same size as the passive vibration member 1100. For example, the rear member 1300 may cover an entire rear surface of the passive vibration member 1100 with a gap space GS and the one or more vibration generating apparatuses 1200 therebetween. The gap space GS may be provided by the coupling member 1350 disposed between the passive vibration member 1100 and the rear member 1300 facing each other. The gap space GS may be referred to as an air gap, an accommodating space, a vibration space, or a sound sounding box, but examples of the present disclosure are not limited thereto.

The rear member 1300 may include any one material of a glass material, a metal material, and a plastic material, but examples of the present disclosure are not limited thereto. For example, the rear member 1300 may include a stacked structure in which one or more of a glass material, a plastic material, and a metal material is stacked thereof, but examples of the present disclosure are not limited thereto.

Each of the passive vibration member 1100 and the rear member 1300 may have a square shape or a rectangular shape, but examples of the present disclosure are not limited thereto. For example, each of the passive vibration member 1100 and the rear member 1300 may have a polygonal shape, a non-polygonal shape, a circular shape, or an oval shape. For example, when the electronic apparatus according to an example of the present disclosure is applied to a sound apparatus or a sound bar, each of the passive vibration member 1100 and the rear member 1300 may have a rectangular shape where a length of a long side is twice or more times longer than a short side, but examples of the present disclosure are not limited thereto.

The coupling member 1350 may be configured to be connected between a rear periphery portion of the passive vibration member 1100 and a front periphery portion of the rear member 1300, and thus, the gap space GS may be provided between the passive vibration member 1100 and the rear member 1300 facing each other.

The coupling member 1350 according to an example of the present disclosure may include an elastic material which has adhesive properties and is capable of compression and decompression. For example, the coupling member 1350 may include a double-sided tape, a single-sided tape, a double-sided foam tape, or a double-sided adhesive foam pad, but examples of the present disclosure are not limited thereto. For example, the coupling member 1350 may include an elastic pad such as a rubber pad or a silicone pad, or the like, which has adhesive properties and is capable of compression and decompression. For example, the coupling member 1350 may be formed by elastomer.

The rear member 1300 according to another example of the present disclosure may further include a sidewall part which supports a rear periphery portion of the passive vibration member 1100. The sidewall part of the rear member 1300 may protrude or be bent toward the rear periphery portion of the passive vibration member 1100 from the front periphery portion of the rear member 1300, and thus, the gap space GS may be provided between the passive vibration member 1100 and the rear member 1300. For example, the coupling member 1350 may be configured to be connected between the sidewall part of the rear member 1300 and the rear periphery portion of the passive vibration member 1100. Accordingly, the rear member 1300 may cover the one or more vibration generating apparatuses 1200 and may support the rear surface 1000a of the passive vibration member 1100. For example, the rear member 1300 may cover the one or more vibration generating apparatuses 1200 and may support the rear periphery portion of the passive vibration member 1100.

According to another example of the present disclosure, the passive vibration member 1100 may further include a sidewall part which is connected to a front periphery portion of the rear member 1300. The sidewall part of the passive vibration member 1100 may protrude or be bent toward the front periphery portion of the rear member 1300 from the rear periphery portion of the passive vibration member 1100, and thus, the gap space GS may be provided between the passive vibration member 1100 and the rear member 1300. A stiffness of the passive vibration member 1100 may be increased based on the sidewall part. For example, the coupling member 1350 may be configured to be connected between the sidewall part of the passive vibration member 1100 and the front periphery portion of the rear member 1300. Accordingly, the rear member 1300 may cover the one or more vibration generating apparatuses 1200 and may support the rear surface 1000a of the passive vibration member 1100. For example, the rear member 1300 may cover the one or more vibration generating apparatuses 1200 and may support the rear periphery portion of the passive vibration member 1100.

The electronic apparatus according to an example of the present disclosure may further include one or more enclosure 1250.

The enclosure 1250 may be connected or coupled to the rear periphery portion of the passive vibration member 1100 to individually cover the one or more vibration generating apparatuses 1200. For example, the enclosure 1250 may be connected or coupled to the rear surface 1000a of the passive vibration member 1100 by an adhesive member 1251. The enclosure 1250 may configure a closed space which covers or surrounds the one or more vibration generating apparatuses 1200 at the rear surface 1000a of the passive vibration member 1100. For example, the enclosure 1250 may be a case, an outer case, a case member, a housing member, a cabinet, a closed member, a closed cap, a closed box, or a sound box, but examples of the present disclosure are not limited thereto. The closed space may be an air gap, a vibration space, a sound space, or a sound sounding box, but examples of the present disclosure are not limited thereto.

The enclosure 1250 may include one or more materials of a metal material and a nonmetal material (or a composite nonmetal material). For example, the enclosure 1250 may include one or more materials of a metal, plastic, carbon, and wood, but examples of the present disclosure are not limited thereto.

The enclosure 1250 according to an example of the present disclosure may maintain an impedance component based on air acting on the passive vibration member 1100 when the passive vibration member 1100 or the vibration generating apparatus 1200 is vibrating. For example, air around the passive vibration member 1100 may resist a vibration of the passive vibration member 1100 and may act as an impedance component having a reactance component and a resistance based on a frequency. Therefore, the enclosure 1250 may configure a closed space which surrounds the one or more vibration generating apparatuses 1200, in the rear surface 1000a of the passive vibration member 1100, and thus, may maintain an impedance component (or an air impedance or an elastic impedance) acting on the passive vibration member 1100 based on air, thereby enhancing a sound characteristic and/or a sound pressure level characteristic of a sound band including the low-pitched sound band and enhancing the quality of a sound of a high-pitched sound band.

The adhesive member 1251 may be configured to minimize or prevent vibration of the passive vibration member 1100 from being transferred to the enclosure 1250. The adhesive member 1251 may include a material characteristic suitable for blocking a vibration. For example, the adhesive member 1251 may include a material having elasticity. For example, the adhesive member 1251 may include a material having elasticity for vibration absorption (or impact absorption). The adhesive member 1251 according to an example of the present disclosure may be configured as polyurethane material or polyolefin material, but examples of the present disclosure are not limited thereto. For example, the adhesive member 1251 may include one or more of an adhesive, a double-sided tape, a double-sided foam tape, a double-sided foam pad, and a double-sided cushion tape, but examples of the present disclosure are not limited thereto.

Comparison results of an electrode area ratio and an average sound pressure level of vibration apparatuses according to experiment examples 1 to 7 and a vibration apparatus according to a reference example are shown in the following Table 1.

**[Table 1]**

| | Vibration layer thickness ratio (%) | Electrode area ratio (%) | Average sound pressure level (dB) (150Hz to 1kHz) | Average sound pressure level (dB) (150Hz to 8kHz) |
|---|---|---|---|---|
| Reference example | 100% | 100% | 83.3 | 83.1 |
| Experiment example 1 | 66% | 66% | 82.3 | 83.2 |
| Experiment example 2 | 66% | 66% | 81.8 | 82.9 |
| Experiment example 3 | 66% | 66% | 81.8 | 83.1 |
| Experiment example 4 | 66% | 66% | 81.4 | 82.0 |
| Experiment example 5 | 66% | 66% | 81.0 | 81.5 |
| Experiment example 6 | 66% | 66% | 79.2 | 82.5 |
| Experiment example 7 | 66% | 66% | 81.1 | 82.9 |

In Table 1, each of the vibration apparatuses according to the experiment examples 1 to 7 and the vibration apparatus according to the reference example may include three electrode layers and two vibration layers each disposed between two adjacent electrode layers of the three electrode layers. The electrode layer of each of the vibration apparatuses according to the experiment examples 1 to 7 may have a small area which is about 34% of an area of the electrode layer of the vibration apparatus according to the reference example. Also, the vibration layer of each of the vibration apparatuses according to the experiment examples 1 to 7 may have a thin thickness which is about 34% of a thickness of the vibration layer of the vibration apparatus according to the reference example. In Table 1, the vibration apparatus according to the reference example may include a vibration layer having a reference thickness and a reference size and upper and lower electrode layers having the same size as that of the vibration layer. The vibration apparatus according to the experiment example 1 may have an electrode pattern structure described above with reference to FIGs. 1 to 7, the vibration apparatus according to the experiment example 2 may have an electrode pattern structure described above with reference to FIGs. 13 to 15, the vibration apparatus according to the experiment example 3 may have an electrode pattern structure described above with reference to FIGs. 16 and 17, the vibration apparatus according to the experiment example 4 may have an electrode pattern structure described above with reference to FIGs. 18 and 19, the vibration apparatus according to the experiment example 5 may have an electrode pattern structure described above with reference to FIGs. 20 to 22, the vibration apparatus according to the experiment example 6 may have an electrode pattern structure described above with reference to FIGs. 23 to 25, and the vibration apparatus according to the experiment example 7 may have an electrode pattern structure described above with reference to FIGs. 26 to 28.

Each of the vibration apparatuses according to the experiment examples 1 to 7 and the vibration apparatus according to the reference example may have the same capacitance.

With reference to Table 1, it may be seen that each of the vibration apparatuses according to the experiment examples 1 to 7 has an average sound pressure level similar to that of the vibration apparatus according to the reference example in a pitched sound band of 150 Hz to 1 kHz and a pitched sound band of 150 Hz to 8 kHz. The vibration apparatuses according to the experiment examples 1 to 7 may include a vibration layer which is thin by about 34% and an electrode layer having an area which is small by about 34%, with respect to the vibration apparatus according to the reference example, and thus, may have the same capacitance and sound pressure level characteristic as those of the vibration apparatus according to the reference example.

Therefore, a vibration apparatus according to one or more examples of the present disclosure may be reduced in thickness of a vibration layer, may have a relatively low capacitance based on a patterning structure of an electrode layer, and may be slimmed, in a stack structure where a plurality of vibration layers are vertically stacked.

Comparison results of an electrode area ratio and an average sound pressure level of a vibration apparatus according to an experiment example 8 and a vibration apparatus according to a reference example is shown in the following Table 2.

**[Table 2]**

| | Vibration layer thickness ratio (%) | Electrode area ratio (%) | Average sound pressure level (dB) (150Hz to 1kHz) | Average sound pressure level (dB) (150Hz to 8kHz) |
|---|---|---|---|---|
| Reference example | 100% | 100% | 77.6 | 79.2 |
| Experiment example 8 | 100% | 66% | 76.8 | 78.1 |

In Table 2, each of the vibration apparatus according to the experiment example 8 and the vibration apparatus according to the reference example may include two electrode layers and a vibration layer disposed between the two electrode layers. The electrode layer of the vibration apparatus according to the experiment example 8 may have a small area which is about 34% of an area of the electrode layer of the vibration apparatus according to the reference example. Also, the vibration layer of the vibration apparatus according to the experiment example 8 may have the same thickness as that of the vibration layer of the vibration apparatus according to the reference example.

With reference to Table 2, it may be seen that the vibration apparatus according to the experiment example 8 has an average sound pressure level similar to that of the vibration apparatus according to the reference example in a pitched sound band of 150 Hz to 1 kHz and a pitched sound band of 150 Hz to 8 kHz. The vibration apparatus according to the experiment example 8 may include an electrode layer having an area which is small by about 34%, with respect to the vibration apparatus according to the reference example, and thus, may have a capacitance which is about 34% smaller than that of the vibration apparatus according to the reference example.

Therefore, a vibration apparatus according to one or more examples of the present disclosure may have a relatively low capacitance based on a patterning structure of an electrode layer, in a stack structure where a plurality of vibration layers are vertically stacked.

A vibration apparatus and an electronic apparatus including the same according to an example of the present disclosure will be described below.

The vibration apparatus according to one or more examples of the present disclosure may comprise a vibration generating part, the vibration generating part may comprise a plurality of electrode layers; a plurality of vibration layers between the plurality of electrode layers, the plurality of vibration layers including a piezoelectric material; a first connection member configured to be electrically connected to an electrode layer in a first group among the plurality of electrode layers; and a second connection member configured to be electrically connected to an electrode layer in a second group among the plurality of electrode layers, and each of the plurality of electrode layers may be configured to have a shape, which differs from a shape of each of the plurality of vibration layers, and a size which is smaller than a size of each of the plurality of vibration layers.

According to one or more examples of the present disclosure, each of the plurality of vibration layers may be configured to two-dimensionally have a tetragonal shape, and each of the plurality of electrode layers may be configured to two-dimensionally have a non-tetragonal shape.

According to one or more examples of the present disclosure, each of the plurality of electrode layers may comprise a main electrode and a sub-electrode protruding from the main electrode, and a ratio of a size of the main electrode to a size of the sub-electrode may be 10:8 to 10:2.

According to one or more examples of the present disclosure, the vibration generating part may further comprise a first connection pattern disposed at an uppermost electrode layer of the plurality of electrode layers and electrically connected to the second connection member.

According to one or more examples of the present disclosure, each of the plurality of vibration layers may be disposed between two electrode layers vertically adjacent to each other among the plurality of electrode layers.

According to one or more examples of the present disclosure, a vibration layer in a first group among the plurality of vibration layers may have a same poling direction, a vibration layer in a second group among the plurality of vibration layers may have a same poling direction, and the vibration layer in the second group may have a poling direction which is different from or opposite to a poling direction of the vibration layer in the first group.

According to one or more examples of the present disclosure, the first connection member and the second connection member may be disposed at one lateral surface of the vibration generating part.

According to one or more examples of the present disclosure, each of the plurality of electrode layers may comprise a main electrode and a sub-electrode protruding from the main electrode, the first connection member may be electrically connected to the sub-electrode of the electrode layer in the first group, and the second connection member may be electrically connected to the sub-electrode of the electrode layer in the second group.

According to one or more examples of the present disclosure, the electrode layer in the second group may further comprise a second connection pattern electrically disconnected from the sub-electrode and electrically connected to the second connection member, and the electrode layer in the first group may further comprise a third connection pattern electrically disconnected from the sub-electrode and electrically connected to the first connection member.

According to one or more examples of the present disclosure, the first connection member may pass through the plurality of vibration layers and may be configured to be electrically connected to the electrode layer in the first group, and the second connection member may pass through the plurality of vibration layers and may be configured to be electrically connected to the electrode layer in the second group.

According to one or more examples of the present disclosure, the vibration generating part may further comprise a first connection pattern disposed at an uppermost electrode layer of the plurality of electrode layers and electrically connected to the second connection member.

According to one or more examples of the present disclosure, each of the plurality of electrode layers may comprise a main electrode and a sub-electrode protruding from the main electrode, the vibration generating part may further comprise one or more first holes configured to pass through the plurality of vibration layers and the sub-electrode of the electrode layer in the first group; and one or more second holes configured to pass through the plurality of vibration layers and the sub-electrode of the electrode layer in the second group, the first connection member may be filled in the one or more first holes and may be electrically connected to the electrode layer in the first group, and the second connection member may be filled in the one or more second holes and may be electrically connected to the electrode layer in the second group.

According to one or more examples of the present disclosure, the electrode layer of the second group may further comprise a second connection pattern electrically disconnected from the sub-electrode and electrically connected to the second connection member, the electrode layer of the first group may further comprise a third connection pattern electrically disconnected from the sub-electrode and electrically connected to the first connection member, the one or more first holes may pass through the second connection pattern, and the one or more second holes may pass through the third connection pattern.

According to one or more examples of the present disclosure, the vibration apparatus may further comprise a bonding member disposed between two vibration layers vertically adjacent to each other among the plurality of vibration layers, two electrode layers vertically adjacent to each other among the plurality of electrode layers may be disposed between two vibration layers vertically adjacent to each other, and the bonding member may be disposed between two electrode layers vertically adjacent to each other.

According to one or more examples of the present disclosure, two electrode layers vertically adjacent to each other with the bonding member therebetween and the bonding member may have a same shape.

According to one or more examples of the present disclosure, the bonding member may comprise a conductive adhesive material.

According to one or more examples of the present disclosure, the vibration layer in the first group among the plurality of vibration layers may have a same poling direction, the vibration layer in the second group among the plurality of vibration layers may have a same poling direction, and the vibration layer in the second group may have a poling direction which is different from or opposite to a poling direction of the vibration layer in the first group.

According to one or more examples of the present disclosure, the vibration generating part may further comprise a first connection pattern disposed at an uppermost electrode layer of the plurality of electrode layers and electrically connected to the second connection member.

According to one or more examples of the present disclosure, the first connection member and the second connection member may be disposed at one lateral surface of the vibration generating part.

According to one or more examples of the present disclosure, each of the plurality of electrode layers may comprise a main electrode and a sub-electrode protruding from the main electrode, the first connection member may be electrically connected to the sub-electrode of the electrode layer in the first group, and the second connection member may be electrically connected to the sub-electrode of the electrode layer in the second group.

According to one or more examples of the present disclosure, the electrode layer of the second group may further comprise a second connection pattern electrically disconnected from the sub-electrode and electrically connected to the second connection member, and the electrode layer of the first group may further comprise a third connection pattern electrically disconnected from the sub-electrode and electrically connected to the first connection member.

According to one or more examples of the present disclosure, the first connection member may pass through the plurality of vibration layers and may be configured to be electrically connected to the electrode layer in the first group, and the second connection member may pass through the plurality of vibration layers and may be configured to be electrically connected to the electrode layer in the second group.

According to one or more examples of the present disclosure, the vibration generating part may further comprise a first connection pattern disposed at an uppermost electrode layer of the plurality of electrode layers and electrically connected to the second connection member.

According to one or more examples of the present disclosure, each of the plurality of electrode layers may comprise a main electrode and a sub-electrode protruding from the main electrode, the vibration generating part further may comprise one or more first holes configured to pass through the plurality of vibration layers and the sub-electrode of the electrode layer in the first group; and one or more second holes configured to pass through the plurality of vibration layers and the sub-electrode of the electrode layer in the second group, the first connection member may be filled in the one or more first holes and may be electrically connected to the electrode layer in the first group, and the second connection member may be filled in the one or more second holes and may be electrically connected to the electrode layer in the second group.

According to one or more examples of the present disclosure, the electrode layer of the second group may further comprise a second connection pattern electrically disconnected from the sub-electrode and electrically connected to the second connection member, the electrode layer of the first group may further comprise a third connection pattern electrically disconnected from the sub-electrode and electrically connected to the first connection member, the one or more first holes may pass through the second connection pattern, and the one or more second holes may pass through the third connection pattern.

According to one or more examples of the present disclosure, the vibration apparatus may further comprise a bonding member disposed between two vibration layers vertically adjacent to each other among the plurality of vibration layers, each of the plurality of electrode layers may comprise an upper electrode layer disposed at a first surface of a corresponding vibration layer of the plurality of vibration layers; and a lower electrode layer disposed at a second surface of the corresponding vibration layer of the plurality of vibration layers, and the bonding member may be disposed between the upper electrode layer and the lower electrode layer vertically adjacent to each other between two vibration layers vertically adjacent to each other among the plurality of vibration layers.

According to one or more examples of the present disclosure, the bonding member may comprise a non-conductive adhesive material.

According to one or more examples of the present disclosure, the plurality of vibration layers may have a same poling direction.

According to one or more examples of the present disclosure, the vibration generating part may further comprise a first connection pattern disposed at an uppermost electrode layer of the plurality of electrode layers and electrically connected to the second connection member.

According to one or more examples of the present disclosure, the first connection member and the second connection member may be disposed at one lateral surface of the vibration generating part.

According to one or more examples of the present disclosure, each of the plurality of electrode layers may comprise a main electrode and a sub-electrode protruding from the main electrode, the first connection member may be electrically connected to the sub-electrode of the electrode layer in the first group, and the second connection member may be electrically connected to the sub-electrode of the electrode layer in the second group.

According to one or more examples of the present disclosure, the electrode layer in the second group may further comprise a second connection pattern electrically disconnected from the sub-electrode and electrically connected to the second connection member, and the electrode layer in the first group may further comprise a third connection pattern electrically disconnected from the sub-electrode and electrically connected to the first connection member.

According to one or more examples of the present disclosure, the first connection member may pass through the plurality of vibration layers and may be electrically connected to the electrode layer in the first group, and the second connection member may pass through the plurality of vibration layers and may be electrically connected to the electrode layer in the second group.

According to one or more examples of the present disclosure, the vibration generating part may further comprise a first connection pattern disposed at an uppermost electrode layer of the plurality of electrode layers and electrically connected to the second connection member.

According to one or more examples of the present disclosure, each of the plurality of electrode layers may comprise a main electrode and a sub-electrode protruding from the main electrode, the vibration generating part further may comprise one or more first holes configured to pass through the plurality of vibration layers and the sub-electrode of the electrode layer in the first group; and one or more second holes configured to pass through the plurality of vibration layers and the sub-electrode of the electrode layer in the second group, the first connection member may be filled in the one or more first holes and may be electrically connected to the electrode layer in the first group, and the second connection member may be filled in the one or more second holes and may be electrically connected to the electrode layer in the second group.

According to one or more examples of the present disclosure, the electrode layer of the second group may further comprise a second connection pattern electrically disconnected from the sub-electrode and electrically connected to the second connection member, the electrode layer of the first group may further comprise a third connection pattern electrically disconnected from the sub-electrode and electrically connected to the first connection member, the one or more first holes may pass through the second connection pattern, and the one or more second holes may pass through the third connection pattern.

According to one or more examples of the present disclosure, each of the plurality of electrode layers may comprise a main electrode; a sub-electrode protruding from the main electrode; and one or more patterning regions in a peripheral region of the sub-electrode.

According to one or more examples of the present disclosure, each of the plurality of electrode layers may further comprise a dummy pattern part disposed at the one or more patterning regions.

According to one or more examples of the present disclosure, the dummy pattern part may comprise first to fourth dummy patterns corresponding to corner portions of the plurality of vibration layers.

According to one or more examples of the present disclosure, the dummy pattern part further may comprise first to fourth dummy patterns corresponding to the corner portions of the plurality of vibration layers; and an electrode connection line configured to be electrically connected to the first to fourth dummy patterns.

According to one or more examples of the present disclosure, the vibration generating part may comprise a third connection member configured to be electrically connected to a dummy pattern part of the electrode layer in the first group among the plurality of electrode layers; and a fourth connection member configured to be electrically connected to a dummy pattern part of the electrode layer in the second group among the plurality of electrode layers.

According to one or more examples of the present disclosure, the third connection member and the fourth connection member may be disposed at one lateral surface of the vibration generating part.

According to one or more examples of the present disclosure, the third connection member may pass through the plurality of vibration layers and may be electrically connected to the dummy pattern part in the first group, and the second connection member may pass through the plurality of vibration layers and may be electrically connected to the dummy pattern part in the second group.

According to one or more examples of the present disclosure, each of the plurality of electrode layers may comprise a main electrode; a sub-electrode protruding from the main electrode; and a pattern electrode connected to an end of the sub-electrode.

According to one or more examples of the present disclosure, the sub-electrode may comprise first and second sub-electrodes protruding in parallel from the main electrode; and third and fourth sub-electrodes protruding in parallel in a direction opposite to the first and second sub-electrodes from the main electrode, and the pattern electrode may comprise a first pattern electrode connected to an end of each of the first and second sub-electrodes; and a second pattern electrode connected to an end of each of the third and fourth sub-electrodes.

According to one or more examples of the present disclosure, the pattern electrode further may comprise a third pattern electrode electrically connected to the first and second sub-electrodes and disposed to intersect with the first and second sub-electrodes, between the first pattern electrode and the main electrode; and a fourth pattern electrode electrically connected to the third and fourth sub-electrodes and disposed to intersect with the third and fourth sub-electrodes, between the second pattern electrode and the main electrode.

According to one or more examples of the present disclosure, each of the plurality of electrode layers may comprise a main electrode; a sub-electrode protruding from the main electrode; and a pattern electrode electrically connected to the sub-electrode and disposed to intersect with the sub-electrode.

According to one or more examples of the present disclosure, the sub-electrode may comprise first and second sub-electrodes protruding in parallel from the main electrode; and third and fourth sub-electrodes protruding in parallel in a direction opposite to the first and second sub-electrodes from the main electrode, and the pattern electrode may comprise a first pattern electrode electrically connected to the first and second sub-electrodes and disposed to intersect with the first and second sub-electrodes; and a second pattern electrode electrically connected to the third and fourth sub-electrodes and disposed to intersect with the third and fourth sub-electrodes.

According to one or more examples of the present disclosure, each of the plurality of electrode layers may comprise a main electrode and a sub-electrode protruding from the main electrode, and the sub-electrode may comprise first to third sub-electrodes protruding in parallel from the main electrode; and fourth to sixth sub-electrodes protruding in parallel in a direction opposite to the first to third sub-electrodes from the main electrode.

According to one or more examples of the present disclosure, each of the plurality of electrode layers may comprise a main electrode and a sub-electrode connected to the main electrode, the main electrode may comprise a plurality of main electrodes parallel to one another, and the sub-electrode may comprise a first sub-electrode electrically connected to one side of each of the plurality of main electrodes; and a second sub-electrode electrically connected to the other side of each of the plurality of main electrodes.

According to one or more examples of the present disclosure, each of the plurality of electrode layers may comprise a main electrode and a sub-electrode connected to the main electrode, the main electrode and the sub-electrode have a "II"-shape in plan.

According to one or more examples of the present disclosure, each of the plurality of electrode layers may comprise a main electrode; a sub-electrode spaced apart from the main electrode; and one or more electrode connection lines electrically connecting the main electrode to the sub-electrode.

According to one or more examples of the present disclosure, the sub-electrode may comprise a first sub-electrode spaced apart from one side of the main electrode and electrically connected to the main electrode through the one or more electrode connection lines; and a second sub-electrode spaced apart from the other side of the main electrode and electrically connected to the main electrode through the one or more electrode connection lines.

According to one or more examples of the present disclosure, each of the plurality of electrode layers may comprise a main electrode including a first main electrode and a second main electrode parallel to each other; a sub-electrode disposed between the first main electrode and the second main electrode; and one or more electrode connection lines electrically connecting the first main electrode to the sub-electrode and electrically connecting the second main electrode to the sub-electrode.

According to one or more examples of the present disclosure, the first main electrode, the second main electrode, and the sub-electrode may extend along a long-side length direction of the vibration generating part.

According to one or more examples of the present disclosure, each of the plurality of electrode layers may comprise a main electrode and a sub-electrode protruding from the main electrode, the sub-electrode may comprise a first sub-electrode and a second sub-electrode, the first sub-electrode may comprise a plurality of first protrusion patterns protruding from one side of the main electrode and a first pattern electrode connected to ends of the plurality of first protrusion patterns in common, and the second sub-electrode may comprise a plurality of second protrusion patterns protruding from the other side of the main electrode and a second pattern electrode connected to ends of the plurality of second protrusion patterns in common.

According to one or more examples of the present disclosure, each of the plurality of electrode layers may comprise one or more first patterning regions surrounded by one side of the main electrode, the plurality of first protrusion patterns, and the first pattern electrode; and one or more second patterning regions surrounded by the other side of the main electrode, the plurality of second protrusion patterns, and the second pattern electrode.

According to one or more examples of the present disclosure, the vibration generating part may further comprise a dummy pattern disposed within the one or more first patterning regions and the one or more second patterning regions so as to be electrically disconnected from the main electrode.

According to one or more examples of the present disclosure, each of the plurality of electrode layers may comprise a main electrode and a sub-electrode protruding from the main electrode, the sub-electrode further may comprise a plurality of first sub-electrodes protruding from one side of the main electrode; and a plurality of second sub-electrodes protruding from the other side of the main electrode, and each of the plurality of electrode layers may further comprise a pattern electrode connected to the plurality of first sub-electrodes in common.

According to one or more examples of the present disclosure, the vibration generating part further may comprise a plurality of first patterning regions surrounded by the main electrode, the plurality of first sub-electrodes, and the pattern electrode; and a plurality of second patterning regions may comprise a region between the plurality of second sub-electrodes.

According to one or more examples of the present disclosure, the vibration generating part may further comprise a dummy pattern part including first to fourth dummy patterns corresponding to corner portions of the plurality of vibration layers.

According to one or more examples of the present disclosure, the dummy pattern part may further comprise an electrode connection line configured to be electrically connected to the first to fourth dummy patterns.

According to one or more examples of the present disclosure, the dummy pattern part may further comprise one or more dummy protrusion lines protruding from the electrode connection line to the plurality of second patterning regions between the plurality of second sub-electrodes.

According to one or more examples of the present disclosure, the vibration generating part further may comprise a third connection member configured to be electrically connected to the dummy pattern part in the electrode layer of the first group among the plurality of electrode layers; and a fourth connection member configured to be electrically connected to the dummy pattern part in the electrode layer of the second group among the plurality of electrode layers.

According to one or more examples of the present disclosure, the vibration apparatus may further comprise a cover member configured to cover at least one or more of a first surface and a second surface, which is opposite to the first surface, of the vibration generating part.

According to one or more examples of the present disclosure, the vibration apparatus may further comprise a signal supply member electrically connected to the vibration generating part, the signal supply member may comprise a first signal line electrically connected to the first connection member; and a second signal line electrically connected to the second connection member.

According to one or more examples of the present disclosure, a portion of the signal supply member may be accommodated between the cover member and the vibration generating part.

According to one or more examples of the present disclosure, the vibration apparatus may further comprise a first cover member and a second cover member, the vibration generating part may be disposed between the first cover member and the second cover member.

According to one or more examples of the present disclosure, the vibration apparatus may further comprise a signal supply member electrically connected to the vibration generating part, the signal supply member may comprise a first signal line electrically connected to the first connection member; and a second signal line electrically connected to the second connection member, and a portion of the signal supply member may be accommodated between the first cover member and the second cover member.

The electronic apparatus according to an example of the present disclosure may comprise a passive vibration member; and one or more vibration generating apparatuses configured to vibrate the passive vibration member, the one or more vibration generating apparatuses may comprise the vibration apparatus, the vibration apparatus may comprise a vibration generating part, the vibration generating part may comprise a plurality of electrode layers; a plurality of vibration layers between the plurality of electrode layers, the plurality of vibration layers including a piezoelectric material; a first connection member configured to be electrically connected to an electrode layer in a first group among the plurality of electrode layers; and a second connection member configured to be electrically connected to an electrode layer in a second group among the plurality of electrode layers, and each of the plurality of electrode layers may be configured to have a shape, which differs from a shape of each of the plurality of vibration layers, and a size which is smaller than a size of each of the plurality of vibration layers.

According to one or more examples of the present disclosure, the electronic apparatus may further comprise an enclosure disposed at a rear surface of the passive vibration member and configured to cover the one or more vibration generating apparatuses.

According to one or more examples of the present disclosure, the passive vibration member may comprise one or more of a vibration plate, a display panel including a pixel configured to display an image, a screen panel on which an image is to be projected from a display apparatus, a light emitting diode lighting panel, an organic light emitting lighting panel, an inorganic light emitting lighting panel, a signage panel, a vehicular interior material, a vehicular exterior material, a vehicular glass window, a vehicular seat interior material, a vehicular ceiling material, a building ceiling material, a building interior material, a building glass window, an aircraft interior material, an aircraft glass window, and a mirror, and the vibration plate may comprise one or more material of a metal, plastic, wood, paper, fiber, cloth, leather, glass, rubber, carbon, and mirror.

A vibration apparatus according to one or more examples of the present disclosure may be applied to or included in a vibration apparatus disposed at an electronic apparatus or a display apparatus. The electronic apparatus or the display apparatus according to one or more examples of the present disclosure may be applied to or included in mobile apparatuses, video phones, smart watches, watch phones, wearable apparatuses, foldable apparatuses, rollable apparatuses, bendable apparatuses, flexible apparatuses, curved apparatuses, sliding apparatuses, variable apparatuses, electronic organizers, electronic books, portable multimedia players (PMPs), personal digital assistants (PDAs), MP3 players, mobile medical devices, desktop personal computers (PCs), laptop PCs, netbook computers, workstations, navigation apparatuses, automotive navigation apparatuses, automotive display apparatuses, automotive apparatuses, theatre apparatuses, theatre display apparatuses, TVs, wall paper display apparatuses, signage apparatuses, game machines, notebook computers, monitors, cameras, camcorders, and home appliances, or the like. Further, the vibration apparatus according to one or more examples of the present disclosure may be applied to or included in an organic light-emitting lighting apparatus or an inorganic light-emitting lighting apparatus. When the vibration apparatus is applied to or included in the lighting apparatuses, the lighting apparatuses may act as lighting and a speaker. In addition, when the vibration apparatus according to one or more examples of the present disclosure is applied to or included in the mobile apparatuses, or the like, the vibration apparatus may be one or more of a speaker, a receiver, and a haptic device, but examples of the present disclosure are not limited thereto.

Further examples are set out in the clauses below:
1. A vibration apparatus, comprising:
   a vibration generating part,
   wherein the vibration generating part comprises:
      a plurality of electrode layers;
      a plurality of vibration layers between the plurality of electrode layers, the plurality of vibration layers including a piezoelectric material;
      a first connection member configured to be electrically connected to an electrode layer
      in a first group among the plurality of electrode layers; and a second connection member configured to be electrically connected to an electrode layer
      in a second group among the plurality of electrode layers, and
      wherein each of the plurality of electrode layers is configured to have a shape, which differs from a shape of each of the plurality of vibration layers, and a size which is smaller than a size of each of the plurality of vibration layers.
2. The vibration apparatus of clause 1, wherein each of the plurality of vibration layers is configured to two-dimensionally have a tetragonal shape, and
   wherein each of the plurality of electrode layers is configured to two-dimensionally have a non-tetragonal shape.
3. The vibration apparatus of clause 1 or 2, wherein the vibration generating part further comprises a first connection pattern disposed at an uppermost electrode layer of the plurality of electrode layers and electrically connected to the second connection member.
4. The vibration apparatus of any one of the preceding clauses, wherein each of the plurality of vibration layers is disposed between two electrode layers vertically adjacent to each other among the plurality of electrode layers.
5. The vibration apparatus of any one of the preceding clauses, wherein the first connection member and the second connection member are disposed at one lateral surface of the vibration generating part.
6. The vibration apparatus of any one of the preceding clauses,
   wherein each of the plurality of electrode layers comprises a main electrode and a sub-electrode protruding from the main electrode,
   wherein the first connection member is electrically connected to the sub-electrode of the electrode layer in the first group, and
   wherein the second connection member is electrically connected to the sub-electrode of the electrode layer in the second group.
7. The vibration apparatus of clause 6,
   wherein the electrode layer in the second group further comprises a second connection pattern electrically disconnected from the sub-electrode and electrically connected to the second connection member, and
   wherein the electrode layer in the first group further comprises a third connection pattern electrically disconnected from the sub-electrode and electrically connected to the first connection member.
8. The vibration apparatus of clause 4,
   wherein the first connection member passes through the plurality of vibration layers and is configured to be electrically connected to the electrode layer in the first group, and
   wherein the second connection member passes through the plurality of vibration layers and is configured to be electrically connected to the electrode layer in the second group.
9. The vibration apparatus of clause 8, wherein the vibration generating part further comprises a first connection pattern disposed at an uppermost electrode layer of the plurality of electrode layers and electrically connected to the second connection member.
10. The vibration apparatus of clause 9,
   wherein each of the plurality of electrode layers comprises a main electrode and a sub-electrode protruding from the main electrode,
   wherein the vibration generating part further comprises:
      one or more first holes configured to pass through the plurality of vibration layers and
      the sub-electrode of the electrode layer in the first group; and
      one or more second holes configured to pass through the plurality of vibration layers and the sub-electrode of the electrode layer in the second group,
      wherein the first connection member is filled in the one or more first holes and is electrically connected to the electrode layer in the first group, and
      wherein the second connection member is filled in the one or more second holes and
      is electrically connected to the electrode layer in the second group.
11. The vibration apparatus of clause 10,
   wherein the electrode layer of the second group further comprises a second connection pattern electrically disconnected from the sub-electrode and electrically connected to the second connection member,
   wherein the electrode layer of the first group further comprises a third connection pattern electrically disconnected from the sub-electrode and electrically connected to the first connection member,
   wherein the one or more first holes pass through the second connection pattern, and wherein the one or more second holes pass through the third connection pattern.
12. The vibration apparatus of any one of the preceding clauses, wherein each of the plurality of electrode layers comprises:
   a main electrode;
   a sub-electrode protruding from the main electrode; and
   one or more patterning regions in a peripheral region of the sub-electrode.
13. The vibration apparatus of clause 12, wherein each of the plurality of electrode layers further comprises a dummy pattern part disposed at the one or more patterning regions.
14. The vibration apparatus of clause 13, wherein the dummy pattern part further comprises:
   first to fourth dummy patterns corresponding to corner portions of the plurality of vibration layers; and
   an electrode connection line configured to be electrically connected to the first to fourth dummy patterns.
15. The vibration apparatus of any one of the preceding clauses, further comprising a cover member configured to cover at least one or more of a first surface and a second surface, which is opposite to the first surface, of the vibration generating part.
16. The vibration apparatus of any one of the preceding clauses, further comprises a signal supply member electrically connected to the vibration generating part, wherein the signal supply member comprises:
   a first signal line electrically connected to the first connection member; and
   a second signal line electrically connected to the second connection member.
17. The vibration apparatus of clause 16, wherein a portion of the signal supply member is accommodated between the cover member and the vibration generating part.
18. An electronic apparatus, comprising:
   a passive vibration member; and
   one or more vibration generating apparatuses configured to vibrate the passive vibration member,
   wherein the one or more vibration generating apparatuses comprise the vibration apparatus of any one of clauses 1 to 17.
19. The electronic apparatus of clause 18, further comprising an enclosure disposed at a rear surface of the passive vibration member and configured to cover the one or more vibration generating apparatuses.
20. The electronic apparatus of clause 18 or 19,
   wherein the passive vibration member comprises one or more of a vibration plate, a display panel including a pixel configured to display an image, a screen panel on which an image is to be projected from a display apparatus, a light emitting diode lighting panel, an organic light emitting lighting panel, an inorganic light emitting lighting panel, a signage panel, a vehicular interior material, a vehicular exterior material, a vehicular glass window, a vehicular seat interior material, a vehicular ceiling material, a building ceiling material, a building interior material, a building glass window, an aircraft interior material, an aircraft glass window, and a mirror, and
   wherein the vibration plate comprises one or more material of a metal, plastic, wood, paper, fiber, cloth, leather, glass, rubber, carbon, and mirror.

It will be apparent to those skilled in the art that various modifications and variations can be made in the present disclosure without departing from the scope of the disclosures. Thus, it is intended that the present disclosure covers the modifications and variations of this disclosure provided that within the scope of the claims and their equivalents.

## Claims

1. A vibration apparatus, comprising:
a vibration generating part,
wherein the vibration generating part comprises:
a plurality of electrode layers;
a plurality of vibration layers between the plurality of electrode layers, the plurality of vibration layers including a piezoelectric material;
a first connection member configured to be electrically connected to an electrode layer in a first group among the plurality of electrode layers; and
a second connection member configured to be electrically connected to an electrode layer in a second group among the plurality of electrode layers, and
wherein each of the plurality of electrode layers is configured to have a shape, which differs from a shape of each of the plurality of vibration layers, and a size which is smaller than a size of each of the plurality of vibration layers.

2. The vibration apparatus of claim 1,
wherein each of the plurality of vibration layers is configured to two-dimensionally have a tetragonal shape, and
wherein each of the plurality of electrode layers is configured to two-dimensionally have a non-tetragonal shape.

3. The vibration apparatus of claim 1 or 2, wherein the vibration generating part further comprises a first connection pattern disposed at an uppermost electrode layer of the plurality of electrode layers and electrically connected to the second connection member.

4. The vibration apparatus of any one of the preceding claims, wherein each of the plurality of vibration layers is disposed between two electrode layers vertically adjacent to each other among the plurality of electrode layers.

5. The vibration apparatus of claim 4, wherein the first connection member and the second connection member are disposed at one lateral surface of the vibration generating part.

6. The vibration apparatus of claim 5,
wherein each of the plurality of electrode layers comprises a main electrode and a sub-electrode protruding from the main electrode,
wherein the first connection member is electrically connected to the sub-electrode of the electrode layer in the first group, and
wherein the second connection member is electrically connected to the sub-electrode of the electrode layer in the second group.

7. The vibration apparatus of claim 6,
wherein the electrode layer in the second group further comprises a second connection pattern electrically disconnected from the sub-electrode and electrically connected to the second connection member, and
wherein the electrode layer in the first group further comprises a third connection pattern electrically disconnected from the sub-electrode and electrically connected to the first connection member.

8. The vibration apparatus of claim 4,
wherein the first connection member passes through the plurality of vibration layers and is configured to be electrically connected to the electrode layer in the first group, and
wherein the second connection member passes through the plurality of vibration layers and is configured to be electrically connected to the electrode layer in the second group.

9. The vibration apparatus of claim 8, wherein the vibration generating part further comprises a first connection pattern disposed at an uppermost electrode layer of the plurality of electrode layers and electrically connected to the second connection member.

10. The vibration apparatus of claim 9,
wherein each of the plurality of electrode layers comprises a main electrode and a sub-electrode protruding from the main electrode,
wherein the vibration generating part further comprises:
one or more first holes configured to pass through the plurality of vibration layers and the sub-electrode of the electrode layer in the first group; and
one or more second holes configured to pass through the plurality of vibration layers and the sub-electrode of the electrode layer in the second group,
wherein the first connection member is filled in the one or more first holes and is electrically connected to the electrode layer in the first group, and
wherein the second connection member is filled in the one or more second holes and is electrically connected to the electrode layer in the second group.

11. The vibration apparatus of claim 10,
wherein the electrode layer of the second group further comprises a second connection pattern electrically disconnected from the sub-electrode and electrically connected to the second connection member,
wherein the electrode layer of the first group further comprises a third connection pattern electrically disconnected from the sub-electrode and electrically connected to the first connection member,
wherein the one or more first holes pass through the second connection pattern, and
wherein the one or more second holes pass through the third connection pattern.

12. The vibration apparatus of any one of the preceding claims, wherein each of the plurality of electrode layers comprises:
a main electrode;
a sub-electrode protruding from the main electrode; and
one or more patterning regions in a peripheral region of the sub-electrode; and optionally
wherein each of the plurality of electrode layers further comprises a dummy pattern part disposed at the one or more patterning regions; and optionally
wherein the dummy pattern part further comprises:
first to fourth dummy patterns corresponding to corner portions of the plurality of vibration layers; and
an electrode connection line configured to be electrically connected to the first to fourth dummy patterns.

13. The vibration apparatus of any one of the preceding claims, further comprising a cover member configured to cover at least one or more of a first surface and a second surface, which is opposite to the first surface, of the vibration generating part; and optionally
further comprises a signal supply member electrically connected to the vibration generating part,
wherein the signal supply member comprises:
a first signal line electrically connected to the first connection member; and
a second signal line electrically connected to the second connection member; and optionally
wherein a portion of the signal supply member is accommodated between the
cover member and the vibration generating part.

14. An electronic apparatus, comprising:
a passive vibration member; and
one or more vibration generating apparatuses configured to vibrate the passive vibration member,
wherein the one or more vibration generating apparatuses comprise the vibration apparatus of any one of claims 1 to 13.

15. The electronic apparatus of claim 18, further comprising an enclosure disposed at a rear surface of the passive vibration member and configured to cover the one or more vibration generating apparatuses, or optionally
wherein the passive vibration member comprises one or more of a vibration plate, a display panel including a pixel configured to display an image, a screen panel on which an image is to be projected from a display apparatus, a light emitting diode lighting panel, an organic light emitting lighting panel, an inorganic light emitting lighting panel, a signage panel, a vehicular interior material, a vehicular exterior material, a vehicular glass window, a vehicular seat interior material, a vehicular ceiling material, a building ceiling material, a building interior material, a building glass window, an aircraft interior material, an aircraft glass window, and a mirror, and
wherein the vibration plate comprises one or more material of a metal, plastic, wood, paper, fiber, cloth, leather, glass, rubber, carbon, and mirror.
